(19)

Europäisches
Patentamt
European
Patent Office
Office européen
des brevets

(11) **EP 4 665 125 A1**

(12) **EUROPEAN PATENT APPLICATION**
published in accordance with Art. 153(4) EPC

(43) Date of publication:
**17.12.2025 Bulletin 2025/51**

(21) Application number: **24881512.8**

(22) Date of filing: **17.10.2024**

(51) International Patent Classification (IPC):
**H10K 59/12** (2023.01)    **H10K 59/121** (2023.01)

(52) Cooperative Patent Classification (CPC):
**H10K 59/121; H10K 59/123; H10K 59/131**

(86) International application number:
**PCT/CN2024/125556**

(87) International publication number:
**WO 2025/087147 (01.05.2025 Gazette 2025/18)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **25.10.2023 PCT/CN2023/126428**

(71) Applicants:
• **BOE TECHNOLOGY GROUP CO., LTD.
Beijing 100015 (CN)**
• **Beijing BOE Technology Development Co., Ltd.
Beijing 100176 (CN)**

(72) Inventors:
• **ZHANG, Yuxin
Beijing 100176 (CN)**
• **FANG, Fei
Beijing 100176 (CN)**
• **WANG, Jingquan
Beijing 100176 (CN)**
• **HAO, Xueguang
Beijing 100176 (CN)**
• **QIAO, Yong
Beijing 100176 (CN)**
• **CHENG, Yudiao
Beijing 100176 (CN)**

(74) Representative: **CMS Cameron McKenna Nabarro
Olswang LLP
Cannon Place
78 Cannon Street
London EC4N 6AF (GB)**

(54) **DISPLAY SUBSTRATE AND DISPLAY APPARATUS**

(57)    A display substrate, comprising: a base (40); multiple first pixel circuits (21) located in a first display area (A1); multiple first light-emitting elements and multiple second light-emitting elements (12); multiple reserved pixel circuits located in a second display area (A2); multiple in-situ pixel circuits (23); and multiple third light-emitting elements. The multiple reserved pixel circuits comprise multiple second pixel circuits (22). In the second display area (A2), a row of reserved pixel circuits is arranged at an interval of every m rows of in-situ pixel circuits, m being an integer greater than 1. At least one of the second pixel circuits (22) is connected to at least one of the second light-emitting elements (12) by means of at least one first conductive connection line (31) extending along a second direction (Y). A maximum length of the first display area (A1) along a first direction (X) is different from a maximum length thereof along the second direction (Y).

FIG. 2

**Description**

The present application claims priority to the International Application No. PCT/CN2023/126428, filed on October 25, 2023 and entitled "Display Substrate and Display apparatus", the disclosure of which should be interpreted as being hereby incorporated by reference.

Technical Field

The present disclosure relates to, but is not limited to, the field of display technologies, in particular to a display substrate and a display apparatus.

Background

An organic Light Emitting Diode (OLED) and a Quantum dot Light Emitting Diode (QLED) are active light emitting display devices, and have advantages of self-illumination, a wide viewing angle, a high contrast ratio, low power consumption, an extremely high reaction speed, lightness and thinness, flexibility, and a low cost, etc.

Summary

The following is a summary of subject matters described herein in detail. This summary is not intended to limit the protection scope of claims.

An embodiment of the present disclosure provides a display substrate and a display apparatus.

In one aspect, the present embodiment provides a display substrate including at least one first display region and a second display region located at at least one side of the first display region. A maximum length of the first display region along a first direction is different from a maximum length of the first display region along a second direction, with the first direction intersecting the second direction. The display substrate includes a base substrate, and a plurality of pixel circuits and a plurality of light emitting elements provided on the base substrate. The plurality of pixel circuits include a plurality of first pixel circuits located in the first display region, and a plurality of reserved pixel circuits and a plurality of in-situ pixel circuits located in the second display region. The plurality of reserved pixel circuits includes a plurality of second pixel circuits. In the second display region, a plurality of reserved pixel circuits arranged along the first direction are one row of reserved pixel circuits, a plurality of in-situ pixel circuits arranged along the first direction are one row of in-situ pixel circuits, and one row of reserved pixel circuits is arranged every m rows of in-situ pixel circuits along the second direction, with m being an integer greater than 1. The plurality of light emitting elements include a plurality of first light emitting elements and a plurality of second light emitting elements located in the first display region, and a plurality of third light emitting elements located in the second display region. At least one first pixel circuit of the plurality of first pixel circuits is connected with at least one first light emitting element of the plurality of first light emitting elements, and an orthographic projection of the at least one first pixel circuit on the base substrate is at least partially overlapped with an orthographic projection of the connected at least one first light emitting element on the base substrate. At least one second pixel circuit of the plurality of second pixel circuits is connected with at least one second light emitting element of the plurality of second light emitting elements through at least one first conductive connection line extending along the second direction, and an orthographic projection of the at least one second pixel circuit on the base substrate is not overlapped with an orthographic projection of the connected at least one second light emitting element on the base substrate. At least one in-situ pixel circuit of the plurality of in-situ pixel circuits is connected with at least one third light emitting element of the plurality of third light emitting elements, and an orthographic projection of the at least one in-situ pixel circuit on the base substrate is at least partially overlapped with an orthographic projection of the connected at least one third light emitting element on the base substrate.

In some exemplary implementations, a maximum length of the first display region along the first direction is greater than a maximum length of the first display region along the second direction. The first display region includes a+1 first sub-regions and a second sub-regions, wherein the a+1 first sub-regions and the a second sub-regions are arranged at intervals along the first direction, with a being an integer greater than 0, and at least one of the first sub-region is provided between the second sub-region and the second display region in the first direction. The first sub-region is provided with the plurality of first pixel circuits and the plurality of first light emitting elements, and the second sub-region is provided with the plurality of second light emitting elements.

In some exemplary implementations, the display substrate further includes a plurality of data lines connected with the plurality of pixel circuits and configured to provide data signals to the plurality of pixel circuits, the plurality of data lines being arranged along the first direction and extending along the second direction. The plurality of data lines includes a plurality of first data lines, a plurality of second data lines, and a plurality of third data lines, the plurality of first data lines being partitioned by the first display region and bypassing the second sub-region along both sides of the second sub-region in the first direction, the plurality of second data lines being connected with the plurality of first pixel circuits in the first sub-region, and the plurality of third data lines being located in the second display region.

In some exemplary implementations, a is 1 or 3.

In some exemplary implementations, a maximum length of the first display region along the second direction is greater than a maximum length of the first display region along the first direction. The first display region includes b first sub-regions and b+1 second sub-regions, and the b first sub-regions and the b+1 second sub-regions are arranged at intervals along the second direction, with b being an integer greater than 0. At least one of the second sub-regions is provided between the first sub-region and the second display region in the second direction. The first sub-region is provided with the plurality of first pixel circuits and the plurality of first light emitting elements, and the second sub-region is provided with the plurality of second light emitting elements.

In some exemplary implementations, in the second display region, a plurality of reserved pixel circuits sequentially arranged along the second direction are one column of reserved pixel circuits, a plurality of in-situ pixel circuits sequentially arranged along the second direction are one column of in-situ pixel circuits, and one column of reserved pixel circuits is arranged every n columns of in-situ pixel circuits along the first direction, with n being an integer greater than 1. The plurality of second light emitting elements provided in the second sub-region located between the second display region and the first sub-region in the second direction are connected with the plurality of second pixel circuits in the second display region through a plurality of first conductive connection lines. The plurality of second light emitting elements provided in a second sub-region between two adjacent first sub-regions in the second direction are connected with the plurality of second pixel circuits in the second display region through a plurality of second conductive connection lines extending along the first direction.

In some exemplary implementations, the first display region includes a plurality of island regions, a transmissive region between adjacent island regions, and an inter-island connection region connecting adjacent island regions, wherein a light transmittance of the transmissive region is greater than a light transmittance of the island region. The island region is provided with the plurality of first pixel circuits and the plurality of first light emitting elements, and the first display region satisfies at least one of the following: the transmissive region is provided with the plurality of second light emitting elements; the inter-island connection region is provided with the plurality of second light emitting elements.

In some exemplary implementations, the first display region includes a plurality of transmissive regions including at least one first transmissive region and a plurality of second transmissive regions, wherein the first transmissive region is provided with the plurality of second light emitting elements, a light transmittance of the second transmissive region is greater than a light transmittance of the first transmissive region, and the second transmissive region and the first transmissive region are arranged at intervals along the first direction or the second direction. The first display region satisfies at least one of the following: a maximum length of the first transmissive region along the first direction is greater than a maximum length of the second transmissive region along the first direction; the maximum length of the first transmissive region along the first direction is equal to the maximum length of the second transmissive region along the first direction; a maximum length of the first transmissive region along the second direction is greater than a maximum length of the second transmissive region along the second direction; the maximum length of the first transmissive region along the second direction is equal to the maximum length of the second transmissive region along the second direction.

In some exemplary implementations, the display substrate further includes a shielding layer located in the first display region, the shielding layer being located at a side of the plurality of first pixel circuits close to the base substrate. An orthographic projection of the shielding layer on the base substrate covers orthographic projections of the plurality of island regions, the plurality of inter-island connection regions, and the plurality of second light emitting elements in the first transmissive region on the base substrate.

In some exemplary implementations, the at least one first conductive connection line is disposed in the same layer as the shielding layer.

In some exemplary implementations, the first transmissive region is located at a central region of the first display region, and the maximum length of the first transmissive region along the first direction is greater than maximum length of the first transmissive region along the second direction.

In some exemplary implementations, the first display region includes a plurality of inter-island connection regions including a plurality of first inter-island connection regions, a plurality of second inter-island connection regions, and a plurality of third inter-island connection regions. The plurality of first inter-island connection regions and the plurality of third inter-island connection regions extend along the first direction, and the plurality of second inter-island connection regions extend along the second direction. The first inter-island connection region is adjacent to the second transmissive region along the second direction, and the third inter-island connection region is adjacent to the first transmissive region along the second direction. A maximum length of the third inter-island connection region along the first direction is greater than a maximum length of the first inter-island connection region along the first direction.

In some exemplary implementations, a maximum length of the third inter-island connection region along the second direction is greater than or equal to a maximum length of the first inter-island connection region along the second direction.

In some exemplary implementations, a minimum distance between the second light emitting element located in the transmissive region and the base substrate is less than or equal to a minimum distance between the first light emitting element located in the island region and the base substrate.

In some exemplary implementations, the inter-island connection region is provided with a plurality of traces, which are straight line segments extending along the first direction or the second direction, or are arc line segments extending along the first direction or the second direction.

In some exemplary implementations, the first display region includes a display middle region and a display edge region surrounding the display middle region, and the display middle region includes a plurality of island regions, a transmissive region between adjacent island regions, and an inter-island connection region connecting adjacent island regions. The plurality of second light emitting elements are located in the display edge region.

In some exemplary implementations, the display substrate includes a plurality of first display regions, wherein at least one of the plurality of first display regions is provided with the plurality of the first pixel circuits, the plurality of the first light emitting elements, and the plurality of the second light emitting elements, and the plurality of first display regions are arranged along the first direction or the second direction in a staggered manner.

In some exemplary implementations, the display substrate further includes a peripheral region located at at least one side of the second display region, and the peripheral region includes a first peripheral region located at one side of the second display region in the second direction and a second peripheral region located at the remaining sides of the second display region. The display substrate further includes a gate driving circuit located in the second peripheral region, wherein the gate driving circuit includes a plurality of first driving units configured to provide gate signals to a plurality of rows of in-situ pixel circuits and a plurality of rows of reserved pixel circuits.

In some exemplary implementations, the display substrate further includes a peripheral region located at at least one side of the second display region, and the peripheral region includes a first peripheral region located at one side of the second display region in the second direction and a second peripheral region located at the remaining sides of the second display region. The display substrate further includes a gate driving circuit located in the second peripheral region, wherein the gate driving circuit includes a plurality of first driving units configured to provide gate signals to a plurality of rows of in-situ pixel circuits and a plurality of second driving units configured to provide gate signals to a plurality of rows of reserved pixel circuits.

In some exemplary implementations, the first display region is in a shape of a track hole.

In some exemplary implementations, the plurality of second light emitting elements in the first display regions are connected with the plurality of second pixel circuits in the second display region through a plurality of first conductive connection lines, the plurality of first conductive connection lines being located in the same conductive layer.

In another aspect, the present embodiment provides a display apparatus, including the display substrate described above, and a sensor located on a non-display side of the display substrate, wherein an orthographic projection of the sensor on the base substrate of the display substrate is at least partially overlapped with an orthographic projection of the first display region of the display substrate on the base substrate.

In another aspect, the present embodiment provides a display substrate including a plurality of first display regions and a second display region located at at least one side of the plurality of first display regions. The plurality of first display regions are arranged along a first direction or a second direction in a staggered manner, with the first direction intersecting the second direction. The display substrate includes a base substrate, and a plurality of pixel circuits and a plurality of light emitting elements provided on the base substrate. The plurality of pixel circuits include a plurality of first pixel circuits located in at least one first display region of the plurality first display regions, and a plurality of reserved pixel circuits and a plurality of in-situ pixel circuits located in the second display region, the plurality of reserved pixel circuits including a plurality of second pixel circuits. In the second display region, a plurality of reserved pixel circuits arranged along the first direction are one row of reserved pixel circuits, a plurality of in-situ pixel circuits arranged along the first direction are one row of in-situ pixel circuits, and one row of reserved pixel circuits is arranged every m rows of in-situ pixel circuits along the second direction, with m being an integer greater than 1. The plurality of light emitting elements include a plurality of first light emitting elements and a plurality of second light emitting elements located in the at least one first display region, and a plurality of third light emitting elements located in the second display region. The at least one first display region includes a first region and a second region arranged along the first direction, the first region being adjacent to the second display region in the first direction, the second region being adjacent to another first display region in the first direction, the plurality of second light emitting elements being located in the first region, and the plurality of first pixel circuits and the plurality of first light emitting elements being located in the second region. At least one first pixel circuit of the plurality of first pixel circuits is connected with at least one first light emitting element of the plurality of first light emitting elements, and an orthographic projection of the at least one first pixel circuit on the base substrate is at least partially overlapped with an orthographic projection of the connected at least one first light emitting element on the base substrate. At least one second pixel circuit of the plurality of second pixel circuits is connected with at least one second light emitting element of the plurality of second light emitting elements through at least one first conductive connection line extending along the second direction, and an orthographic projection of the at least one second pixel circuit on the base substrate is not overlapped with an orthographic projection of the connected at least one second light emitting element on the base substrate. At least one in-situ pixel circuit of the plurality of in-situ pixel circuits is connected with at least one third light emitting element of the plurality of third light emitting elements, and an orthographic projection of the in-situ pixel circuit on the base substrate is at least partially overlapped with an orthographic projection of the connected at least one third light emitting element on the base substrate.

In some exemplary implementations, the display substrate includes three first display regions, with two first display regions being arranged aligned along the first direction, and a third first display region being located at the same side of the two first display regions in the second direction, and each first display region being provided with the plurality of first light emitting elements, the plurality of second light emitting elements, and the plurality of first pixel circuits. In the two first display regions located in the same row, the plurality of second light emitting elements are located in a first region of the first display region in the first direction, and the plurality of first pixel circuits and the plurality of first light emitting elements are located in a second region of the first display region in the first direction. And in the third first display region, the plurality of second light emitting elements are located in the middle of the plurality of first light emitting elements in the first direction.

In some exemplary implementations, the display substrate includes four first display regions, which are arranged in two rows, and the two rows of first display regions are arranged along the first direction in a staggered manner. Two first display regions in at least one row are provided with the plurality of first light emitting elements, the plurality of second light emitting elements, and the plurality of first pixel circuits, or one first display region in a row is provided with the plurality of first light emitting elements, the plurality of second light emitting elements, and the plurality of first pixel circuits.

Other aspects of the present disclosure may be comprehended after the drawings and the detailed descriptions are read and understood.

Brief Description of Drawings

Accompanying drawings are intended to provide an understanding of technical solutions of the present application and form a part of the specification, and are used to explain the technical solutions of the present application together with embodiments of the present application, and do not constitute a limitation on the technical solutions of the present application.

FIG. 1 is a schematic diagram of a display substrate according to at least one embodiment of the present disclosure.

FIG. 2 is a partial schematic diagram of a display region of a display substrate according to at least one embodiment of the present disclosure.

FIG. 3 is a schematic diagram of an arrangement of a plurality of second light emitting elements in a second sub-region of a first display region according to at least one embodiment of the present disclosure.

FIG. 4 is another partial schematic diagram of a display region of a display substrate according to at least one embodiment of the present disclosure.

FIG. 5 is another schematic diagram of a display substrate according to at least one embodiment of the present disclosure.

FIG. 6 is another partial schematic diagram of a display region of a display substrate according to at least one embodiment of the present disclosure.

FIG. 7 is another schematic diagram of a display region of a display substrate according to at least one embodiment of the present disclosure.

FIG. 8 is another partial schematic diagram of a display region of a display substrate according to at least one embodiment of the present disclosure.

FIG. 9 is another partial schematic diagram of a display region of a display substrate according to at least one embodiment of the present disclosure.

FIG. 10 is another partial schematic diagram of a first display region of a display substrate according to at least one embodiment of the present disclosure.

FIG. 11 is a partial schematic diagram of a shielding layer of the first display region in FIG. 10.

FIG. 12 illustrates schematically a partial cross-sectional view of a display substrate according to at least one embodiment of the present disclosure.

FIG. 13 illustrates schematically another partial cross-sectional view of a display substrate according to at least one embodiment of the present disclosure.

FIG. 14 illustrates schematically another partial cross-sectional view of a display substrate according to at least one embodiment of the present disclosure.

FIG. 15 is an equivalent circuit diagram of a pixel circuit according to at least one embodiment of the present disclosure.

FIG. 16 is a partial schematic diagram of a semiconductor layer of a display region according to at least one embodiment of the present disclosure.

FIG. 17A is a partial schematic diagram of a display region after a first conductive layer is formed, according to at least one embodiment of the present disclosure.

FIG. 17B is a schematic diagram of the first conductive layer in FIG. 17A.

FIG. 18A is a partial schematic diagram of a display region after a second conductive layer is formed, according to at least one embodiment of the present disclosure.

FIG. 18B is a schematic diagram of the second conductive layer in FIG. 18A.

FIG. 19A is a partial schematic diagram of a display region after a third conductive layer is formed, according to at least one embodiment of the present disclosure.

FIG. 19B is a schematic diagram of the third conductive layer in FIG. 19A.

FIG. 20A is a partial schematic diagram of a display region after a fourth conductive layer is formed, according to at least one embodiment of the present disclosure.

FIG. 20B is a schematic diagram of the fourth conductive layer in FIG. 20A.

FIG. 21A is a partial schematic diagram of a display region after an anode layer is formed, according to at least one embodiment of the present disclosure.

FIG. 21B is a schematic diagram of the anode layer in FIG. 21A.

FIG. 22 is another partial schematic diagram of a first display region according to at least one embodiment of the present disclosure.

FIG. 23 is another partial schematic diagram of a first display region according to at least one embodiment of the present disclosure.

FIG. 24 is another partial schematic diagram of a display region according to at least one embodiment of the present disclosure.

FIG. 25 is another partial schematic diagram of a display region according to at least one embodiment of the present disclosure.

FIG. 26 is another partial schematic diagram of a display region according to at least one embodiment of the present disclosure.

FIG. 27 is another partial schematic diagram of a display region according to at least one embodiment of the present disclosure.

FIG. 28 is another partial schematic diagram of a display region according to at least one embodiment of the present disclosure.

FIG. 29 is another schematic diagram of a display substrate according to at least one embodiment of the present disclosure.

FIG. 30 is another partial schematic diagram of a display region according to at least one embodiment of the present disclosure.

FIG. 31 is another schematic diagram of a display substrate according to at least one embodiment of the present disclosure.

FIG. 32 is another partial schematic diagram of a display region according to at least one embodiment of the present disclosure.

FIG. 33 is a schematic diagram of another arrangement of a plurality of second light emitting elements in a second sub-region of a first display region according to at least one embodiment of the present disclosure.

FIG. 34 is another partial schematic diagram of a display region according to at least one embodiment of the present disclosure.

FIG. 35 is another partial schematic diagram of a display region according to at least one embodiment of the present disclosure.

FIG. 36 is another schematic diagram of a display substrate according to at least one embodiment of the present disclosure.

FIG. 37 is another schematic diagram of a display substrate according to at least one embodiment of the present disclosure.

FIG. 38 is another schematic diagram of a display substrate according to at least one embodiment of the present disclosure.

FIG. 39 is another schematic diagram of a display substrate according to at least one embodiment of the present disclosure.

FIG. 40 is another schematic diagram of a display substrate according to at least one embodiment of the present disclosure.

FIG. 41 is a schematic diagram of a display apparatus according to at least one embodiment of the present disclosure.

Detailed Description

The embodiments of the present disclosure will be described below with reference to the drawings in detail. Implementations may be implemented in multiple different forms. Those of ordinary skills in the art may easily understand such a fact that modes and contents may be transformed into other forms without departing from the purpose and scope of the present disclosure. Therefore, the present disclosure should not be explained as being limited to the contents recorded in the following implementations only. The embodiments and features in the embodiments of the present disclosure may be randomly combined with each other if there is no conflict.

In the drawings, a size of one or more constituent elements, a thickness of a layer, or a region is sometimes exaggerated for clarity. Therefore, one mode of the present disclosure is not necessarily limited to the size, and a shape and a size of one or more components in the drawings do not reflect an actual scale. In addition, the accompanying drawings schematically illustrate ideal examples, and an implementation of the present disclosure is not limited to shapes, numerical values, or the like shown in the drawings.

Ordinal numerals "first", "second", "third", etc., in the specification are set not to form limits in numbers but only to avoid confusion between constituent elements. In the present disclosure, "plurality" represents two or more than two.

In the specification, for convenience, expressions "central", "above", "below", "front", "back", "vertical", "horizontal", "top", "bottom", "inside", "outside", etc., for indicating directional or positional relationships are used to illustrate positional relationships between the constituent elements with reference to the accompanying drawings, not to indicate or imply that involved devices or elements are required to have specific orientations or are structured and operated in the specific orientations but only to easily describe the present specification and simplify the description, and thus should not be understood as limitations on the present disclosure. The positional relationships between the constituent elements are changed as appropriate according to directions of the constituent elements described. Therefore, appropriate replacements based on situations are allowed, which is not limited to the expressions in the specification.

In the specification, unless otherwise specified and defined explicitly, terms "mount", "mutually connect", "connect", and "couple" should be understood in a broad sense. For example, it may be a fixed connection, a detachable connection, or an integral connection; it may be a mechanical connection or a connection; it may be a direct connection, an indirect connection through a middleware, or an internal communication between two elements. Those of ordinary skills in the art may understand meanings of the aforementioned terms in the present disclosure according to situations.

In the present specification, a "connection" includes an "electrical connection". An "electrical connection" includes a case where constituent elements are connected together through an element with a certain electrical effect. The "element with a certain electrical effect" is not particularly limited as long as electrical signals between the connected constituent elements can be transmitted. Examples of the "element with a certain electrical effect" not only include an electrode and a wiring, but also include a switching element such as a transistor, a resistor, an inductor, a capacitor, and other elements with a plurality of functions, etc.

In the specification, a transistor refers to an element which at least includes three terminals, i.e., a gate, a drain, and a source. The transistor has a channel region between the drain (drain electrode terminal, drain region, or drain electrode) and the source (source electrode terminal, source region, or source electrode), and a current can flow through the drain, the channel region, and the source. In the specification, the channel region refers to a region through which a current mainly flows.

In the specification, a first electrode may be a drain and a second electrode may be a source, or, a first electrode may be a source and a second electrode may be a drain. In a case that transistors with opposite polarities are used, or in a case that a direction of a current is changed during operation of a circuit, or the like, functions of the "source" and the "drain" are sometimes interchangeable. Therefore, the "source" and the "drain" are interchangeable in the specification. In addition, the gate may also be referred to as a control electrode.

In the specification, "parallel" refers to a state in which an angle formed by two straight lines is above -10 ° and below 10 °, and thus may include a state in which the angle is above -5 ° and below 5°. In addition, "perpendicular" refers to a state in which an angle formed by two straight lines is above 80 ° and below 100 °, and thus may include a state in which the angle is above 85 ° and below 95 °.

In the specification, a circle, oval, triangle, rectangle, trapezoid, pentagon, or hexagon, etc. is not strictly speaking, but may be an approximate circle, oval, triangle, rectangle, trapezoid, pentagon, or hexagon, etc. Some small deformations due to tolerances may exist, for example, chamfers, arc edges, and deformations may exist.

A "light transmittance" in the present disclosure refers to an ability of light to pass through a medium, and is a percentage of luminous flux passing through a transparent or translucent body to its incident luminous flux.

In the present disclosure, "about" and "substantially" refer to that a boundary is not defined strictly and a case within a range of process and measurement errors is allowed. In the present disclosure, "to be the same" may include a case where the numerical values differ by within 10%.

In the present disclosure, "A extends along a B direction" means that A may include a main body portion and a secondary portion connected to the main body portion. The main body portion is a line, a line segment, or a strip-shaped body, the main body portion extends along the B direction, and a length of the main body portion extending along the B direction is greater than a length of the secondary portion extending along another direction. "A extends along the B direction" in the present disclosure always means "the main body portion of A extends along the B direction".

"A and B are disposed in a same layer" and "A and B are of a same layer structure" in the present disclosure means that A and B are formed simultaneously through a same patterning process, or distances between surfaces of A and B close to a base substrate and the base substrate are substantially the same, or the surfaces of A and B close to the base substrate are in direct contact with a same film layer. A "thickness" of a film layer is a dimension of the film layer in a direction perpendicular to the display substrate.

In the present disclosure, "an orthographic projection of B being within a range of an orthographic projection of A" or "an orthographic projection of A containing an orthographic projection of B" means that a boundary of the orthographic projection of B falls within a range of a boundary of the orthographic projection of A, or the boundary of the orthographic projection of A is overlapped with the boundary of the orthographic projection of B. The "shape of A" as used in the present disclosure refers to the shape of the orthographic projection of A onto the base substrate.

With continuous development of display technologies, a camera is usually installed on a display device to meet needs of shooting or face recognition. In order to maximize a screen-to-body ratio, technologies such as fringe screen, water drop screen and in-screen hole have successively came into being. These technologies reduce the area occupied by the camera by digging a hole locally in a display region and placing the camera under a hole-digging region, thus increasing the screen-to-body ratio. However, the above technologies need to dig out part of the display region, which will cause some regions in a display picture to be unable to be displayed, and make it impossible to further improve the screen-to-body ratio. In order to avoid punching holes in the display region and under a premise of ensuring practicability of the display substrate, a true full-screen will be achieved by adopting a pixel circuit built-out mode or a pixel circuit built-in mode in the full display with camera (FDC) region.

The pixel circuit built-out mode means that the pixel circuits connected with the light emitting elements in the FDC region is provided in the normal display region, and the light transmittance of the FDC region is improved by arranging the light emitting elements and the pixel circuits separately. The light emitting element and the pixel circuit may be electrically connected through a conductive connection line. Because no pixel circuit is provided in the FDC region, there is no light-shielding layer other than the anodes of the light emitting elements in this region, and a higher light transmittance can be realized. However, in this mode, the pixel circuits and the light emitting elements need to be electrically connected through conductive connection lines, the size (e.g., aperture) of the FDC region of the display substrate using the pixel circuit built-out mode is limited due to the limitation of the space for the arrangement of the conductive connection lines. For example, the pixel circuit built-out mode is not suitable for a FDC region in the shape of a track hole, nor is it suitable for a structure of multiple FDC regions. Moreover, increasing the aperture of the FDC region usually requires an increased mask process of the conductive connection lines, resulting in increased cost.

The pixel circuit built-in mode refers to the provision of light emitting elements and the pixel circuits connected with the light emitting elements in the FDC region. Compared with the pixel circuit built-out mode, the built-in mode eliminates the need for long conductive connection lines for the electric connection between the pixel circuits and the light emitting elements in the FDC region, which can avoid the display defect of the FDC region caused by the conductive connection lines. Moreover, the built-in method does not limit the size of the FDC region and can support the FDC region with large aperture and the structure of multiple FDC regions. However, in a display substrate adopting the pixel circuit built-in mode, since the anode of the light emitting element in the FDC region cannot completely block the pixel circuit, the light transmittance of the FDC region will be affected.

An embodiment of the present disclosure provides a display substrate including a base substrate, a plurality of pixel circuits and a plurality of light emitting elements provided on the base substrate. The display substrate includes at least one first display region and a second display region located at at least one side of the first display region, a maximum length of the first display region along a first direction is different from a maximum length of the first display region along a second direction, with first direction intersecting the second direction, for example, the first direction may be perpendicular to the second direction. The plurality of pixel circuits includes a plurality of first pixel circuits located in the first display region, and a plurality of reserved pixel circuits and a plurality of in-situ pixel circuits located in the second display region. In the second display region, a plurality of reserved pixel circuits arranged sequentially along the first direction are one row of reserved pixel circuits, a plurality of in-situ pixel circuits arranged along the first direction are one row of in-situ pixel circuits, and one row of reserved pixel circuits is arranged every m rows of in-situ pixel circuits along the second direction, wherein m may be an integer greater than 1. The plurality of light emitting elements may include a plurality of first light emitting elements and a plurality of second light emitting elements located in the first display region, and a plurality of third light emitting elements located in the second display region. At least one first pixel circuit of the plurality of first pixel circuits is connected with at least one first light emitting element of the plurality of first light emitting elements, and an orthographic projection of the at least one first pixel circuit on the base substrate may be at least partially overlapped with an orthographic projection of the connected at least one first light emitting element on the base substrate. At least one second pixel circuit of the plurality of second pixel circuits is connected with at least one second light emitting element of the plurality of second light emitting elements through at least one first conductive connection line extending along the second direction, and an orthographic projection of the at least one second pixel circuit on the base substrate may be not overlapped with an orthographic projection of the connected at least one second light emitting element on the base substrate. At least one in-situ pixel circuit of the plurality of in-situ pixel circuits is connected with at least one third light emitting element of the plurality of third light emitting elements, and an orthographic projection of the at least one in-situ pixel circuit on the base substrate may be at least partially overlapped with an orthographic projection of the connected at least one third light emitting element on the base substrate.

In the display substrate provided in the present embodiment, the first display region adopts a combination of a pixel circuit built-out mode and a pixel circuit built-in mode, so that a light transmittance of the first display region can be guaranteed, and size of the first display region can be increased. For example, the present example can satisfy a full display with camera (FDC) region in a shape of a track hole, and can also be suitable for the design requirements of a plurality of FDC regions.

In some exemplary implementations, a maximum length of the first display region along the first direction may be greater than a maximum length of the first display region along the second direction. The first display region may include a+1 first sub-regions and a second sub-regions, and the a+1 first sub-regions and the a second sub-regions are arranged at intervals along the first direction, with a being an integer greater than 0. For example, a may be 1 or may be 3. In the first direction, at least one first sub-region is provided between the second sub-region and the second display region. In other words, a first sub-region is adjacent to the second display region in the first direction. The first sub-region is provided with a plurality of first pixel circuits and a plurality of first light emitting elements, and the second sub-region is provided with a plurality of second light emitting elements. In other words, the first sub-region may be a pixel circuit built-in region, and the second sub-region may be a pixel circuit built-out region. The arrangement of the first display region of the present example may be beneficial to shorten the length of the first conductive connection line and improve the display uniformity of the display substrate.

In some exemplary implementations, the maximum length of the first display region along the second direction may be greater than the maximum length of the first display region along the first direction. The first display region may include b first sub-regions and b+1 second sub-regions, and the b first sub-regions and b+1 second sub-regions are arranged at intervals along the second direction, with b being an integer greater than 0. For example, b may be 1 or may be 2. In the second direction, at least one second sub-region may be provided between the first sub-region and the second display region. In other words, a second sub-region is adjacent to the second display region in the second direction. The first sub-region is provided with a plurality of first pixel circuits and a plurality of first light emitting elements, and the second sub-region is provided with a plurality of second light emitting elements. The arrangement of the first display region of the present example may be beneficial to shorten the length of the first conductive connection line and improve the display uniformity.

In some exemplary implementations, the first display region may include a plurality of island regions, a transmissive region between adjacent island regions, and an inter-island connection region connecting adjacent island regions. A light transmittance of the transmissive region is greater than a light transmittance of the island region. The island region is provided with a plurality of first pixel circuits and a plurality of first light emitting elements. The first display region may satisfy at least one of the following: the transmissive region is provided with a plurality of second light emitting elements; the inter-island connection region is provided with a plurality of second light emitting elements. In this example, the island region is used as a pixel circuit built-in region, and the transmissive region or the inter-island connection region, or the transmissive region and the inter-island connection region may be used as a pixel circuit built-out region.

In some exemplary implementations, the first display region includes a plurality of transmissive regions, the plurality of transmissive regions including at least one first transmissive region provided with a plurality of second light emitting elements and a plurality of second transmissive regions, with a light transmittance of the second transmissive region being greater than that of the first transmissive region. The second transmissive region and the first transmissive region may be arranged at intervals along the first direction or the second direction. In this example, some of the transmissive regions (that is, the first transmissive region) may be provided with the second light emitting element, and some other of the transmissive regions (that is, the second transmissive region) may not be provided with pixel circuit or light emitting element, so as to improve the light transmittance of the first display region.

Solutions of the embodiments will be described below through some examples.

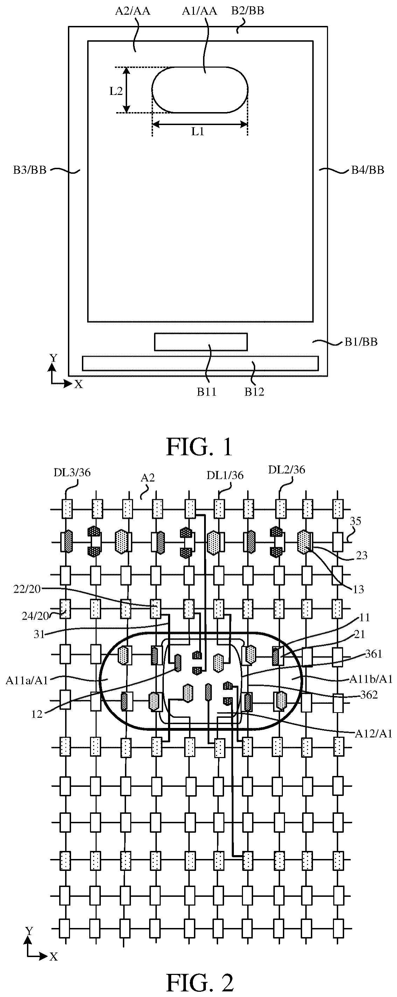

FIG. 1 is a schematic diagram of a display substrate according to at least one embodiment of the present disclosure. In some examples, as shown in FIG. 1, the display substrate may include a display region AA and a peripheral region BB located at a periphery of the display region AA. The peripheral region BB may include a first peripheral region B1 located at one side of the display region AA and a second peripheral region located at remaining sides of the display region AA. For example, the first peripheral region B1 may be a lower bezel region of the display substrate, and the second peripheral region may include an upper bezel region B2, a left bezel region B3, and a right bezel region B4 of the display substrate. The first peripheral region B1 may be connected with the left bezel region B3 and the right bezel region B4, and the upper bezel region B2 may be connected with the left bezel region B3 and the right bezel region B4. The left bezel region B3 and the right bezel region B4 may be located at both sides of the display region AA along a first direction X, and the upper bezel region B2 and the first peripheral region B1 may be located at both sides of the display region AA along a second direction Y. The first direction X intersects the second direction Y. For example, the first direction X may be perpendicular to the second direction Y.

In some examples, as shown in FIG. 1, the first peripheral region B1 may include a first signal access region B11 and a second signal access region B12. The first signal access region B11 may be located at a side of the second signal access region B12 close to the display region AA. The first signal access region B11 may be provided with a plurality of first contact pads, and the second signal access region B12 may be provided with a plurality of second contact pads. Some of the first contact pads in the first signal access region B11 may be connected with some of the second contact pads in the second signal access region B12 through a plurality of contact pad connection lines. The plurality of first contact pads in the first signal access region B11 may be connected with a drive integrated circuit (IC), which may be configured to provide a plurality of kinds of signals, such as data signals. The plurality of second contact pads in the second signal access region B12 may be connected with an external circuit board, such as a flexible circuit board.

In some examples, as shown in FIG. 1, the display region AA may include a first display region A1 and a second display region A2, and the second display region A2 may at least partially surround the first display region A1. For example, a shape of the display region AA may be a rectangle, the first display region A1 may be located in a middle of the top of the display region AA, and the second display region A2 may surround the first display region A1. The peripheral region BB may surround the second display region A2. In some other examples, the first display region A1 may be located at other positions such as an upper left corner, a lower left corner, an upper right corner or a lower right corner of the display region.

In some examples, the first display region A1 may be referred to as a light transmitting display region, which may serve as a Full Display with Camera (FDC) region, or a full display face identification (Face ID) region. The second display region A2 may be referred to as a normal display region. A light transmittance of the first display region A1 may be greater than a light transmittance of the second display region A2. For example, an orthographic projection of a sensor (including a camera and other hardware) on the display substrate may be located within the first display region A1 of the display substrate.

In some examples, the first display region A1 may be in a shape of a track hole. For example, the first display region A1 may include one rectangular region and two semi-circular regions, and the two semi-circular regions may be connected at opposite ends of the rectangular region along the first direction X. A maximum length L1 of the first display region A1 along the first direction X may be greater than a maximum length L2 of the first display region along the second direction Y. In other words, the first display region A1 may be in a shape of a track hole extending along the first direction X.

In some examples, the display region AA may be provided with a plurality of pixel units, and one pixel unit may include three or four sub-pixels. For example, three sub-pixels included in one pixel unit may be a red sub-pixel, a green sub-pixel, and a blue sub-pixel, respectively. Alternatively, four sub-pixels included in one pixel unit may be two green sub-pixels, one red sub-pixel, and one blue sub-pixel.

In some examples, at least one sub-pixel may include a pixel circuit and a light emitting element. The pixel circuit may be configured to drive a light emitting element connected thereto. For example, the pixel circuit may be configured to provide a drive current for driving the light emitting element to emit light. The pixel circuit may include a plurality of transistors and at least one capacitor. For example, the pixel circuit may have a 3T1C, 4T1C, 5T1C, 5T2C, 6T1C, 7T1C, or 8T1C structure. In the aforementioned circuit structures, T refers to a thin film transistor, C refers to a capacitor, a digit before T represents a quantity of thin film transistors in the circuit, and a digit before C represents a quantity of capacitors in the circuit.

In some examples, the light emitting element may be any one of a Light Emitting Diode (LED), an Organic Light Emitting Diode (OLED), a Quantum dot Light Emitting Diode (QLED), a micro LED (including: mini-LED or micro-LED), and the like. For example, the light emitting element may be an OLED, and the light emitting element may emit red light, green light, blue light, or white light, or the like under drive of a pixel circuit corresponding to the light emitting element. A color of light emitted by the light emitting element may be determined as required. In some examples, the light emitting element may include an anode, a cathode, and an organic emitting layer located between the anode and the cathode. The anode of the light emitting element may be electrically connected with a corresponding pixel circuit. However, the present embodiment is not limited thereto.

FIG. 2 is a partial schematic diagram of a display region of a display substrate according to at least one embodiment of the present disclosure. FIG. 2 illustrates some of first pixel circuits 21, some of first light emitting elements 11, some of second light emitting elements 12, some of second pixel circuits 22, and some of third light emitting elements 13 in a first display region A1 as examples. In each of the following figures, some of the pixel circuits and some of the light emitting elements in the display region are illustrated as examples.

In some examples, as shown in FIG. 2, the first display region A1 may be in a shape of a track hole extending along a first direction X. The number a of second sub-regions in this example may be 1. The first display region A1 may include two first sub-regions A11a and A11b, and one second sub-region A12. The second sub-region A12 may be located in a middle of the two first sub-regions A11a and A11b in the first direction X, the first sub-region A11a may be located between a second display region A2 and the second sub-region A12 in the first direction X, and the first sub-region A11b may be located between the second sub-region A12 and the second display region A2 in the first direction X. In other words, the first sub-region A11a, the second sub-region A12, and the first sub-region A11b may be arranged in this order along the first direction X. For example, the first sub-regions A11a and A11b may be semi-circular regions, and the second sub-region A12 may be a rectangular region. The present embodiment is not limited thereto.

In some examples, the first sub-regions A11a and A11b may be provided with a plurality of first pixel circuits 21 and a plurality of first light emitting elements 11. At least one first pixel circuit 21 is connected with at least one first light emitting element 11, and is configured to drive the connected first light emitting element 11 to emit light. An orthographic projection of the at least one first pixel circuit 21 on the base substrate may be at least partially overlapped with an orthographic projection of the connected at least one first light emitting element 11 on the base substrate. The first pixel circuits 21 and the first light emitting elements 11 in the first sub-regions A11a and A11b may be in a one-drive-one relationship, or may be in a one-drive-multiple relationship. In this example, the one-drive-one relationship between a pixel circuit and a light emitting element means that one pixel circuit is connected with one light emitting element and is configured to drive the one light emitting element to emit light, and the one-drive-multiple relationship means that one pixel circuit is connected with a plurality of light emitting elements, and is configured to drive the plurality of light emitting elements to emit light. The first sub-regions A11a and A11b of the present example may pixel circuits built-in regions.

In some examples, the second sub-region A12 may be provided with a plurality of second light emitting elements 12. A plurality of second pixel circuits 22 connected with the plurality of second light emitting elements 12 are located in the second display region A2. At least one second pixel circuit 22 may be connected with at least one second light emitting element 12 through at least one first conductive connection line 31, and may be configured to drive the connected second light emitting element 12 to emit light. An orthographic projection of the at least one second pixel circuit 22 on the base substrate may not be overlapped with an orthographic projection of the connected at least one second light emitting element 12 on the base substrate. The second pixel circuits 22 and the second light emitting elements 12 may be in a one-drive-one relationship or may be in a one-drive-multiple relationship. The second sub-region A12 of the present example may be a pixel circuit built-out region.

In some examples, the first conductive connection line 31 may extend along a second direction Y. The material of the first conductive connection line 31 may include a transparent conductive material, such as indium tin oxide (ITO). Using a transparent conductive material to prepare the first conductive connection line 31 may be beneficial to ensure a light transmittance of the first display region A1. For example, a plurality of first conductive connection lines 31 may be located on the same conductive film layer, and may be prepared by a single patterning process. In some other examples, the plurality of first conductive connection lines 31 may be arranged on a plurality of conductive film layers, and the wiring space may be reduced.

In some examples, the second display region A2 may be provided with a plurality of reserved pixel circuits 20, a plurality of in-situ pixel circuits 23, and a plurality of third light emitting elements 13. At least one in-situ pixel circuit 23 is connected with at least one third light emitting element 13, and is configured to drive the connected third light emitting element 13 to emit light. An orthographic projection of the at least one in-situ pixel circuit 23 on the base substrate may be at least partially overlapped with an orthographic projection of the connected at least one third light emitting element 13 on the base substrate. The in-situ pixel circuit 23 and the third light emitting element 13 may be in a one-drive-one relationship, or may be in a one-drive-multiple relationship.

In some examples, the plurality of reserved pixel circuits 20 may include a plurality of second pixel circuits 22 and a plurality of invalid pixel circuits 24. In the second display region A2, the plurality of reserved pixel circuits 20 and the plurality of in-situ pixel circuits 23 may be arranged at intervals along the second direction Y. For example, a plurality of reserved pixel circuits 20 arranged along the first direction X are referred to as one row of reserved pixel circuits, and a plurality of in-situ pixel circuits 23 arranged along the first direction X are referred to as one row of in-situ pixel circuits. A plurality of reserved pixel circuits 20 arranged along the second direction Y are referred to as one column of reserved pixel circuits, and a plurality of in-situ pixel circuits 23 arranged along the second direction Y are referred to as one column of in-situ pixel circuits. For example, one row of reserved pixel circuits may include a plurality of second pixel circuits 22, or may include a plurality of second pixel circuits 22 and a plurality of invalid pixel circuits 24, or may include a plurality of invalid pixel circuits 24. Along the second direction Y, one row of reserved pixel circuits may be arranged every m rows of in-situ pixel circuits, and m may be an integer greater than 1. In other words, m rows of in-situ pixel circuits may be arranged between two adjacent rows of reserved pixel circuits. In this example, m may be 2. In some other examples, m may be 3 or 4. In this example, the structure of the invalid pixel circuit 24 may be similar to that of the second pixel circuit 22, and the invalid pixel circuit 24 is not connected with the light emitting element. By providing the invalid pixel circuit 24 in the second display region A2, uniformity of the circuit film layer in the second display region A2 can be ensured.

In some examples, the second display region A2 may further be provided with a plurality of first signal lines 35 and a plurality of second signal lines 36. The plurality of first signal lines 35 may extend along the first direction X and be arranged along the second direction Y. The plurality of second signal lines 36 may extend along the second direction Y and be arranged along the first direction X. For example, the plurality of first signal lines 35 may include a plurality of gate lines (including, for example, a first scanning line, a second scanning line, and a light emitting control line) and a plurality of initial signal lines. The plurality of second signal lines 36 may include a plurality of data lines and a plurality of first power supply lines. For example, the first signal lines 35 connected with one row of pixel circuits may include a first scanning line, a second scanning line, a light emitting control line, a first initial signal line, and a second initial signal line. The plurality of second signal lines 36 connected with one column of pixel circuits may include a data line and a first power supply line.

In some examples, as illustrated in FIG. 2, the plurality of data lines may include a plurality of first data lines DL1, a plurality of second data lines DL2, and a plurality of third data lines DL3. The plurality of third data lines DL3 are located in the second display region A2, extend along the second direction Y, and do not pass through the first display region A1. The plurality of first data lines DL1 and the plurality of second data lines DL2 extend along the second direction Y and pass through the first display region A1. The plurality of first data lines DL1 are partitioned by the first display region A1. A first data line DL1 may include two sub-line segments partitioned by the first display region A1, and one first data transfer line 361. The two sub-line segments of the first data line DL1 partitioned by the first display region A1 may be connected through the first data transfer line 361 located in the first display region A1. The first data transfer line 361 may bypass the second sub-region A12, for example, may be disposed in the first sub-region A11a or A11b, or may be disposed at a junction position between the first sub-region A11a (or A11b) and the second sub-region A12. The first data transfer line 361 may not be connected with the pixel circuit in the first display region A1. A second data line DL2 may include two sub-line segments located in the second display region A2 and a second data transfer line 362 located in the first display region A1. The two sub-line segments of the second data line DL2 located in the second display region A2 may be connected through the second data transfer line 362 located in the first display region A1, and the second data transfer line 362 may be connected with a plurality of first pixel circuits 21 sequentially arranged along the second direction Y in the first sub-region A11a (or A11b).

In some examples, the first data line DL1 and its connected first data transfer line 361 may have an integral structure, and the second data line DL2 and its connected second data transfer line 362 may have an integral structure. However, the present embodiment is not limited thereto. For example, the first data line DL1 and its connected first data transfer line 361 may be located on different conductive layers, or the second data line DL2 and its connected second data transfer line 362 may be located on different conductive layers.

In some examples, at least one first signal line 35 may extend to the first display region A1, connect with the plurality of first pixel circuits 21 arranged along the first direction X in the first sub-region A11a, and connect with the plurality of first pixel circuits 21 arranged along the first direction X in the first sub-region A11b after bypassing the second sub-region A12 along an outer edge of the second sub-region A12.

In some examples, trace portions of the first signal line 35 located in the first sub-regions A11a and A11b may be made of transparent conductive material, and trace portions of the second signal line 36 located in the first sub-regions A11a and A11b may be made of transparent conductive material, thereby ensuring the light transmittance of the first display region A1. In some other examples, trace portions of the plurality of first signal lines 35 located in the first sub-regions A11a and A11b may be collectively arranged, or trace portions of the plurality of second signal lines 36 located in the first sub-regions A11a and A11b may be collectively arranged.

In some examples, the plurality of first pixel circuits 21 in the first sub-regions A11a and A11b may be arranged in a dispersed manner. For example, the arrangement of the plurality of first pixel circuits 21 in the plurality of first sub-regions A11a and A11b may be similar to the arrangement of the pixel circuits in the second display region A2, for example, the first pixel circuits 21 may be aligned with the pixel circuits in the second display region A2 along the first direction X and the second direction Y.

In the present example, the first sub-regions A11a and A11b of the first display region A1 may adopt a pixel circuit built-in mode, and the second sub-region A12 may adopt a pixel circuit built-out mode. Compared with the case in which the first display region only adopts a pixel circuit built-out mode, the present example can reduce the number of built-out second pixel circuits, thereby reducing the number of the first conductive connection lines, which is beneficial to reduce the masking process of the conductive connection lines.

In the present example, the second sub-region A12 is located between the two first sub-regions A11a and A11b along the first direction X, and the first conductive connection line 31 extends and wires along the second direction Y. Therefore, it is possible to improve the situation that different lengths of the conductive connection lines caused by extending and wiring along the first direction X need to be compensated for. Furthermore, the plurality of data lines can be wound along the edge of the second sub-region A12 without being wound along the edge of the first display region A1. Therefore the winding length of the data line can be reduced, and load differences between the plurality of data lines are reduced, which is beneficial to avoid uneven display.

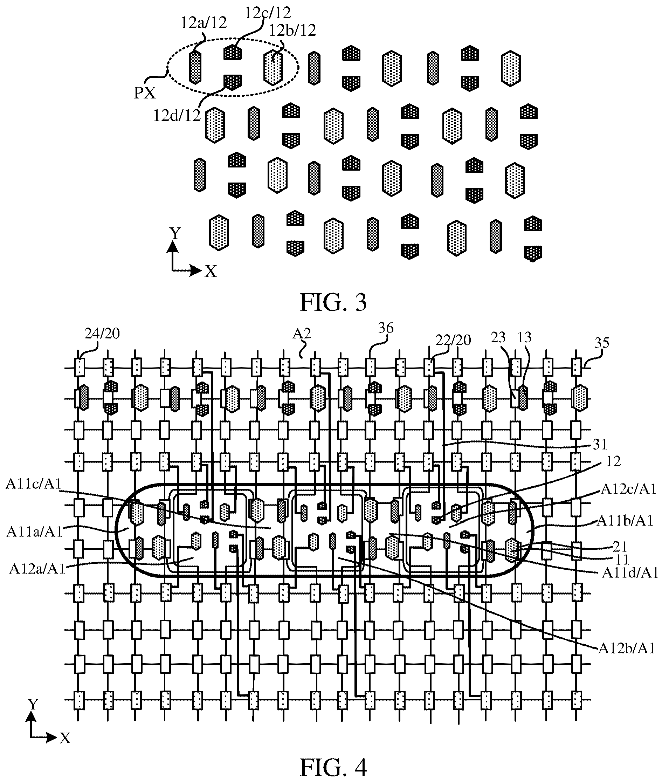

FIG. 3 is a schematic diagram of an arrangement of a plurality of second light emitting elements in a second sub-region of a first display region according to at least one embodiment of the present disclosure. In some examples, as shown in FIG. 3, the plurality of second light emitting elements 12 in the first display region may include: a plurality of second light emitting elements 12a emitting light of the first color, a plurality of second light emitting element 12b emitting light of the second color, and a plurality of second light emitting elements 12c and 12d emitting light of the third color. One pixel unit PX in the second sub-region may include one second light emitting element 12a emitting light of the first color, one second light emitting element 12b emitting light of the second color, and two second light emitting elements 12c and 12d emitting light of the third color. For example, the light of the first color may be red light, the light of the second color may be blue light, and the light of the third color light may be green light.

In some examples, in the second sub-region, a plurality of pixel units PX may be arrayed along a first direction X and a second direction Y. A plurality of pixel units PX arranged along the first direction X are one row of pixel units, and the pixel units in adjacent rows may be arranged along the first direction X in a staggered manner. For example, a misalignment distance of adjacent rows of pixel units along the first direction X may be less than the length of a single pixel unit along the first direction X.

In some examples, an orthographic projection of a light emitting region of a single second light emitting element 12a or 12b on the base substrate may be substantially hexagonal, and an orthographic projection of a light emitting region of a single second light emitting element 12c or 12d on the base substrate may be substantially pentagonal. An area of the light emitting region of a single second light emitting element 12a may be smaller than an area of the light emitting region of a single second light emitting element 12b, and an area of the light emitting region of a single second light emitting element 12c or 12d may be smaller than an area of the light emitting region of a single second light emitting element 12a. An area of the light emitting region of a single second light emitting element 12c and an area of the light emitting region of a single second light-emitting element 12d may be the same. The light emitting region of the light emitting element of the present example refers to an overlapping region between an anode of a light emitting element exposed by a pixel opening in a pixel definition layer and an orthographic projection of an organic functional layer and a cathode on the base substrate.

In some examples, in a single pixel unit PX, the second light emitting elements 12c and 12d may be aligned along the second direction Y and located between the second light emitting elements 12a and 12b in the first direction X. The second light emitting elements 12c and 12d may be disposed symmetrically with respect to an intermediate line therebetween extending along the first direction X.

As for the arrangement of the plurality of first light emitting elements in the first sub-region and the arrangement of the plurality of third light emitting elements in the second display region, the arrangement of the plurality of second light emitting elements in the second sub-region can be referred to, and thus the detailed description thereof is omitted.

FIG. 4 is another partial schematic diagram of a display region of a display substrate according to at least one embodiment of the present disclosure. In some examples, as shown in FIG. 4, a first display region A1 may be in a shape of a track hole extending along a first direction X. The first display region A1 may include four first sub-regions A11a, A11b, A11c, and A11d, and three second sub-regions A12a, A12b, and A12c. In this example, the number a of the second sub-regions may be 3. The four first sub-regions and the three second sub-regions may be arranged at intervals along the first direction X. For example, the first sub-region A11a may be located between a second display region A2 and the second sub-region A12a in the first direction X, the first sub-region A11b may be located between the second display region A2 and the second sub-region A12c in the first direction X, the first sub-region A11c may be located between the second sub-regions A12a and A12b in the first direction X, and the first sub-region A11d may be located between the second sub-regions A12b and A12c in the first direction X. In other words, the first sub-region A11a, the second sub-region A12a, the first sub-region A11c, the second sub-region A12b, the first sub-region A11d, the second sub-region A12c, and the first sub-region A11b may be arranged sequentially along the first direction X.

In some examples, as shown in FIG. 4, the four first sub-regions A11a, A11b, A11c, and A11d may adopt a pixel circuit built-in mode and be provided with a plurality of first pixel circuits 21 and a plurality of first light emitting elements 11. The three second sub-regions A12a, A12b, and A12c adopt a pixel circuit built-out mode and are provided with a plurality of second light emitting elements 12, and the plurality of second light emitting elements 12 are connected with a plurality of second pixel circuits 22 located in the second display region A2 through a plurality of first conductive connection lines 31. In the second display region A2 and along a second direction Y, one row of reserved pixel circuits may be arranged every two rows of in-situ pixel circuits 23, and at least one row of reserved pixel circuits may include a plurality of second pixel circuits 22 and a plurality of invalid pixel circuits 24. The structure of the invalid pixel circuit 24 may be similar to that of the second pixel circuit 22, and the invalid pixel circuit 24 is not connected with the light emitting element. By providing invalid pixel circuits 24 in the second display region A2, uniformity of the circuit film layer in the second display region A2 can be ensured.

In the first display region of the present example, the first sub-regions which adopt a pixel circuit built-in mode and the second sub-regions which adopt a pixel circuit built-out mode are arranged alternately along the first direction, which is beneficial to improve the display uniformity of the first display region. Furthermore, second pixel circuits are inserted into the plurality of in-situ pixel circuits along the second direction, such that the first conductive connection lines can be wired along the second direction Y, and lengths of the first conductive connection lines can be further shortened. Remaining description of the display substrate of the present example may be referred to the description in the aforementioned embodiments, which is not repeated here.

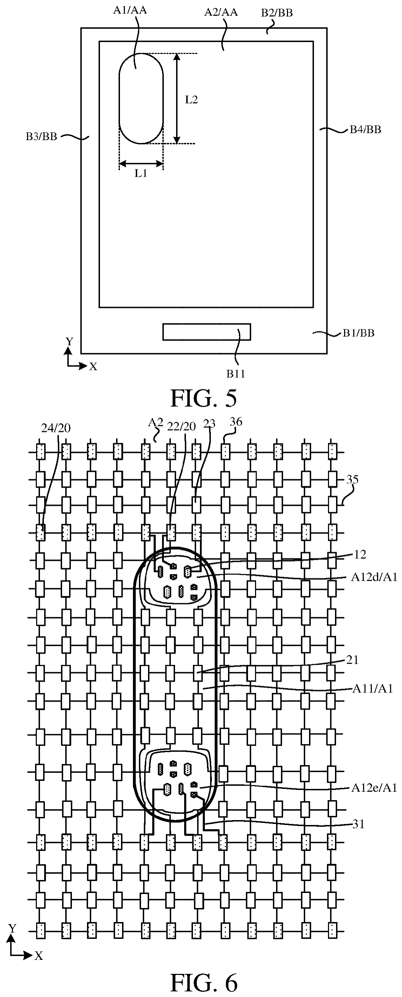

FIG. 5 is another schematic diagram of a display substrate according to at least one embodiment of the present disclosure. FIG. 6 is another partial schematic diagram of a display region of a display substrate according to at least one embodiment of the present disclosure. In FIG. 6, only several first conductive connection lines 31 between second light emitting elements 12 and second pixel circuits 22 are illustrated as examples.

In some examples, as shown in FIGS. 5 and 6, a first display region A1 may be located at an upper left corner of a display region AA, or may be located at an upper right corner. The first display region A1 of the display substrate may be in a shape of a track hole extending along a second direction Y. A maximum length L1 of the first display region A1 along a first direction X may be smaller than its maximum length L2 along the second direction Y.

In some examples, the number b of first sub-regions within the first display region may be 1. The first display region A1 may include one first sub-region A11 and two second sub-regions A12d and A12e. The first sub-region A11 may be located between the two second sub-regions A12e and A12d along the second direction Y. The second sub-region A12e, the first sub-region A11 and the second sub-region A12d are arranged aligned along the second direction Y. The second sub-regions A12e and A12d are both adjacent to a second display region A2 in the second direction Y. A maximum length of the first sub-region A11 along the second direction Y may be greater than a maximum length of the second sub-region A12e along the second direction Y, and may be greater than a maximum length of the second sub-region A12d along the second direction Y. For example, the second sub-regions A12e and A12d may be semi-circular, and the first sub-region A11 may be rectangular.

In some examples, in the second display region A2 and along the second direction Y, one row of reserved pixel circuits may be arranged every two rows of in-situ pixel circuits 23, and at least one row of reserved pixel circuits may include a plurality of second pixel circuits 22 and a plurality of invalid pixel circuits 24. The structure of the invalid pixel circuit 24 may be similar to that of the second pixel circuit 22, and the invalid pixel circuit 24 is not connected with the light emitting element. The second light emitting elements 12 in the second sub-regions A12e and A12d may be connected with the second pixel circuits 22 in the second display region A2 through the first conductive connection lines 31. The first conductive connection lines 31 may extend along the second direction Y.

The first display region A1 of the present example is in a shape of a track hole extending along the second direction Y, and the two second sub-regions A12d and A12e are provided at two ends of the first sub-region A11 along the second direction Y (for example, upper end and lower end), which can further reduce lengths of the first conductive connection lines and improve the situation that lengths of the conductive connection lines between the second light emitting elements and the second pixel circuits are different and need to be compensated for. Remaining description of the display substrate in this example may be referred to the description in the aforementioned embodiments, which is not repeated here.

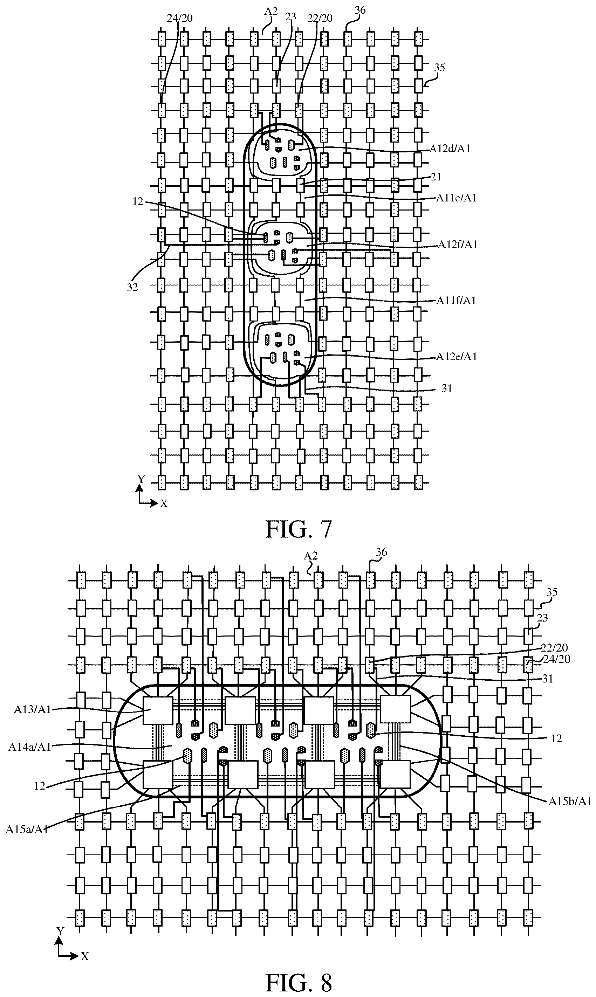

FIG. 7 is another schematic diagram of a display region of a display substrate according to at least one embodiment of the present disclosure. In some examples, the number b of first sub-regions within a first display region may be 2. As shown in FIG. 7, the first display region A1 may include two first sub-regions A11e and A11f, and three second sub-regions A12e, A12d, and A12f. The first display region A1 may be in a shape of a track hole extending along a second direction Y. The first sub-region A11e may be located between the second sub-regions A12d and A12f in the second direction Y, the second sub-region A12f may be located between the first sub-regions A11e and A11f in the second direction Y, and the first sub-region A11f may be located between the second sub-regions A12f and A12e in the second direction Y. The second sub-region A12d, the first sub-region A11e, the second sub-region A12f, the first sub-region A11f, and the second sub-region A12e may be arranged aligned along the second direction Y. Both the second sub-regions A12d and A12e are adjacent to the second display region A2 in the second direction Y.

In some examples, in the second display region A2: along the second direction Y, one row of reserved pixel circuits may be arranged every m rows of in-situ pixel circuits 23, and at least one row of reserved pixel circuits may include a plurality of second pixel circuits 22 and a plurality of invalid pixel circuits 24; along a first direction X, one column of reserved pixel circuits may be arranged every n columns of in-situ pixel circuits, and at least one column of reserved pixel circuits may include a plurality of second pixel circuits 22 and a plurality of invalid pixel circuits 24; both m and n may be integers greater than 1. For example, m and n may be the same, both being 2. In other examples, m and n may be different, for example, n may be greater than m.

In some examples, the second sub-regions A12d and A12e are adjacent to the second display region A2 in the second direction Y, and the plurality of second light emitting elements 12 in the second sub-regions A12d and A12e may be connected through a plurality of first conductive connection lines 31 with the plurality of second pixel circuits 22 which are inserted into the third pixel circuits 23 in the second display region A2 in the second direction Y. The second sub-region A12f is located between the first sub-regions A11e and A11f in the second direction Y, and the plurality of second light emitting elements 12 in the second sub-region A12f may be connected through a plurality of second conductive connection lines 32 with the plurality of second pixel circuits 22 which are inserted into the third pixel circuit 23 in the second display region A2 in the first direction X. The first conductive connection line 31 may extend along the second direction Y, and the second conductive connection line 32 may extend along the first direction X.

In this example, the first display region A1 is divided into a first sub-region and a second sub-region, wherein the second light emitting elements 12 in the second sub-region adjacent to the second display region A2 in the second direction Y are connected with second pixel circuits 22 through first conductive connection lines 31, and the second light emitting elements 12 in the second sub-region between two first sub-regions in the second direction Y are connected with second pixel circuits 22 through second conductive connection lines 32, therefore lengths of the conductive connection lines can be further shorten, and length differences between different conductive connection lines may be reduced. Remaining description of the display substrate in this example may be referred to the description in the aforementioned embodiments, which is not repeated here.

FIG. 8 is another partial schematic diagram of a display region of a display substrate according to at least one embodiment of the present disclosure. In some examples, as shown in FIG. 8, a first display region A1 may be in a shape of a track hole extending along a first direction X. The first display region A1 may include a plurality of island regions A13 spaced apart from each other, a transmissive region located between adjacent island regions A13 (for example, including a plurality of first transmissive regions A14a), and an inter-island connection region connecting adjacent island regions A13 (for example, including a plurality of first inter-island connection regions A15a and a plurality of second inter-island connection regions A15b). The plurality of island regions A13 may be arranged in an array. For example, a plurality of island regions A13 arranged along the first direction X may be referred to as one row of island regions, and a plurality of island regions A13 arranged along a second direction Y may be referred to as one column of island regions. A light transmittance of the first transmissive region A14a may be greater than light transmittances of the island region A13 and the inter-island connection region.

In some examples, in a plane parallel to the display substrate, the plurality of island regions A13 may have the same shape, for example, may be substantially rectangular, such as may be substantially square. The first inter-island connection region A15a may be a straight strip-shaped region extending along the first direction X, and may connect two island regions A13 arranged adjacently in the first direction X. A second inter-island connection region A15b may be substantially a straight strip-shaped region extending along the second direction Y, and may connect two island regions A13 arranged adjacently in the second direction Y.

In some examples, in a plane parallel to the display substrate, the plurality of first transmissive regions A14a may have the same shape, for example, may be in a shape of a cross formed by twelve sides. For example, a single first transmissive region A14a may be surrounded by four island regions A13 and four inter-island connection regions (including, for example, two first inter-island connection regions A15a and two second inter-island connection regions A15b). Adjacent first transmissive regions A14a arranged along the first direction X may be separated by a second inter-island connection region A15b, and adjacent first transmissive regions A14a arranged along the second direction Y may be separated by a first inter-island connection region A15a.

In some examples, an area of a single first transmissive region A14a may be larger than an area of a single island region A13, to increase the light transmittance of the first display region A1.

In some examples, a single island region A13 may be provided with a plurality of first pixel circuits and a plurality of first light emitting elements, the plurality of first pixel circuits are connected with the plurality of first light emitting elements and are configured to drive the plurality of first light emitting elements to emit light. A single first transmissive region A14a may be provided with a plurality of second light emitting elements 12, and the plurality of second light emitting elements 12 may be connected with a plurality of second pixel circuits 22 located in the second display region A2 through a plurality of first conductive connection lines 31 extending along the second direction Y. In the second display region A2 and along the second direction Y, one row of reserved pixel circuits may be arranged every two rows of in-situ pixel circuits 23, and at least one row of reserved pixel circuits may include a plurality of second pixel circuits 22 and a plurality of invalid pixel circuits 24.

In some examples, the first display region A1 only includes a plurality of first transmissive regions A14a, in other words, each of the transmissive regions between adjacent island regions A13 is provided therein a plurality of second light emitting elements 12. In some other examples, the first display region A1 may include a plurality of transmissive regions, and the plurality of transmissive regions may include a plurality of first transmissive regions A14a and a plurality of second transmissive regions. A plurality of second light emitting elements 12 may be provided in the first transmissive regions A14a, and the second transmissive regions may not be provided with pixel circuit or light emitting element. For example, the size of a single first transmissive region A14a may be the same as the size of a single second transmissive region. The plurality of first transmissive regions and the plurality of second transmissive regions may be arranged at intervals along the first direction, or the plurality of first transmissive regions and the plurality of second transmissive regions may be arranged at intervals along both of the first direction and the second direction.

In the first display region of the present example, the island region (which is used as a pixel circuit built-in region) adopts a pixel circuit built-in mode, and the first transmissive region (which is used as a pixel circuit built-out region) adopts a pixel circuit built-out mode, which may be beneficial to improve the display uniformity of the first display region. Further, in combination with the arrangement in which second pixel circuits are inserted into third pixel circuits along the second direction, first conductive connection lines can be arranged and wired along the second direction, which may be beneficial to shorten lengths of the first conductive connection lines. In addition, a plurality of data lines (for example, the plurality of first data lines partitioned by the first display region A1) can be arranged by wiring in the island region and the inter-island connection region, without bypassing the edge of the first display region A1, which is beneficial to shorten winding lengths of the data lines, and can avoid uneven display caused by excessive load differences between different data lines. Remaining description of the display substrate in this example may be referred to the description in the aforementioned embodiments, which is not repeated here.

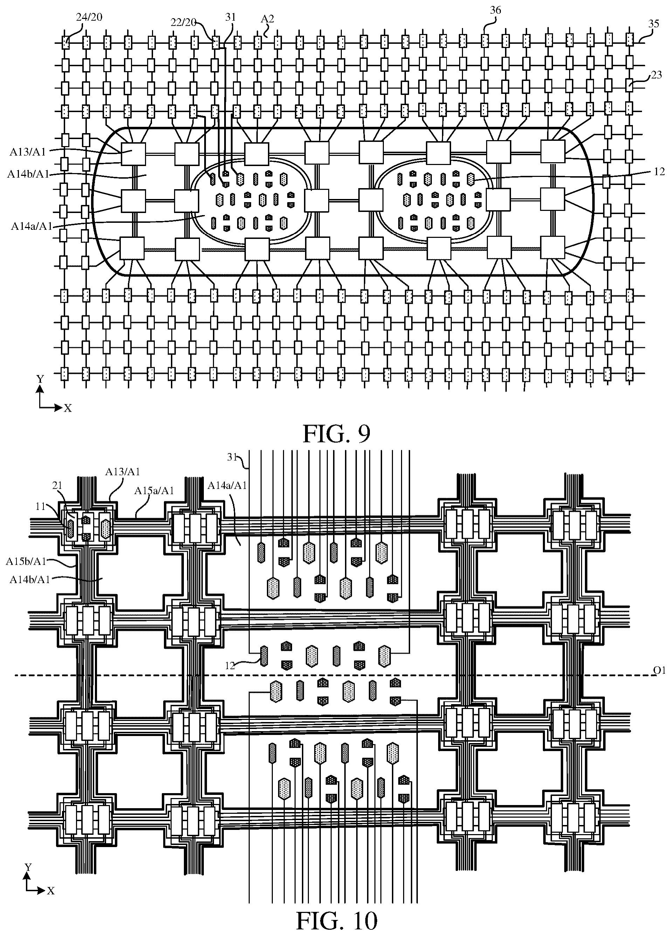

FIG. 9 is another partial schematic diagram of a display region of a display substrate according to at least one embodiment of the present disclosure. In some examples, as shown in FIG. 9, a first display region A1 may be in a shape of a track hole extending along a first direction X. The first display region A1 may include a plurality of island regions A13 spaced apart from each other, a transmissive region located between adjacent island regions A13 (including, for example, a plurality of first transmissive regions A14a and a plurality of second transmissive regions A14b) , and an inter-island connection region connecting adjacent island regions A13.

In some examples, the plurality of island regions A13 may be regularly arranged along the first direction X and a second direction Y. The first transmissive region A14a may be provided with a plurality of second light emitting elements 12, and the plurality of second light emitting elements 12 may be connected with a plurality of second pixel circuits 22 located in a second display region A2 through a plurality of first conductive connection lines 31 extending along the second direction Y. In the second display region A2 and along a second direction Y, one row of reserved pixel circuits may be arranged every two rows of in-situ pixel circuits 23, and at least one row of reserved pixel circuits may include a plurality of second pixel circuits 22 and a plurality of invalid pixel circuits 24. In order to improve light transmittance of the first display region A1, the second transmissive region A14b may not be provided with light emitting element or pixel circuit.

In some examples, the second transmissive region A14b may be surrounded by four island regions A13 and four inter-island connection regions. The first transmissive region A14a may be surrounded by a plurality of (e.g. eight) island regions A13 and a plurality of inter-island connection regions. The second transmissive regions A14b and the first transmissive regions A14a may be arranged at intervals along the first direction X. An area of a single first transmissive region A14a may be greater than an area of a single second transmissive region A14b. For example, a length of the single first transmissive region A14a along the second direction Y may be greater a length of the single second transmissive region A14b along the second direction Y, and a length of the single first transmissive region A14a along the first direction X may be greater than a length of the single second transmissive region A14b along the first direction X. A maximum length of a single first transmissive region A14a along the first direction X may be greater than a maximum length of the single first transmissive region A14a along the second direction Y.

In the first display region of the present example, the island region A13 (which is used as a pixel circuit built-in region) adopts a pixel circuit built-in mode, the first transmissive region A14a (which is used as a pixel circuit built-out region ) adopts a pixel circuit built-out mode, and the second transmissive region A14b is not provided with pixel circuit and light emitting element, which may be beneficial to improve display uniformity and light transmittance of the first display region A1. Further, in combination with the arrangement in which second pixel circuits 22 are inserted into third pixel circuits 23 along the second direction Y, first conductive connection lines 31 can extend and wire along the second direction Y, which is beneficial to shorten lengths of the first conductive connection lines 31. In addition, a plurality of data lines (for example, the plurality of first data lines partitioned by the first display region A1) can be arranged by wiring in the island region A13 and the inter-island connection region, without bypassing the edge of the first display region A1, which is beneficial to shorten winding lengths of the data lines, and can avoid uneven display caused by excessive load differences between different data lines. Remaining description of the display substrate in this example may be referred to the description in the aforementioned embodiments, which is not repeated here.

FIG. 10 is another partial schematic diagram of a first display region of a display substrate according to at least one embodiment of the present disclosure. In some examples, as shown in FIG. 10, a first display region A1 may include a plurality of island regions A13, a plurality of transmissive regions (e.g., including a plurality of first transmissive regions A14a and a plurality of second transmissive regions A14b), and a plurality of inter-island connection regions (e.g., including a plurality of first inter-island connection regions A15a and a plurality of second inter-island connection regions A15b).

In some examples, an island region A13 is provided therein with a plurality of first light emitting elements 11 and a plurality of first pixel circuits 21. For example, a single island region A13 may be provided therein with three first pixel circuits 21, and the three first pixel circuits 21 may be sequentially arranged along a first direction X. A single island region A13 may be provided therein with three first light emitting elements, which are electrically connected with three first pixel circuits 21 in a one-to-one correspondence. Alternatively, the single island region A13 may be provided therein with four first light emitting elements (including, for example, one first light emitting element that emits light of the first color, one first light emitting element that emits light of the second color, and two first light emitting elements that emit light of the third color) , wherein the one first light emitting element that emits light of the first color is connected with one first pixel circuit, the one first light emitting element that emits light of the second color is connected with one first pixel circuit, and the two first light emitting elements that emit light of the third color may be connected with the same first pixel circuit.

In some examples, the first transmissive region A14a is provided therein with a plurality of second light emitting elements 12, and the second transmissive region A14b is not provided with light emitting element and pixel circuit. A single second transmissive region A14b may be surrounded by four island regions A13, two first inter-island connection regions A15a, and two second inter-island connection regions A15b. A single first transmissive region A14a may be surrounded by four island regions A13, two first inter-island connection regions A15a, and two second inter-island connection regions A15b. The plurality of first transmissive regions A14a and the plurality of second transmissive regions A14b may be arranged at intervals along the first direction X, for example, one column of first transmissive regions may be arranged every two columns of second transmissive regions.

In some examples, a maximum length of the first transmissive region A14a along the first direction X may be greater than a maximum length of the first transmissive region A14a along a second direction Y. The maximum length of the first transmissive region A14a along the first direction X may be greater than a maximum length of the second transmissive region A14b along the first direction X, and the maximum length of the first transmissive region A14a along the second direction Y may be the same as a maximum length of the second transmissive region A14b along the second direction Y. A length of the first inter-island connection region A15a adjacent to the first transmissive region A14a along the first direction X may be greater than a length of the first inter-island connection region A15a adjacent to the second transmissive region A14b along the first direction X.

In some examples, the plurality of second light emitting elements 12 in the first transmissive region A14a may be connected with the plurality of second pixel circuits in the second display region A2 through a plurality of first conductive connection lines 31. The plurality of first conductive connection lines 31 may extend along the second direction Y. For example, the first display region A1 may have a first center line O1 extending along the first direction X, a plurality of second light emitting elements 12 located above the first center line O1 may be connected with a plurality of second pixel circuits in the second display region at upper side of the first display region A1, and a plurality of second light emitting elements 12 located below the first center line O1 may be connected with a plurality of second pixel circuits in the second display region at lower side of the first display region A1.

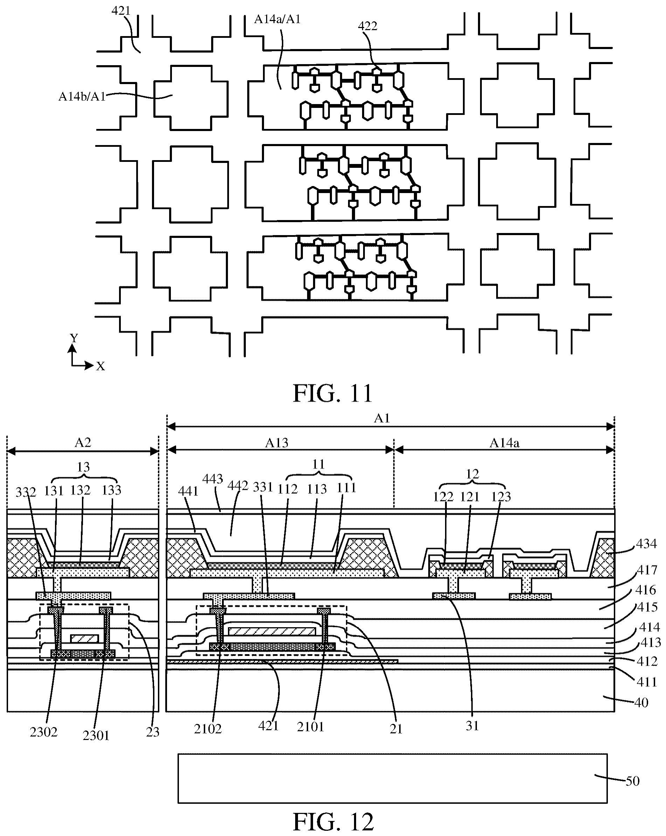

FIG. 11 is a partial schematic diagram of a shielding layer of the first display region in FIG. 10. In some examples, as shown in FIGS. 10 and 11, the display substrate may further include a shielding layer located in the first display region A1. The shielding layer may include a first shielding layer 421 and a second shielding layer 422. An orthographic projection of the first shielding layer 421 on the base substrate may cover orthographic projections of the plurality of first pixel circuits 21 and the plurality of first light emitting elements 11 in the island region A13 on the base substrate, and may also cover orthographic projections of traces of the plurality of inter-island connection regions on the base substrate. The second shielding layer 422 may be located in the first transmissive region A14a, and an orthographic projection of the second shielding layer 422 on the base substrate may cover orthographic projections of the plurality of second light emitting elements 12 in the first transmissive region A14a on the base substrate. The first shielding layer 421 and the second shielding layer 422 may have an integral structure.

In some examples, the integral structure of the first shielding layer 421 and the second shielding layer 422 may be used to implement patterning of a cathode layer of the first display region A1. For example, a patterned cathode layer can be obtained by using a laser light to irradiate a cathode thin film covered by the first shielding layer 421 and the second shielding layer 422. In some other examples, the display substrate may be provided with only the first shielding layer or only the second shielding layer.

In this example, the shielding layer is used to shield the pixel circuit, the light emitting element, and the trace of the first display region, which may be beneficial to reduce diffraction of the first display region and improve the display effect of the first display region. Remaining description of the display substrate in this example may be referred to the description in the aforementioned embodiments, which is not repeated here.

FIG. 12 illustrates schematically a partial cross-sectional view of a display substrate according to at least one embodiment of the present disclosure. In some examples, as shown in FIG. 12, in a direction perpendicular to the display substrate, the display substrate may include a base substrate 40, and a circuit structure layer, a light emitting structure layer, and an encapsulation structure layer which are disposed on the base substrate 40, sequentially. In some examples, the display substrate may further include other film layers, e.g. a touch structure layer, a color filter layer and the like. The present embodiment is not limited thereto.

In some examples, a circuit structure layer of a first display region A1 may include a first pixel circuit 21 located in an island region A13, and a light emitting structure layer of the first display region A1 may include a first light emitting element 11 located in the island region A13 and a second light emitting element 12 located in a first transmissive region A14a. A circuit structure layer of a second display region A2 may include a second pixel circuit, an in-situ pixel circuit 23, and a third light emitting element 13. FIG. 12 illustrates in the second display region A2 one transistor of a in-situ pixel circuit 23 and one third light emitting element 13 as an example, and illustrates in the first display region A1 one transistor of a first pixel circuit 21, one first light emitting element 11 and two second light-emitting elements 12 as an example.

In some examples, the circuit structure layer may include a first shielding layer 421, a semiconductor layer, a first conductive layer, a second conductive layer, a third conductive layer and a first transparent conductive connection layer disposed on the base substrate 40. A first insulation layer 411 (which may also be referred to as a first buffer layer) may be provided between the first shielding layer 421 and the base substrate 40, a second insulation layer 412 (which may also be referred to as a second buffer layer) may be provided between the first shielding layer 421 and the semiconductor layer, a third insulation layer 413 (which may also be referred to as a first gate insulation layer) may be provided between the semiconductor layer and the first conductive layer, a fourth insulation layer 414 (which may also be referred to as a second gate insulation layer) may be provided between the first conductive layer and the second conductive layer, a fifth insulation layer 415 (which may also be referred to as an interlayer insulation layer) may be provided between the second conductive layer and the third conductive layer, a sixth insulation layer 416 (which may also be referred to as a first flat layer) may be provided between the third conductive layer and the first transparent conductive connection layer, and a seventh insulation layer 417 (which may also be referred to as a second flat layer) may be provided on a side of the first transparent conductive connection layer away from the base substrate 40. The first conductive layer may also be referred to as a first gate metal layer, the second conductive layer may also be referred to as a second gate metal layer, and the third conductive layer may also be referred to as a first source-drain metal layer. In some examples, the first shielding layer 421, the first conductive layer, the second conductive layer, and the third conductive layer may employ a metal material, and the first transparent conductive connection layer may employ a transparent conductive material, such as ITO.

In some examples, the first insulation layer 411 to the fifth insulation layer 415 may be inorganic insulation layers, and the sixth insulation layer 416 and the seventh insulation layer 417 may be organic insulation layers. However, the present embodiment is not limited thereto. In some other examples, an inorganic insulation layer may also be provided between the sixth insulation layer 416 and the third conductive layer.

In some examples, the first shielding layer 421 may be located in the island region A13 and the inter-island connection region of the first display region A1, and an orthographic projection of the first shielding layer 421 on the base substrate 40 may cover an orthographic projection of an active layer of at least one transistor of the first pixel circuit 21 of the island region A13 on the base substrate 40. For example, the first pixel circuit 21 includes a plurality of transistors, and the orthographic projection of the first shielding layer 421 on the base substrate may cover the orthographic projections of the active layers of all transistors of the first pixel circuit 21 on the base substrate. In this example, by providing the first shielding layer 421 in the island region A13 to cover the active layer of the transistor of the first pixel circuit 21, interference from external light to the transistor of the first pixel circuit 21 can be avoided, and performance of the transistor of the first pixel circuit 21 can be ensured.

In some examples, the semiconductor layer may include, at least, the active layer of the transistor of the first pixel circuit 21 located in the island region A13, and an active layer of a transistor of the in-situ pixel circuit 23 located in the second display region A2. The first conductive layer may include, at least, a gate of the transistor and a first electrode of a storage capacitor (not shown) of the first pixel circuit 21 located in the island region A13, and a gate of the transistor and a first electrode of a storage capacitor (not shown) of the in-situ pixel circuit 23 located in the second display region A2. The second conductive layer may include, at least, a second electrode (not shown) of the storage capacitor of the first pixel circuit 21, and a second electrode (not shown) of the storage capacitor of the in-situ pixel circuit 23. The third conductive layer may include, at least, a first electrode 2101 and a second electrode 2102 of the transistor of the first pixel circuit 21, and a first electrode 2301 and a second electrode 2302 of the transistor of the in-situ pixel circuit 23. The transparent conductive connection layer may include a plurality of first anode connection electrodes 331 located in the first display region A1, a plurality of second anode connection electrodes 332 located in the second display region A2, and a plurality of first conductive connection lines 31. One end of the first conductive connection line 31 may be connected with a second light emitting element 12, and the other end may extend to the second display region A2 and be connected with a second pixel circuit in the second display region A2.

In some examples, the light emitting structure layer may include an anode layer, a pixel definition layer 434, an organic functional layer, and a cathode layer that are disposed sequentially. The anode layer may include, at least, an anode 121 of the second light emitting element 12 located in the first transmissive region A14a, an anode 111 of the first light emitting element 11 located in the island region A13, and an anode 131 of the third light emitting element 13 located in the second display region A2. The organic functional layer may include, at least, an organic light emitting layer 122 of the second light emitting element 12 located in the first transmissive region A14a, an organic light emitting layer 112 of the first light emitting element 11 located in the island region A13, and an organic light emitting layer 132 of the third light emitting element 13 located in the second display region A2. The cathode layer may include, at least, a cathode 123 of the second light emitting element 12 located in the first transmissive region A14a, a cathode 113 of the first light emitting element 11 located in the island region A13, and a cathode 133 of the third light emitting element 13 located in the second display region A2.

In some examples, the anode 131 of the third light emitting element 13 may be located on the seventh insulation layer 417, and may be connected with a second anode connection electrode 332 through a via opened in the seventh insulation layer 417, and the second anode connection electrode 332 may be connected with a third pixel circuit 23 through a via opened in the sixth insulation layer 416. The pixel definition layer 434 may be provided with a third pixel opening opened in the second display region A2, and the third pixel opening may expose at least a part of a surface of the anode 131 of the third light emitting element 13. The organic light emitting layer 132 and the cathode 133 of the third light emitting element 13 may be sequentially stacked on the anode 131 exposed by the third pixel opening.

In some examples, the anode 121 of the second light emitting element 12 may be located on the seventh insulation layer 417, and may be connected with a first conductive connection line 31 through a via opened in the seventh insulation layer 417. The first conductive connection line 31 may extend to the second display region A2, and may be connected with a second pixel circuit located in the second display region A2 through a via opened in the sixth insulation layer 416. The pixel definition layer 434 may be provided with a second pixel opening opened in the first transmissive region A14a of the first display region A1, and the second pixel opening may expose at least a part of a surface of the anode 121 of the second light emitting element 12. The organic light emitting layer 122 and the cathode 123 of the second light emitting element 12 may be sequentially stacked on the anode 121 exposed by the second pixel opening.

In some examples, an anode 111 of the first light emitting element 11 may be located on the seventh insulation layer 417 and be connected with the first anode connection electrode 331 through a via opened in the seventh insulation layer 417, and the first anode connection electrode 331 may be connected with a first pixel circuit 21 through a via opened in the sixth insulation layer 416. The pixel definition layer 434 may be provided with a first pixel opening opened in the island region A13 of the first display region A1, and the first pixel opening may expose at least a part of a surface of the anode 111 of the first light emitting element 11. The organic light emitting layer 112 and the cathode 113 of the first light emitting element 11 may be sequentially stacked on the anode 111 exposed by the first pixel opening.

In some examples, the cathode 133 of the third light emitting element 13, the cathode 113 of the first light emitting element 11, and the cathode 123 of the second light emitting element 12 may be connected with each other to form an integral structure. The cathode layer of the second display region A2 may have a whole-surface structure, and the cathode layer of the first display region A1 may adopt a patterned design. For example, the pattern of the cathode layer of the first display region A1 may be as shown in FIG. 11, wherein the cathode thin film of the second transmissive region A14b of the first display region A1 may be removed, and the cathode thin film of the region other than the second light emitting element 12 in the first light transmissive region A14a may be removed to improve the light transmittance of the first display region A1.

In some examples, the encapsulation structure layer may include a first encapsulation layer 441, a second encapsulation layer 442, and a third encapsulation layer 443 which are stacked, wherein the first encapsulation layer 441 and the third encapsulation layer 443 may be made of an inorganic material, the second encapsulation layer 442 may be made of an organic material, and the second encapsulation layer 442 may be disposed between the first encapsulation layer 441 and the third encapsulation layer 443 to form a laminated structure of an inorganic material/an organic material/an inorganic material, which can ensure that external water vapor cannot enter the light emitting structure layer.

In some examples, a sensor 50 may be provided on a non-display side of the display substrate, and an orthographic projection of the sensor 50 on the display substrate may be overlapped with the first display region A1 of the display substrate. For example, the orthographic projection of the sensor 50 on the display substrate may be located within the first display region A1. For example, the sensor 50 may include a camera or an infrared sensor.

In this example, the anode 121 of the second light emitting element 12 and the anode 111 of the first light emitting element 11 are both provided on a side of the seventh insulation layer 417 away from the base substrate 40, so that the flatness of the first light emitting element 11 and the second light emitting element 12 in the first display region A1 can be ensured, which may be beneficial to ensure the display effect of the first display region A1. Remaining description of the display substrate in this example may be referred to the description in the aforementioned embodiments, which is not repeated here.

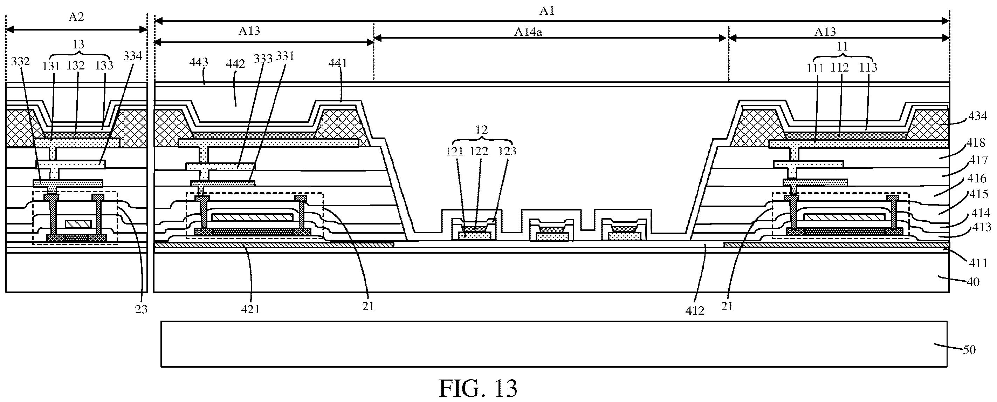

FIG. 13 illustrates schematically another partial cross-sectional view of a display substrate according to at least one embodiment of the present disclosure. In some examples, as shown in FIG. 13, in a direction perpendicular to the display substrate, the display substrate may include a base substrate 40, and a circuit structure layer, a light emitting structure layer, and an encapsulation structure layer which are sequentially disposed on the base substrate 40. The circuit structure layer may include a first shielding layer 421, a semiconductor layer, a first conductive layer, a second conductive layer, a third conductive layer, a first transparent conductive connection layer, and a second transparent conductive connection layer that are disposed on the base substrate 40. A seventh insulation layer 417 may be provided between the first transparent conductive connection layer and the second transparent conductive connection layer, and an eighth insulation layer (which may also be referred to as a third flat layer) 418 may be provided on a side of the second transparent conductive connection layer away from the base substrate 40. The sixth insulation layer 416 to the eighth insulation layer 418 may be organic insulation layers, and the first insulation layer 411 to the fifth insulation layer 415 may be inorganic insulation layers. The first transparent conductive connection layer and the second transparent conductive connection layer may be made of a transparent conductive material, for example ITO.

In some examples, the first transparent conductive connection layer may include a second anode connection electrode 332 located in a second display region A2, and a first anode connection electrode 331 located in a first display region A1. The second transparent conductive connection layer may include a fourth anode connection electrode 334 located in the second display region A2 and a third anode connection electrode 333 located in the first display region A1. The anode 131 of the third light emitting element 13 and the anode 111 of the first light emitting element 11 may be located on the eighth insulation layer 418. The anode 131 of the third light emitting element 13 may be connected with the fourth anode connection electrode 334 through a via opened in the eighth insulation layer 418, and the fourth anode connection electrode 334 may be connected with the second anode connection electrode 332 through a via opened in the seventh insulation layer 417. The anode 111 of the first light emitting element 11 may be connected with the third anode connection electrode 333 through a via opened in the eighth insulation layer 418, and the third anode connection electrode 333 may be connected with the first anode connection electrode 331 through a via opened in the seventh insulation layer 417.

In some examples, the first conductive connection line may be of the same layer structure as the anode layer. The anode 121 of the second light emitting element 12 and its connected first conductive connection line may have an integral structure. The anode 121 of the second light emitting element 12 may be located on the second insulation layer 412. For example, after the preparation of the eighth insulation layer 418 is completed, the eighth insulation layer 418, the seventh insulation layer 417, the sixth insulation layer 416, the fifth insulation layer 415, the fourth insulation layer 414, and the third insulation layer 413 in the first transmissive region A14a may be removed so that the anode 121 of the second light emitting element 12 may be formed on the second insulation layer 412. However, the present embodiment is not limited thereto. In some other examples, the anode 121 of the second light emitting element 12 may be located on the third insulation layer, the fourth insulation layer, the fifth insulation layer, the sixth insulation layer or the seventh insulation layer. In some other examples, the conductive connection line connected with the anode 121 of the second light emitting element 12 may be located on the first transparent conductive connection layer or the second transparent conductive connection layer.

In this example, the anode 111 of the first light emitting element 11 and the anode 121 of the second light emitting element 12 may be located on different insulation layers. By removing a plurality of insulation layers on a side of the second light emitting element 12 close to the base substrate 40 in the first transmissive region A14a, it may be beneficial to improve the light transmittance of the first transmissive region. Remaining description of the display substrate in this example may be referred to the description in the aforementioned embodiments, which is not repeated here.

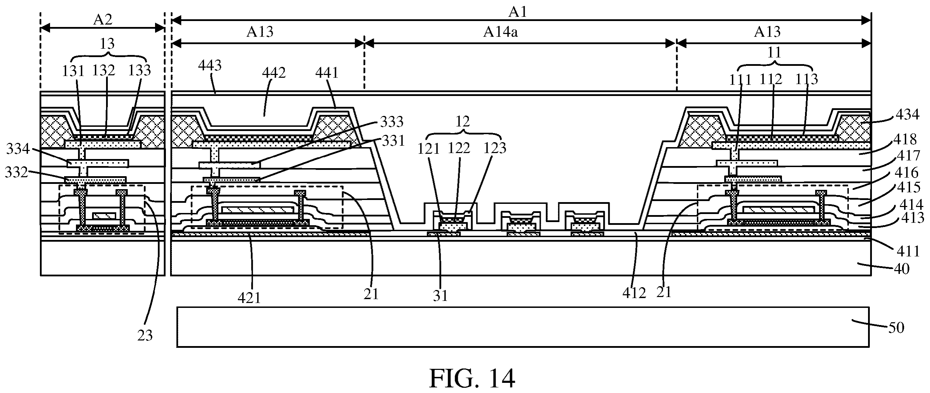

FIG. 14 illustrates schematically another partial cross-sectional view of a display substrate according to at least one embodiment of the present disclosure. In some examples, as shown in FIG. 14, in a direction perpendicular to the display substrate, the display substrate may include a base substrate 40, and a circuit structure layer, a light emitting structure layer, and an encapsulation structure layer which are sequentially disposed on the base substrate 40. A conductive connection line (for example, the first conductive connection line 31) connected with the anode 121 of the second light-emitting element 12 may be disposed in the same layer as the first shielding layer 421. The anode 121 of the second light emitting element 12 may be located on the second insulation layer 412.

In this example, the anode 111 of the first light emitting element 11 and the anode 121 of the second light emitting element 12 may be located on different insulation layers. By removing a plurality of insulation layers on a side of the second light emitting element 12 close to the base substrate 40 in the first transmissive region A14a, and disposing a conductive connection line (for example, the first conductive connection line 31) connected with the second light emitting element 12 to be in the same layer as the first shielding layer 421, it is not only beneficial to arrange the conductive connection line, but also beneficial to improve the light transmittance of the first transmissive region. Remaining description of the display substrate in this example may be referred to the description in the aforementioned embodiments, which is not repeated here.

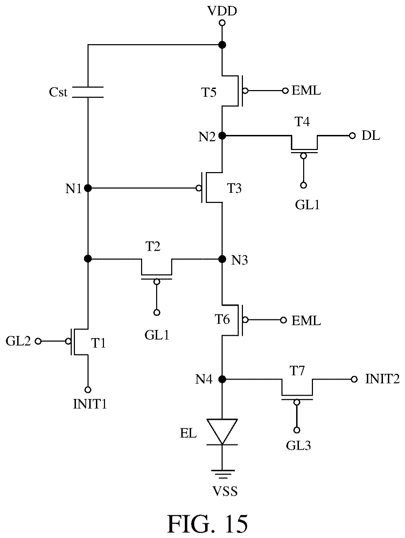

FIG. 15 is an equivalent circuit diagram of a pixel circuit according to at least one embodiment of the present disclosure. The pixel circuit of the present example may be a 7T1C structure, and may include seven transistors (e.g., first transistors T1 to seventh transistors T7) and one capacitor (e.g., a storage capacitor Cst). The pixel circuit may be electrically connected with a first scan line GL1, a second scan line GL2, a third scan line GL3, a light emitting control line EML, a first initial signal line INIT1, a second initial signal line INIT2, a data line DL, and a first power supply line VDD. The light-emitting element EL may be connected with the pixel circuit and the second power supply line VSS.

In some examples, the first power supply line VDD may be configured to provide a constant first voltage signal to the pixel circuit, and the second power supply line VSS may be configured to provide a constant second voltage signal to the pixel circuit, and the first voltage signal may be greater than the second voltage signal. The first scan line GL1 may be configured to provide a first scan signal SCAN1 to the pixel circuit, the data line DL may be configured to provide a data signal to the pixel circuit, the light emitting control line EML may be configured to provide a light emitting control signal EM to the pixel circuit, the second scan line GL2 may be configured to provide a second scan signal SCAN2 to the pixel circuit, and the third scan line GL3 may be configured to provide a third scan signal SCAN3 to the pixel circuit.

In some examples, the second scan line GL2 electrically connected to an n-th row of pixel circuits may be electrically connected to the first scan line GL1 electrically connected to an (n-1)-th row of pixel circuits, so that the second scan line GL2 is input with a first scan signal SCAN1 (n-1). That is, a second scan signal SCAN2 (n) may be the same as the first scan signal SCAN1 (n-1). A third scan line GL3 of the n-th row of pixel circuits may be electrically connected with a first scan line GL1 of the n-th row of pixel circuits, so that the third scan line GL3 is input with the first scan signal SCAN1 (n). That is, the third scan signal SCAN3 (n) may be the same as the first scan signal SCAN1 (n). Herein, n is an integer greater than 0. Thus, signal lines of the display substrate may be reduced, thereby achieving a narrow bezel design of the display substrate. However, the present embodiment is not limited thereto.

In some examples, the first initial signal line INIT1 may be configured to provide a first initial signal to the pixel circuit, and the second initial signal line INIT2 may be configured to provide a second initial signal to the pixel circuit. In some examples, the first initial signal and the second initial signal line may be the same, so only the first initial signal line may be provided to provide the first initial signal. However, the present embodiment is not limited thereto. In some other examples, the first initial signal may be different from the second initial signal. The first initial signal and the second initial signal may be constant voltage signals, and their magnitudes may be between a first voltage signal and a second voltage signal, but are not limited thereto.

In some examples, the first transistor T1 is also referred to as a first reset transistor, the second transistor T2 is also referred to as a threshold compensation transistor, the third transistor T3 is also referred to as a drive transistor, the fourth transistor T4 is also referred to as a data writing transistor, the fifth transistor T5 is also referred to as a first light emitting control transistor, the sixth transistor T6 is also referred to as a second light emitting control transistor, and the seventh transistor T7 is also referred to as a second reset transistor. The light emitting device EL may be an Organic Light Emitting Diode (OLED) including a first electrode (e.g., anode), an organic emitting layer, and a second electrode (e.g., cathode) that are stacked.

In some examples, the transistor types of the first transistor T1 to the seventh transistor T7 may be the same, for example, all are P-type transistors, or all may be N-type transistors. However, the present embodiment is not limited thereto. In some other examples, the first transistor T1 and the second transistor T2 may be N-type transistors, and the third transistor T3 to the seventh transistor T7 may be P-type transistors.

In some examples, the first transistor T1 to the seventh transistor T7 may employ low-temperature polysilicon thin film transistors. Alternatively, the first transistor T1 and the second transistor T2 may be oxide thin film transistors, and the third transistor T3 to the seventh transistor T7 may be low temperature poly-silicon thin film transistors. Low Temperature Poly Silicon (LTPS) is adopted for an active layer of a low temperature poly silicon thin film transistor and an oxide semiconductor (Oxide) is adopted for an active layer of an oxide thin film transistor. The low temperature poly silicon thin film transistor has advantages, such as a high mobility, and fast charging, etc., while the oxide thin film transistor has advantages, such as a low leakage current, etc. The low temperature poly-silicon thin film transistor and the oxide thin film transistor are integrated on one display substrate to form a low temperature poly-crystalline oxide (LTPS+ Oxide) display substrate, and advantages of both the low temperature poly silicon thin film transistor and the oxide thin film transistor can be utilized, which can achieve low frequency drive, reduce power consumption, and improve display quality.

In some examples, a first electrode of the storage capacitor Cst is connected with a first node N1, that is, the first electrode of the storage capacitor Cst is connected with a gate of the third transistor T3, and a second electrode of the storage capacitor Cst is connected with the first power supply line VDD.

In some examples, a gate of the first transistor T1 is connected with the second scan line GL2, a first electrode of the first transistor T1 is connected with the first initial signal line INIT1, and a second electrode of the first transistor T1 is connected with the first node N1. When an on-level signal is applied to the second scan line GL2, the first transistor T1 transmits a first initial signal supplied from the first initial signal line INIT1 to the gate of the third transistor T3 to initialize the charge amount of the gate of the third transistor T3.

In some examples, a gate of the second transistor T2 is connected with a first scan line GL1, a first electrode of the second transistor T2 is connected with a third node N3, and a second electrode of the second transistor T2 is connected with the first node N1. When an on-level signal is applied to the first scan line GL1, the second transistor T2 enables the gate of the third transistor T3 to be connected with the second electrode of the third transistor T3.

In some examples, the gate of the third transistor T3 is connected with the first node N1, i.e., the gate of the third transistor T3 is connected with the first electrode of the storage capacitor Cst, the first electrode of the third transistor T3 is connected with the second node N2, and the second electrode of the third transistor T3 is connected with the third node N3. The third transistor T3 determines a drive current flowing between the first power supply line VDD and the second power supply line VSS according to a potential difference between the gate and the first electrode of the third transistor T3. The first power supply line VDD may be configured to transmit a first voltage signal, the second power supply line VSS may be configured to transmit a second voltage signal, and the first voltage signal may be greater than the second voltage signal.

In some examples, a gate of the fourth transistor T4 is connected with the first scan line GL1, a first electrode of the fourth transistor T4 is connected with the data line DL, and a second electrode of the fourth transistor T4 is connected with the second node N2. When an on-level signal is applied to the first scan line GL1, the fourth transistor T4 enables a data voltage of the data line DL to be input to the pixel circuit.

In some examples, a gate of the fifth transistor T5 is connected with the light emitting control line EML, a first electrode of the fifth transistor T5 is connected with the first power supply line VDD, and a second electrode of the fifth transistor T5 is connected with the second node N2. A gate of the sixth transistor T6 is connected with the light emitting control line EML, a first electrode of the sixth transistor T6 is connected with the third node N3, and a second electrode of the sixth transistor T6 is connected with a fourth node N4. When an on-level signal is applied to the light emitting control line EML, the fifth transistor T5 and the sixth transistor T6 enable the light emitting device to emit light by forming a driving current transfer path between the first power supply line VDD and the second power supply line VSS.

In some examples, a gate of the seventh transistor T7 is connected with the third scan line GL3, a first electrode of the seventh transistor T7 is connected with the second initial signal line INIT2, and a second electrode of the seventh transistor T7 is connected with the fourth node N4. When an on-level signal is applied to the third scan line GL3, the seventh transistor T7 transmits a second initial signal supplied by the second initial signal line INIT2 to a first electrode of the light emitting element EL, so as to initialize a charge amount accumulated in the first electrode of the light emitting element or release a charge amount accumulated in the first electrode of the light emitting device.

In some examples, a second electrode of the light emitting element EL is connected with the second power supply line VSS. The first scan line GL1 is a scan line in a pixel circuit in the present display row, and the second scan line GL2 is a scan line in a pixel circuit in a previous display row, that is, for an nth display row, the first scan line GL1 is GL1(n), the second scan line GL2 is GL1(n-1), the second scan line GL2 in the present display row and the first scan line GL1 in the pixel circuit in the previous display row may be a same signal line, so as to reduce signal lines of the display panel and achieve a narrow border of the display panel.

In some examples, as shown in FIG. 2, the first node N1 may be a connection point of the second electrode of the first transistor T1, the second electrode of the second transistor T2, the gate of the third transistor T3, and the first electrode of the storage capacitor Cst. The second node N2 may be a connection point of the second electrode of the fifth transistor T5, the second electrode of the fourth transistor T4, and the first electrode of a third transistor T3. The third node N3 may be a connection point of the second electrode of the third transistor T3, the first electrode of the second transistor T2, and the first electrode of the sixth transistor T6. The fourth node N4 may be a connection point of the second electrode of the sixth transistor T6, the second electrode of the seventh transistor T7, and the first electrode of the light emitting element EL.

A working process of the pixel circuit is described below. The description is given by taking a case in which multiple transistors included in the pixel circuit shown in FIG. 15 are all P-type transistors as an example. In this example, the third scan signal provided by the third scan line GL3 may be the same as the first scan signal provided by the first scan line GL1.

In some examples, during one-frame display time period, the operating process of the pixel circuit may include a first stage, a second stage, and a third stage.

The first stage is referred to as a reset stage. The second scan signal SCAN2 provided by the second scan signal line GL2 may be a low-level signal, so that the first transistor T1 is turned on, and the first initial signal provided by the first initial signal line INIT1 is provided to the first node N1 to initialize the first node N1 and clear an original data voltage in the storage capacitor Cst. The first scan signal SCAN1 provided by the first scan line GL1 may be a high-level signal, and the light emitting control signal EM provided by the light emitting control line EML may be a high-level signal, so that the fourth transistor T4, the second transistor T2, the fifth transistor T5, the sixth transistor T6 and the seventh transistor T7 are turned off. In this stage, the light emitting element EL does not emit light.

The second stage is referred to as a data writing stage or a threshold compensation stage. The first scan signal SCAN1 provided by the first scan line GL1 may be a low-level signal, the second scan signal SCAN2 provided by the second scan line GL2 and the emitting control signal EM provided by the emitting control line EML may be both high-level signals, and the data line DL outputs a data signal DATA. In this stage, since the first plate of the storage capacitor Cst is at a low level, the third transistor T3 is turned on. The first scan signal SCAN1 is the low-level signal, so that the second transistor T2, the fourth transistor T4, and the seventh transistor T7 are turned on. The second transistor T2 and the fourth transistor T4 are turned on, so that a data voltage Vdata output by the data line DL is provided to the first node N1 through the second node N2, the turned-on third transistor T3, the third node N3, and the turned-on second transistor T2, and the storage capacitor Cst is charged with a difference between the data voltage Vdata output by the data line DL and a threshold voltage of the third transistor T3. A voltage of the first plate (i.e., the first node N1) of the storage capacitor Cst is Vdata-|Vth|, wherein Vdata is the data voltage output by the data line DL, and Vth is the threshold voltage of the third transistor T3. The seventh transistor T7 is turned on, so that a second initial signal provided by the second initial signal line INIT2 is provided to the anode of the light emitting element EL to initialize (reset) the anode of the light emitting element EL and clear a pre-stored voltage therein, so as to complete initialization, thereby ensuring that the light emitting element EL does not emit light. The second scan signal SCAN2 provided by the second scan line GL2 may be a high-level signal, so that the first transistor T1 is turned off. The light emitting control signal EM provided by the light emitting control signal line EML is a high-level signal, so that the fifth transistor T5 and the sixth transistor T6 are turned off.

The third stage is referred to as a light emitting stage. The light emitting control signal EM provided by the light emitting control line EML is a low-level signal, and the first scan signal SCAN1 provided by the first scan line GL1 and the second scan signal SCAN2 provided by the second scan line GL2 are high-level signals. The light emitting control signal EM provided by the light emitting control line EML is a low-level signal, so that the fifth transistor T5 and the sixth transistor T6 are turned on, and the first voltage signal output from the first power supply line VDD provides a drive voltage to the anode of the light emitting device EL through the turned-on fifth transistor T5, third transistor T3 and sixth transistor T6 to drive the light emitting element EL to emit light.

In a drive process of the pixel circuit, a drive current flowing through the third transistor T3 is determined by a voltage difference between the gate and the first electrode of the third transistor T3. Since a voltage of the first node N1 is Vdata-|Vth|, the drive current of the third transistor T3 is as follows.

$$I = K \times (Vgs\text{-}Vth)^2 = K \times [(Vdd\text{-}Vdata\text{+}|Vth|)\text{-}Vth]^2 = K \times [Vdd\text{-}Vdata]^2.$$

Herein I is the drive current flowing through the third transistor T3 (i.e., a drive current for driving the light emitting element EL), K is a constant, Vgs is the voltage difference between the gate and the first electrode of the third transistor T3, Vth is the threshold voltage of the third transistor T3, Vdata is the data voltage output by the data line DL, and Vdd is the first voltage signal output by the first power supply line VDD.

It may be seen from the above formula that a current flowing through the light emitting element EL is independent of the threshold voltage of the third transistor T3. Therefore, the pixel circuit according to this embodiment may better compensate the threshold voltage of the third transistor T3.

A film layer structure of the display substrate will be described below through an example of a preparation process of the display substrate. A "patterning process" mentioned in the present disclosure includes photoresist coating, mask exposure, development, etching, photoresist stripping, and the like for a metal material, an inorganic material, or a transparent conductive material, and includes organic material coating, mask exposure, development, and the like for an organic material. Deposition may be any one or more of sputtering, evaporation, and chemical vapor deposition, coating may be any one or more of spray coating, spin coating, and inkjet printing, and etching may be any one or more of dry etching and wet etching, the present disclosure is not limited thereto. A "thin film" refers to a layer of thin film made of a certain material on a base substrate using deposition, coating, or other processes. If the "thin film" does not need to be processed through a patterning process in the entire manufacturing process, the "thin film" may also be called a "layer". If the "thin film" needs to be processed through the patterning process in the entire manufacturing process, the "thin film" is called a "thin film" before the patterning process is performed and is called a "layer" after the patterning process is performed. At least one "pattern" is contained in the "layer" which has been processed through the patterning process.

In some examples, the preparing process of the display substrate may include the following operations. The 7T1C structure shown in FIG. 15 is used as an example of a pixel circuit of a display region. Here, the plurality of pixel circuits in the display region includes a plurality of first region pixel circuits located in a first display region A1 and a plurality of second region pixel circuits located in a second display region A2. The plurality of first region pixel circuits includes a plurality of first pixel circuits, and the plurality of second region pixel circuits includes a plurality of second pixel circuits, a plurality of in-situ pixel circuits, and a plurality of invalid pixel circuits. Hereinafter, the first pixel circuit in the first display region and the second region pixel circuit in the second display region will be described as examples.

In some examples, a first pixel circuit in an island region A13 of the first display region A1 may include: a first transistor 51, a second transistor 52, a third transistor 53, a fourth transistor 54, a fifth transistor 55, a sixth transistor 56, a seventh transistor 57, and a storage capacitor. A second region pixel circuit in the second display region A2 may include a first transistor 61, a second transistor 62, a third transistor 63, a fourth transistor 64, a fifth transistor 65, a sixth transistor 66, a seventh transistor 67, and a storage capacitor.

(1) A base substrate is provided. In some examples, the base substrate may be a rigid substrate or a flexible substrate. For example, the rigid substrate may be made of, but not limited to, one or more of glass and quartz. The flexible substrate may be made of, but not limited to, one or more of polyethylene terephthalate, ethylene terephthalate, polyether ether ketone, polystyrene, polycarbonate, polyarylate, polyarylester, polyimide, polyvinyl chloride, polyethylene, and textile fibers. In some examples, the flexible substrate may include a first flexible material layer, a first inorganic material layer, a second flexible material layer and a second inorganic material layer which are stacked. The first flexible material layer and the second flexible material layer may be made of a material such as polyimide (PI), polyethylene terephthalate (PET), or a polymer soft film on which surface treatment is performed, and materials of the first inorganic material layer and the second inorganic material layer may be silicon nitride (SiNy, y>0) or silicon oxide (SiOx, x>0), etc., which are used to improve resistance to water and oxygen of the base substrate.

(2) A semiconductor layer is formed. In some examples, a buffer thin film and a semiconductor thin film are deposited on the base substrate sequentially, and the semiconductor thin film is patterned through a patterning process to form a buffer layer disposed on the substrate and a semiconductor layer disposed on the buffer layer. In some examples, a material of the semiconductor layer may be amorphous Silicon (a-Si), polycrystalline Silicon (p-Si), hexathiophene or polythiophene, or another material.

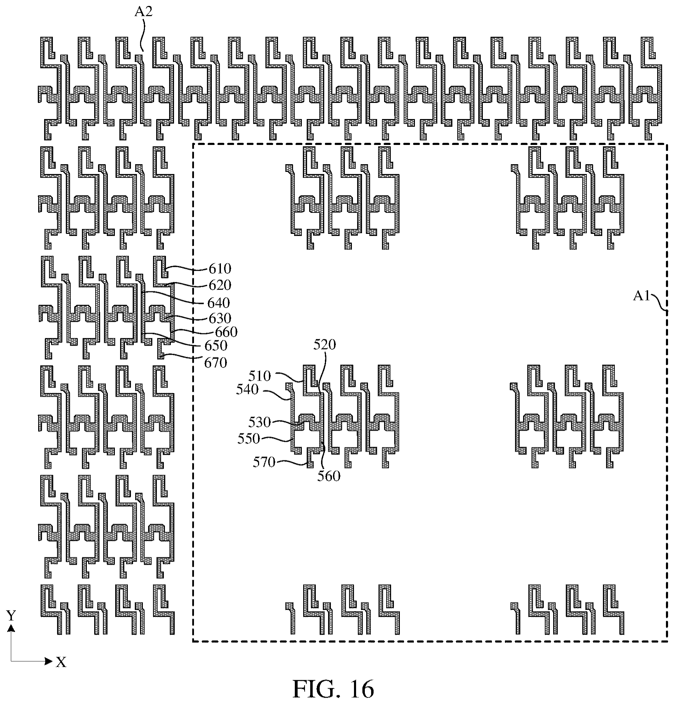

FIG. 16 is a partial schematic diagram of a semiconductor layer of a display region according to at least one embodiment of the present disclosure. FIG. 16 shows a partial junction region between a first display region A1 and a second display region A2. In some examples, as shown in FIG. 16, a semiconductor layer of a display region may at least include: active layers of a plurality of transistors of a plurality of first pixel circuits located in an island region (for example, each island region is provided with three first pixel circuits) of the first display region A1(e.g., including: an active layer 510 of a first transistor, an active layer 520 of a second transistor, an active layer 530 of a third transistor, an active layer 540 of a fourth transistor, an active layer 550 of a fifth transistor, an active layer 560 of a sixth transistor, and an active layer 570 of a seventh transistor, of the first pixel circuit), and active layers of a plurality of transistors of a plurality of second region pixel circuits located in the second display region (e.g., including: an active layer 610 of a first transistor, an active layer 620 of a second transistor, an active layer 630 of a third transistor, an active layer 640 of a fourth transistor, an active layer 650 of a fifth transistor, an active layer 660 of a sixth transistor, and an active layer 670 of a seventh transistor, of the second region pixel circuit).

In some examples, active layers of first to seventh transistors of each first pixel circuit may be connected with each other to form an integral structure. Active layers of first to seventh transistors of each third pixel circuit may be connected with each other to form an integral structure.

In some examples, an active layer of each transistor may include: a first region, a second region, and a channel region located between the first region and the second region. A material of the semiconductor layer may include polysilicon, for example. The channel region may be not doped with impurities, and has characteristics of a semiconductor. The first region and the second region may be doped regions on both sides of the channel region, and are doped with impurities, and thus have conductivity. The impurities may be different according to a type of a transistor. In some examples, a doped region of the active layer may be interpreted as a source or a drain of a transistor. A part of active layers between transistors may be interpreted as a wiring doped with impurities, and may be used for electrically connecting the transistors. The present embodiment is not limited thereto.

(3) A first conductive layer is formed. In some examples, a first gate insulation thin film and a first conductive thin film are sequentially deposited on the base substrate on which the aforementioned patterns are formed, and the first conductive thin film is patterned through a patterning process to form a first gate insulation layer disposed on the semiconductor layer and a first conductive layer disposed on the first gate insulation layer.

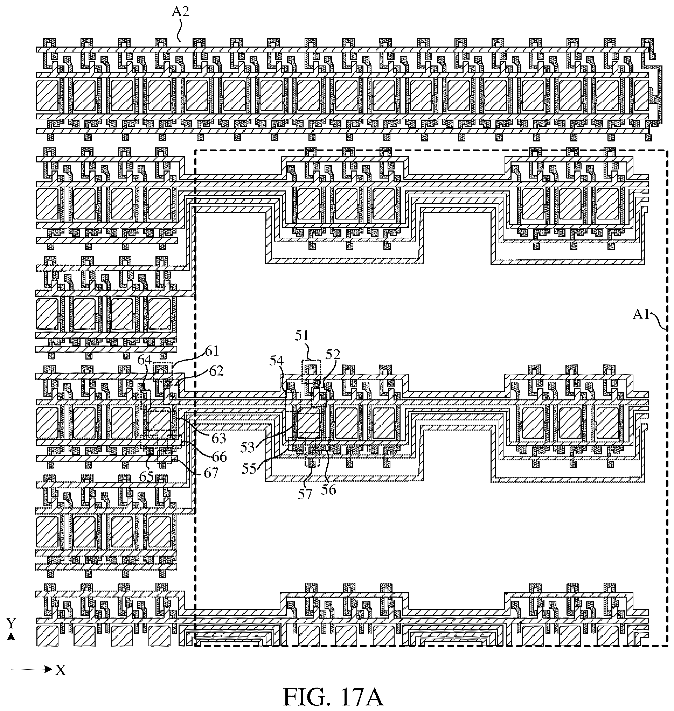

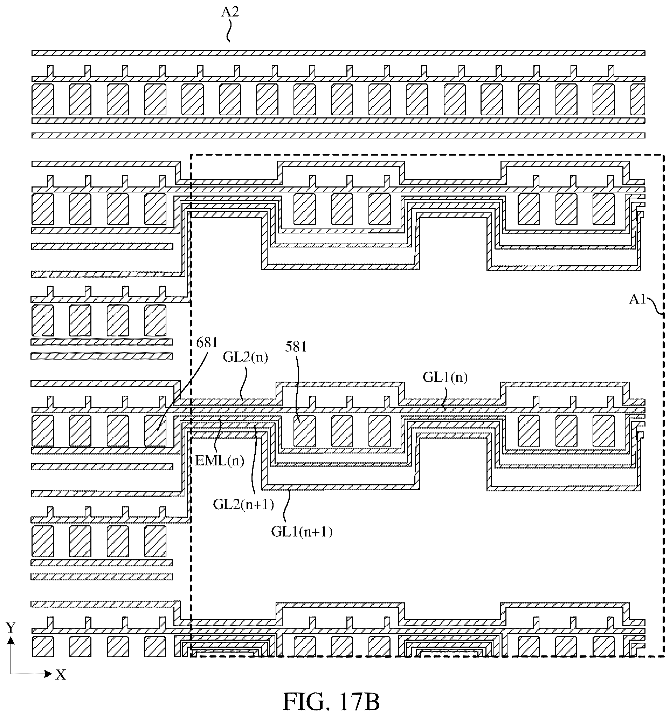

FIG. 17A is a partial schematic diagram of a display region after a first conductive layer is formed, according to at least one embodiment of the present disclosure. FIG. 17B is a schematic diagram of the first conductive layer in FIG. 17A. In some examples, as shown in FIGs. 17A and 17B, the first conductive layer of the display region may include, at least, a plurality of first scan lines (e.g., including first scan lines GL1 (n) and GL1 (n+1)), a plurality of second scan lines (e.g., including second scan lines GL2 (n) and GL2 (n+1)), a plurality of light emitting control lines (e.g., including light emitting control lines EML (n)), a first plate 581 of the storage capacitor of the first pixel circuit, and a first plate 681 of the storage capacitor of the second region pixel circuit.

In some examples, the first plate 581 of the storage capacitor of the first pixel circuit may also serve as a gate of a third transistor 53. The first plate 681 of the storage capacitor of the second region pixel circuit may also serve as a gate of a third transistor 63.

In some examples, two rows of second region pixel circuits in the second display region may correspond to one row of first pixel circuits in the first display region A1. The first scan line GL1 (n), the second scan line GL2 (n), and the light emitting control line EML (n) may be connected to a second region pixel circuit in an n-th row. The first scan line GL1 (n), the light emitting control line EML (n), and the first scan line GL1 (n+1) may be connected with a first pixel circuit in an n-th row, and the second scan line GL2 (n+1) may be configured to connect with a seventh transistor of the first pixel circuit in the n-th row. The first scan line GL1 (n+1) is connected with a second region pixel circuit in an (n+1)-th row, and bypasses the first pixel circuit in the n-th row on a side of the first pixel circuit in the n-th row in a direction opposite to a second direction Y.

In some examples, a shape of the second scan line GL2(n) may be substantially a polyline extending along a first direction X. A region where the second scan line GL2 (n) is overlapped with the active layer 610 of the first transistor 61 of the second region pixel circuit in the n-th row may act as a gate of the first transistor 61. A region where the second scan line GL2 (n) is overlapped with the active layer 510 of the first transistor 51 of the first pixel circuit in the n-th row may act as a gate of the first transistor 51.

In some examples, a shape of the first scan line GL1 (n) may be approximately a straight line extending along the first direction X. A region where the first scan line GL1 (n) is overlapped with the active layer 620 of the second transistor 62 of the second region pixel circuit in the n-th row may act as a gate of the second transistor 62, and a region where the first scan line GL1 (n) is overlapped with the active layer 640 of the fourth transistor 64 may act as a gate of the fourth transistor 64. A region where the first scan line GL1 (n) is overlapped with the active layer 520 of the second transistor 52 of the first pixel circuit in the n-th row may act as a gate of the second transistor 52, and a region where the first scan line GL1 (n) is overlapped with the active layer 540 of the fourth transistor 54 may serve as a gate of the fourth transistor 54.

In some examples, a shape of the light emitting control line EML(n) may be substantially a polyline extending along the first direction X. A region where the light emitting control line EML(n) is overlapped with the active layer 650 of the fifth transistor 65 of the second region pixel circuit in the n-th row may act as a gate of the fifth transistor 65, and a region where the light emitting control line EML(n) is overlapped with the active layer 660 of the sixth transistor 66 may act as a gate of the sixth transistor 66. A region where the light emitting control line EML(n) is overlapped with the active layer 550 of the fifth transistor 55 of the first pixel circuit in the n-th row may act as a gate of the fifth transistor 55, and a region where the light emitting control line EML(n) is overlapped with an active layer 560 of the sixth transistor 56 may serve as a gate of the sixth transistor 56.

In some examples, a shape of the second scan line GL2(n+1) may be substantially a polyline extending along the first direction X. A region where the second scan line GL2(n+1) is overlapped with the active layer 570 of the seventh transistor 57 of the first pixel circuit in the n-th row may act as a gate of the seventh transistor 57.

In some examples, after a pattern of the first conductive layer is formed, the first conductive layer may be used as a shield to perform a conductive processing on the semiconductor layer. The semiconductor layer in a region, which is shielded by the first conductive layer, forms a channel region of a transistor, and the semiconductor layer in a region, which is not shielded by the first conductive layer, may be made to be conductive, that is, both a first region and a second region of an active layer may be made to be conductive.

(4) A second conductive layer is formed. In some examples, a second gate insulation thin film and a second conductive thin film are sequentially deposited on the substrate on which the aforementioned patterns are formed, and the second conductive thin film is patterned through a patterning process to form a second gate insulation layer disposed on the first conductive layer and a second conductive layer disposed on the second gate insulation layer.

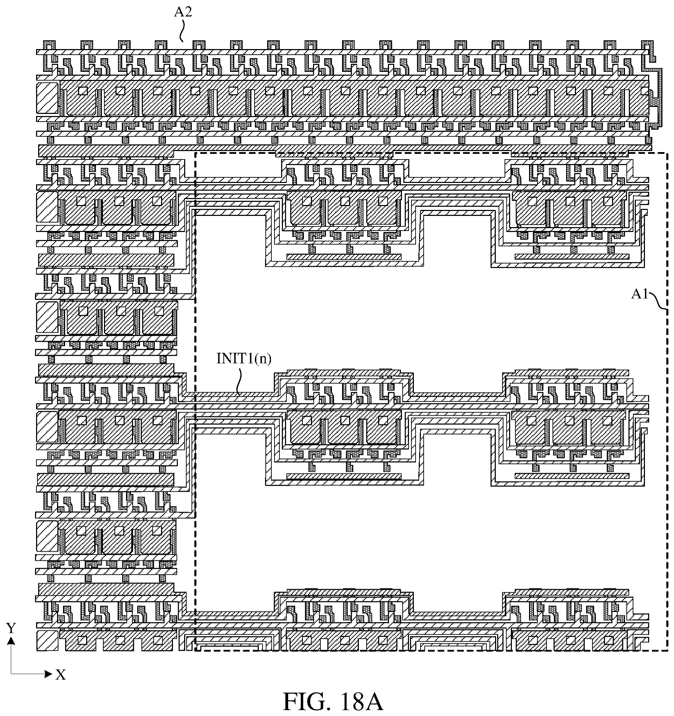

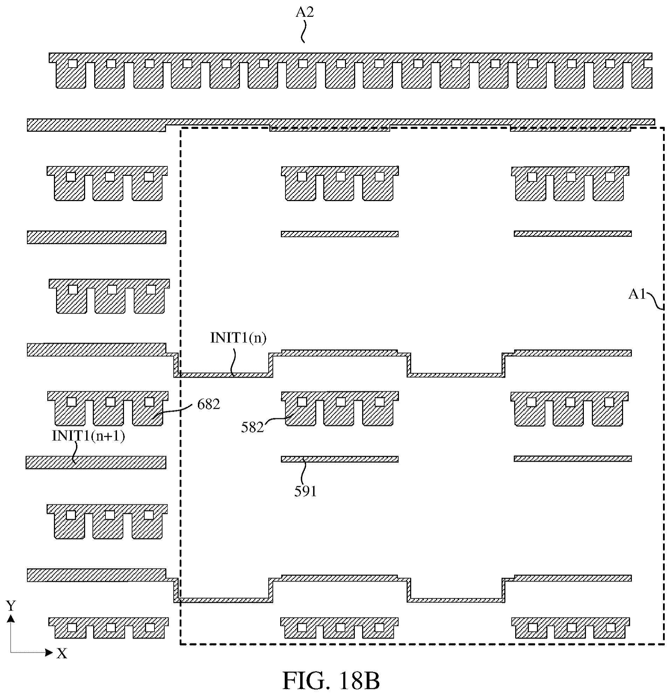

FIG. 18A is a partial schematic diagram of a display region after a second conductive layer is formed, according to at least one embodiment of the present disclosure. FIG. 18B is a schematic diagram of the second conductive layer in FIG. 18A. In some examples, as shown in FIGs. 18A and 18B, the second conductive layer of the display region may include, at least, a plurality of first initial signal lines (including, for example, first initial signal lines INIT1 (n), INIT1 (n+1)), a first initial connection section 591, a second plate 582 of the storage capacitor of the first pixel circuit, and a second plate 682 of the storage capacitor of the second region pixel circuit.

In some examples, an orthographic projection of the second plate 582 of the storage capacitor of the first pixel circuit on the base substrate is overlapped with an orthographic projection of the first capacitor plate 581 on the base substrate. Second plates 582 of storage capacitors of three first pixel circuits in one island region may be connected to each other to form an integral structure.

In some examples, an orthographic projection of the second plate 682 of the storage capacitor of the second region pixel circuit on the base substrate is overlapped with an orthographic projection of the first plate 681 on the base substrate. Second plates 682 of storage capacitors of a plurality of second region pixel circuits in a same row may be connected to each other to form an integral structure.

In some examples, the first initial connection segment 591 may be located in the island region, and be a strip extending along the first direction X. The first initial connection section 591 may be located on a side of the semiconductor layer of the three first pixel circuits in the island region in a direction opposite to the second direction.

In some examples, a shape of the first initial signal line INIT1(n) may be substantially a polyline extending along the first direction X. The first initial signal line INIT1(n) may extend from the second display region to the first display region A1, and the first initial signal line INIT1(n+1) does not extend to the first display region A1. The first initial signal line in this example may be configured to provide an initial signal to the first transistor and the seventh transistor.

(5) A third conductive layer is formed. In some examples, an interlayer insulation thin film is deposited on the base substrate on which the aforementioned patterns are formed, and the interlayer insulation thin film is patterned through a patterning process to form an interlayer insulation layer. The interlayer insulation layer of the display region may be provided with a plurality of vias that may expose, for example, a part of a surface of the semiconductor layer, a part of a surface of the first conductive layer, and a part of a surface of the second conductive layer. Subsequently, a third conductive thin film is deposited on the base substrate on which the aforementioned patterns are formed, and the third conductive thin film is patterned through a patterning process to form a third conductive layer disposed on the interlayer insulation layer.

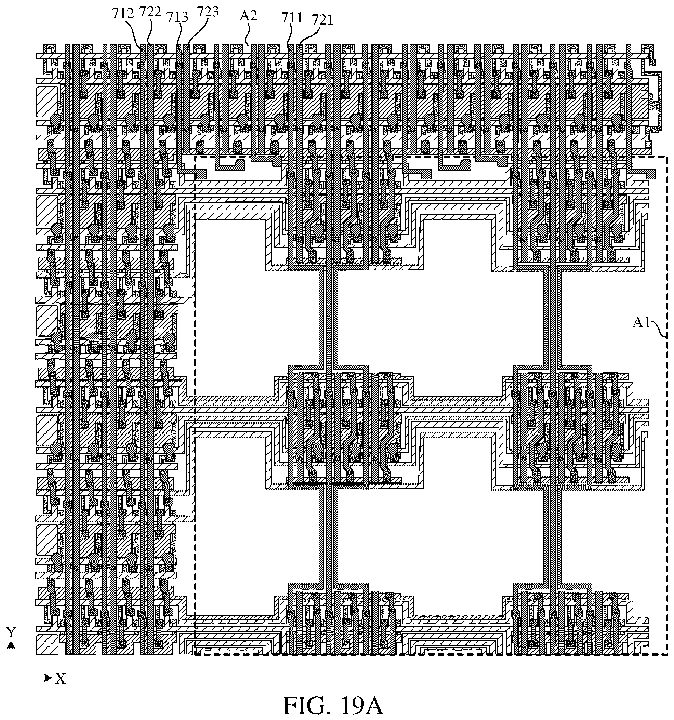

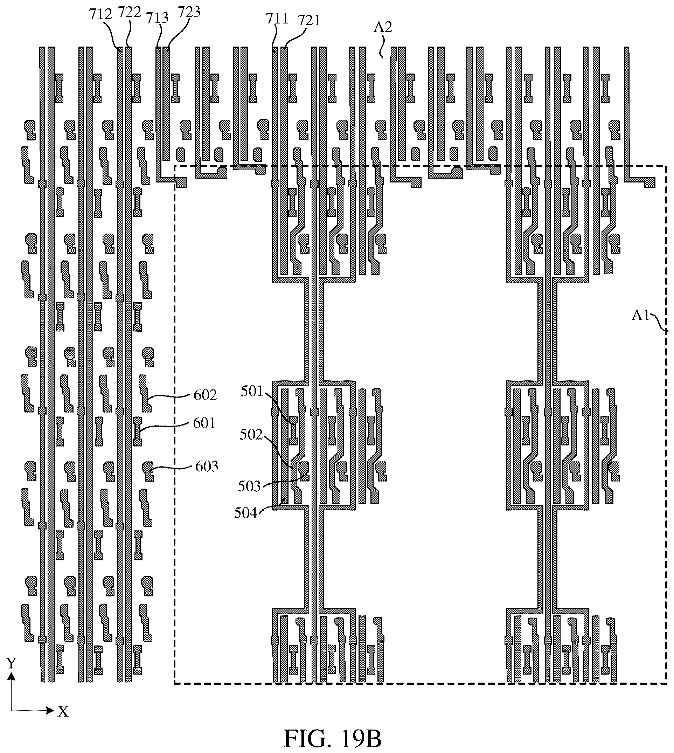

FIG. 19A is a partial schematic diagram of a display region after a third conductive layer is formed, according to at least one embodiment of the present disclosure. FIG. 19B is a schematic diagram of the third conductive layer in FIG. 19A. In some examples, as shown in FIGs. 19A and 19B, the third conductive layer of the display region may include, at least, a plurality of data lines (including, for example, data lines 711, 712, and 713), a plurality of first power supply lines (including, for example, first power supply lines 721, 722, and 723), and a plurality of connection electrodes (including, for example, a first connection electrode 501, a second connection electrode 502, a third connection electrode 503, a fourth connection electrode 504, a fifth connection electrode 601, a sixth connection electrode 602, and a seventh connection electrode 603).

In some examples, the first connection electrode 501, the second connection electrode 502, the third connection electrode 503, and the fourth connection electrode 504 may be located in the island region. The first connection electrode 501 may be connected with the active layer 520 of the second transistor 52 of the first pixel circuit, and may also be connected with the gate of the third transistor 53. The first connection electrode 501 may act as a first node of the first pixel circuit. The second connection electrode 502 may be connected with the first initial signal line INIT1 (n), may be also connected with the active layer 510 of the first transistor 51, may be also connected with the active layer 570 of the seventh transistor 57, and may be also connected with the first initial connection section 591. The second connection electrode 502 may achieve electrical connections of the first initial signal line with the first transistor 51 and the seventh transistor 57. The third connection electrode 503 may be connected with the active layer 560 of the sixth transistor 56. The fourth connection electrode 504 may be connected with the active layer 550 of the fifth transistor 55.

In some examples, the fifth connection electrode 601, the sixth connection electrode 602, and the seventh connection electrode 603 may be located in the second display region. The fifth connection electrode 601 may be connected with the active layer 620 of the second transistor 62 of the second region pixel circuit, and may be also connected with the gate of the third transistor 63. The sixth connection electrode 602 may be connected with the first initial signal line INIT1 (n), the active layer 610 of the first transistor 61 of the second region pixel circuit in the n-th row, and the active layer 670 of the seventh transistor 67 of the second region pixel circuit in the (n-1)-th row. The seventh connection electrode 603 may be connected with the active layer 660 of the sixth transistor 66 of the second region pixel circuit.

In some examples, in the second direction Y, six columns of second region pixel circuits may correspond to three columns of first pixel circuits. The data line 711 may extend from the second display region to the first display region A1, and is connected with the active layer 540 of the fourth transistor 54 of the first pixel circuit in the island region. The data line 711 may be substantially in a shape of a polyline or straight line extending along the second direction Y. The data line 712 may be located in the second display region and may be connected with the active layers 640 of the fourth transistors 64 of the plurality of second region pixel circuits arranged along the second direction Y. The data line 713 may be located in the second display region, and may be connected with a data transfer line on the fourth conductive layer at a junction region between the second display region and the first display region A1. In the first direction X, three data lines 713 and three data lines 711 may be arranged alternately in turn. The three data lines 713 may be bypassed from a side of the first pixel circuit by the data transfer line, and the three data lines 711 may be connected with the three first pixel circuits in the island region respectively, so as to achieve transmission of data signals.

In some examples, the first power supply line 721 may extend from the second display region to an island region in an adjacent first display region A1, and be connected with the active layer 550 of the fifth transistor 55 of the first pixel circuit in the island region to achieve transmission of the first voltage signal. The first power supply lines 722 and 723 may be located in the second display region, and connected with the active layers 650 of the fifth transistors 65 of the plurality of second region pixel circuits arranged in the second direction Y to achieve longitudinal transmission of the first voltage signal in the second display region. In the first direction X, three first power supply lines 723 and three first power supply lines 721 may be arranged alternately in turn.

(6) A fourth conductive layer is formed. In some examples, a passivation insulation thin film is deposited on the substrate on which the aforementioned patterns are formed, and the passivation insulation thin film is patterned through a patterning process to form a passivation layer. The passivation layer may be provided with a plurality of vias which may expose a part of a surface of the third conductive layer. Subsequently, a fourth conductive thin film is deposited on the substrate on which the aforementioned patterns are formed, and the fourth conductive thin film is patterned through a patterning process to form a fourth conductive layer disposed on the passivation layer. In some examples, the fourth conductive layer may also be referred to as a second source-drain metal layer.

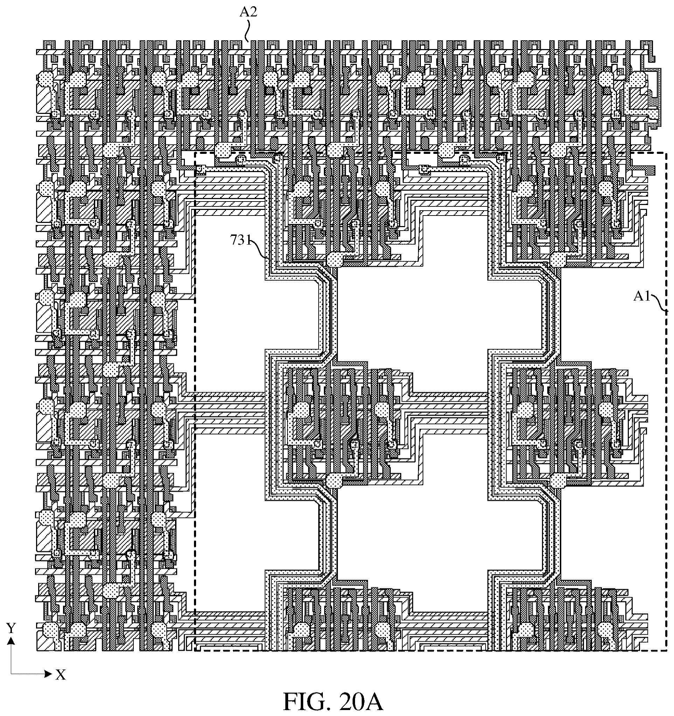

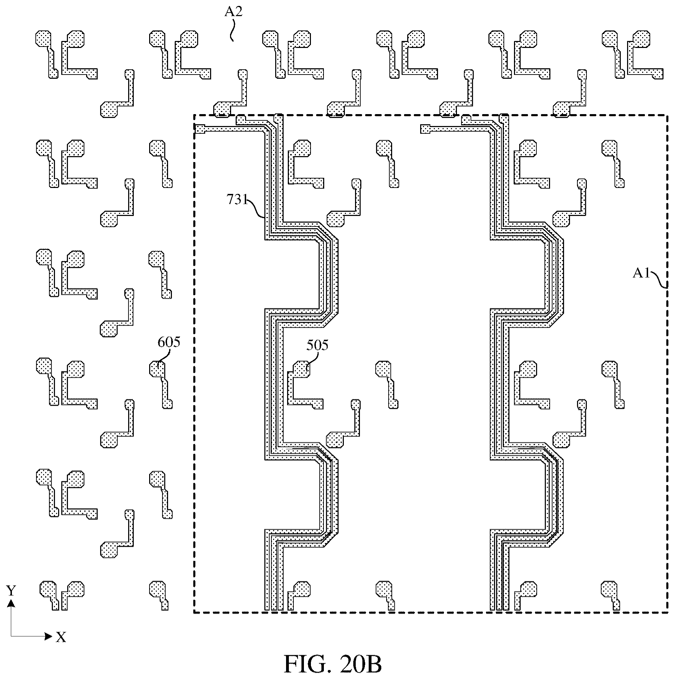

FIG. 20A is a schematic diagram of a partition of a display region after a fourth conductive layer is formed, according to at least one embodiment of the present disclosure. FIG. 20B is a schematic diagram of a fourth conductive layer in FIG. 20A. In some examples, as shown in FIGs. 20A and 20B, the fourth conductive layer of the display region may include, at least, a plurality of connection electrodes (including, for example, an eighth connection electrode 505 and a ninth connection electrode 605), and a plurality of data transfer lines 731.

In some examples, the eighth connection electrode 505 is located in the island region of the first display region A1 and connected with the third connection electrode 503, so as to achieve connection with the sixth transistor of the first pixel circuit. The ninth connection electrode 605 may be located in the second display region and connected with the seventh connection electrode 603, so as to achieve connection with the sixth transistor of the second region pixel circuit.

In some examples, the data transfer lines 731 may be located in the first display region A1. The data transfer line 731 may be substantially in a shape of a polyline extending along the second direction Y. One end of the data transfer line 731 may be connected with an end of the data line 713 in the second display region at an upper side of the first display region A1, and the other end of the data transfer line 731 may be connected with an end of the data line 713 in the second display region at a lower side of the first display region A1, thereby realizing the transmission of data signals within the second display region located at the upper and lower sides of the first display region A1. The three data transfer lines 731 may serve as a group and be located on a side of the three first pixel circuits in a direction opposite to the first direction X.

(7) An anode layer is formed. In some examples, a planarization thin film is coated on the substrate on which the aforementioned patterns are formed, and the planarization thin film is patterned by a patterning process to form a planarization layer. Subsequently, an anode thin film is deposited on the base substrate on which the aforementioned patterns are formed, and the anode thin film is patterned through a patterning process to form an anode layer.

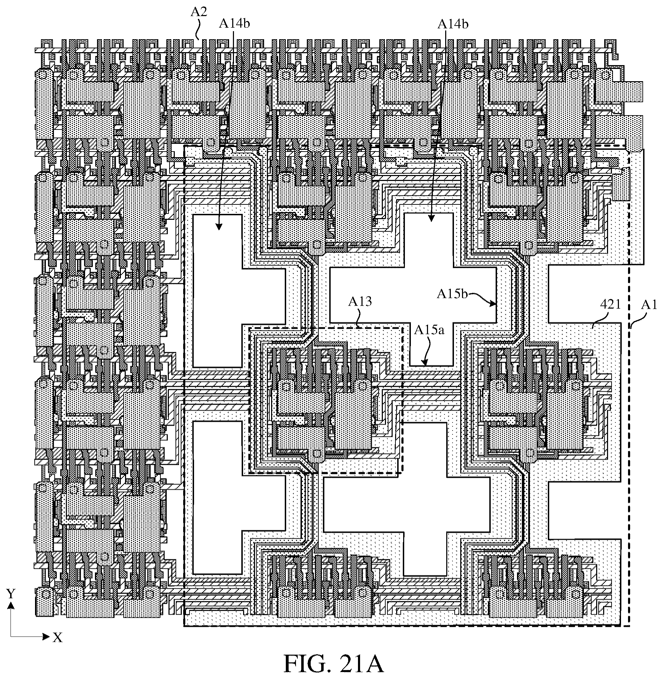

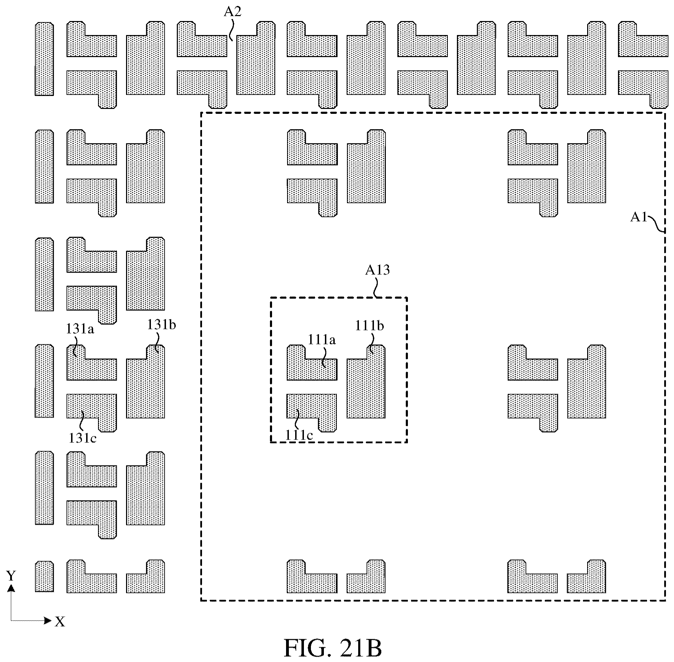

FIG. 21A is a schematic diagram of a partition of a display region after an anode layer is formed, according to at least one embodiment of the present disclosure. FIG. 21B is a schematic diagram of the anode layer in FIG. 21A. In some examples, as shown in FIGS. 21A and 21B, the anode layer may include anodes 111a, 111b, and 111c of the first light emitting element located in the island region A13 of the first display region A1, and anodes 131a, 131b, and 131c of the third light emitting element located in the second display region.

In some examples, the anode 131b of the third light emitting element may be connected through a ninth connection electrode 605, thereby realizing a connection with a sixth transistor of the second region pixel circuit. The anode 111a of the first light emitting element may be connected with an eighth connection electrode 505, thereby realizing an electrical connection with a sixth transistor of the first pixel circuit.

In some examples, the anode layer may include a first sub-conductive layer, a second sub-conductive layer, and a third sub-conductive layer which are stacked. Materials of the first sub-conductive layer and the third sub-conductive layer may be the same. For example, a transparent conductive material may be used, such as Indium Tin Oxide (ITO). The second sub-conductive layer may be made of a metal material, including silver (Ag), for example. For example, the first conductive connection line may have the same layer structure as a first sub-conductive layer of the anode layer to realize an electrical connection between the second pixel circuit and the second light emitting element. However, the present embodiment is not limited thereto.

Subsequently, a pixel definition layer, an organic light emitting layer, a cathode layer and an encapsulation layer are formed sequentially. In some examples, a plurality of pixel openings are formed in the pixel definition layer, and organic light emitting layers may be formed within the plurality of pixel openings, respectively. The organic light emitting layers are connected with corresponding anodes, and the cathode layer may be connected with the organic light emitting layer. In some examples, the cathode layer of the first display region may adopt a patterned design, wherein the cathode layer of the second transmissive region A14b and the cathode layer of the first transmissive region in a region other than the region of second light emitting element may be removed to increase the light transmittance of the first display region.

In some examples, as shown in FIG. 21A, the display substrate may include a first shielding layer 421 located in the first display region A1. An orthographic projection of the first shielding layer 421 on the base substrate may cover orthographic projections of the island region A13 and the inter-island connection region (including the first inter-island connection region A15a and the second inter-island connection region A15b) on the base substrate, and the first shielding layer 421 and the second transmissive region A14b may not be overlapped. A boundary between the island region A13, the first inter-island connection region A15a, and the second inter-island connection region A15b may be defined, for example, by the first shielding layer 421.

In some examples, the first shielding layer, the first conductive layer, the second conductive layer, the third conductive layer and the fourth conductive layer may be made of a metallic material, such as any one or more of Argentum (Ag), Copper (Cu), Aluminum (Al), and Molybdenum (Mo), or an alloy material of the abovementioned metals, such as an Aluminum-Neodymium alloy (AlNd) or a Molybdenum-Niobium alloy (MoNb), and may be of a single-layer structure, or a multilayer composite structure, such as Mo/Cu/MO. The first gate insulation layer, the second gate insulation layer, the interlayer insulation layer and the passivation layer may be made of any one or more of a silicon oxide (SiOx, x > 0), a silicon nitride (SiNy, y > 0) and a silicon oxynitride (SiON), and may be in a single-layer, or a multi-layer, or a composite layer. The planarization layer may be made of an organic material, e.g., polyimide, acrylic, or polyethylene terephthalate. The pixel definition layer may be made of an organic material, such as polyimide, acrylic, or polyethylene terephthalate. However, the present embodiment is not limited thereto.

A structure and a preparation process of the display substrate of the embodiment are merely illustrative. In some examples, a corresponding structure may be changed and a patterning process may be added or reduced according to actual needs. In some other examples, the fourth conductive layer may be omitted, and the data line 713 located in the third conductive layer may extend directly to the first display region to avoid the first pixel circuit by bending the trace. In some other examples, at least one transparent conductive connection layer may be provided between the fourth conductive layer and the anode layer, and the plurality of first conductive connection lines may be located on the same transparent conductive connection layer. Alternatively, the plurality of first conductive connection lines may be arranged on a plurality of different transparent conductive connection layers. In some other examples, a shielding layer may be provided on a side of the semiconductor layer close to the base substrate. The present embodiment is not limited thereto.

The manufacturing process in the exemplary embodiment may be implemented using an existing mature manufacturing device, and may be compatible well with an existing manufacturing process, simple in process implementation, easy to implement, high in a production efficiency, low in a production cost, and high in yield.

In the display substrate provided in the present example, second light emitting elements are disposed in the first transmissive region in a pixel circuit built-out mode, which increases the pixel density of the first display region on the basis of ensuring the light transmittance, thereby realizing high PPI display.

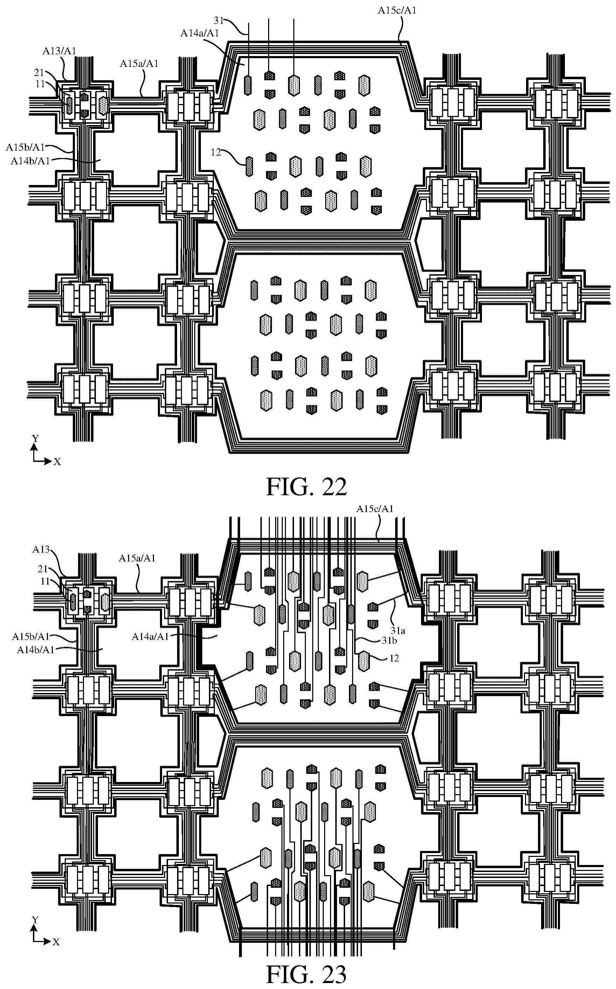

FIG. 22 is another partial schematic diagram of a first display region according to at least one embodiment of the present disclosure. In some examples, as shown in FIG. 22, the first display region A1 may include a plurality of island regions A13 that are disposed independently of each other, a plurality of transmissive regions (for example, including a plurality of first transmissive regions A14a and a plurality of second transmissive regions A14b), and a plurality of inter-island connection regions (for example, including a plurality of first inter-island connection regions A15a, a plurality of second inter-island connection regions A15b, and a plurality of third inter-island connection regions A15c) .

In some examples, the first transmissive region A14a is provided with a plurality of second light emitting elements 12. The plurality of second light emitting elements 12 may be connected with a plurality of second pixel circuits located in a second display region through a plurality of first conductive connection lines 31 extending along a second direction Y. The second transmissive region A14b may not be provided with light emitting element and pixel circuit.

In some examples, the plurality of first transmissive regions A14a may be arranged aligned along the second direction Y, and the first transmissive region Al4a and the second transmissive region A14b may be arranged at intervals along a first direction X. A maximum length of the first transmissive region A14a along the second direction Y may be greater than a maximum length of the second transmissive region A14b along the second direction Y, and a maximum length of the first transmissive region A14a along the first direction X may be greater than a maximum length of the second transmissive region A14b along the first direction X.

In some examples, the third inter-island connection region A15c may be a polyline-shaped region extending along the first direction X. A maximum length of the third inter-island connection region A15c along the second direction Y may be greater than a maximum length of the first inter-island connection region A15a along the second direction Y, and a maximum length of the third inter-island connection region A15c along the first direction X may be greater than a maximum length of the first inter-island connection region A15a along the first direction X. The third inter-island connection region A15c of the present example may be formed by merging traces of two or three adjacent first inter-island connection regions.

In this example, by arranging the traces between islands to be close to each other, the size of the first transmissive region can be increased, which is beneficial to improve a light transmittance of the first display region. Remaining description of the display substrate in this example may be referred to the description in the aforementioned embodiments, which is not repeated here.

FIG. 23 is another partial schematic diagram of a first display region according to at least one embodiment of the present disclosure. In some examples, as shown in FIG. 23, the first display region A1 may include a plurality of island regions A13, a plurality of transmissive regions (e.g., including a plurality of first transmissive regions A14a and a plurality of second transmissive regions A14b), and a plurality of inter-island connection regions (e.g., including a plurality of first inter-island connection regions A15a, a plurality of second inter-island connection regions A15b, and a plurality of third inter-island connection regions A15c).

In some examples, a plurality of first conductive connection lines 31a and 31b connected with the plurality of second light emitting elements 12 in the first transmissive region A14a may extend along a second direction. For example, a second light emitting element 12 close to the third inter-island connection region A15c may be connected with a first conductive connection line 31a.

In some examples, a connection between a second light emitting element 12 and a second pixel circuit may adopt a connection mode of near-to-near and far-to-far. Here, a second pixel circuit connected with a second light emitting element 12 close to a second display region is located at a side of a second pixel circuit connected with a second light emitting element 12 far away from the second display region close to the first display region. In other words, a second pixel circuit connected with a second light emitting element 12 close to a junction between the first display region and the second display region is close to the junction between the first display region and the second display region, and a second pixel circuit connected with a second light emitting element 12 far away from the junction between the first display region and the second display region is far away from the junction between the first display region and the second display region. In some other examples, the connection between the second light emitting element 12 and the second pixel circuit may adopt a connection mode of far-to-near and near-to-far. Here, a second pixel circuit connected with a second light emitting element 12 close to the second display region is located at a side of a second pixel circuit connected with a second light emitting element 12 far away from the second display region far away from the first display region. For example, the first row of second pixel circuits to the nth row of second pixel circuits in the second display region are arranged along a direction away from the junction between the first display region and the second display region, wherein a second pixel circuit connected with the second light emitting element closest to the junction between the first display region and the second display region may be located in the nth row of second pixel circuits, and a second pixel circuit connected with the second light emitting element farthest from the junction between the first display region and the second display region may be located in the first row of second pixel circuits. As a result, the lengths of a plurality of first conductive connection lines connecting a plurality of second light emitting elements and a plurality of second pixel circuits tends to be consistent. The connection mode between the second light emitting element and the second pixel circuit of the present example is similarly applicable to the remaining embodiments.

In some examples, the first conductive connection line 31a may employ a metal material, for example, the first conductive connection line 31a may be located on a shielding layer. An orthographic projection of the first conductive connection line 31a on the base substrate may be overlapped with a portion of the third inter-island connection region A15c extending along a third direction or a fourth direction. The third direction may intersect both the first direction X and the second direction Y, the fourth direction may intersect both the first direction X and the second direction Y, and the third direction may intersect the fourth direction. In some other examples, the first conductive connection line 31a may be located on the remaining conductive layers such as a first conductive layer or a second conductive layer. In some other examples, the first conductive connection line 31a may include a first connection segment in the third inter-island connection region A15c, ans a second connection segment in the transmissive region (e.g., the first transmissive region A14a), wherein the first connection segment is connected with the second connection segment, the first connection segment may be made of a metal material, and the second connection segment may be made of a transparent conductive material.

In some examples, the material of the first conductive connection line 31b may include a transparent conductive material, for example, the first conductive connection line 31b may be located on a first transparent conductive layer or a second transparent conductive layer.

In this example, the plurality of first conductive connection lines employ metal material and transparent conductive material, which can optimize arrangement of the traces and is beneficial to improve the light transmittance of the first display region. Remaining description of the display substrate in this example may be referred to the description in the aforementioned embodiments, which is not repeated here.

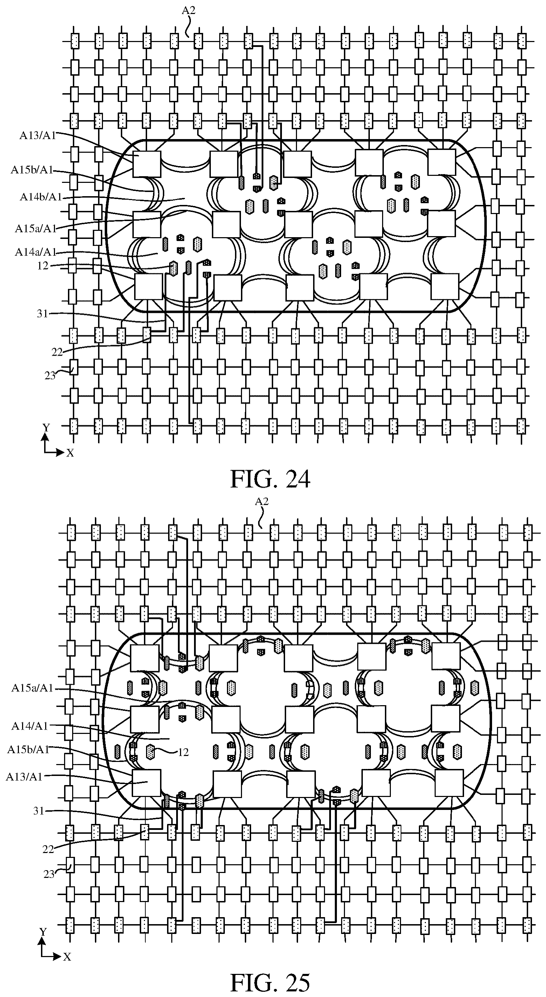

FIG. 24 is another partial schematic diagram of a display region according to at least one embodiment of the present disclosure. In FIG. 24, only several first conductive connection lines 31 between second light emitting elements 12 and second pixel circuits 22 are illustrated as examples. In the following drawings, only some first conductive connection lines are schematically illustrated as examples.

In some examples, as shown in FIG. 24, a first display region A1 may include a plurality of island regions A13 that are disposed independently of each other, a plurality of transmissive regions (e.g., including a plurality of first transmissive regions A14a and a plurality of second transmissive regions A14b), and a plurality of inter-island connection regions (e.g., including a plurality of first inter-island connection regions A15a and a plurality of second inter-island connection regions A15b).

In some examples, the first transmissive region A14a is provided with a plurality of second light emitting elements 12, and the plurality of second light emitting elements 12 may be connected with a plurality of second pixel circuits 22 in a second display region A2 through a plurality of first conductive connection lines 31 extending along a second direction Y. The second transmissive region A14b is not provided with light emitting element or pixel circuit. The first transmissive region A14a or the second transmissive region A14b may be surrounded by four island regions A13, two first inter-island connection regions A15a, and two second inter-island connection regions A15b. The size of the second transmissive region A14b may be smaller than the size of the first transmissive region A14a. For example, a maximum length of the first transmissive region A14a along a first direction X may be greater than a maximum length of the second transmissive region A14b along the first direction X, and a maximum length of the first transmissive region A14a along the second direction Y may be greater than a maximum length of the second transmissive region A14b along the second direction Y.

In some examples, the first transmissive regions A14a and the second transmissive regions A14b may be arranged at intervals along the first direction X and at intervals along the second direction Y. The arrangement of this example may help to improve display uniformity.

In some examples, the first inter-island connection region A15a may be an arc-shaped region extending along the first direction X and be connected with an island regions A13 adjacent along the first direction X. The second inter-island connection region A15b may be an arc-shaped region extending along the second direction Y and be connected with an island region A13 adjacent along the second direction Y. The traces in the first inter-island connection region A15a and the second inter-island connection region A15b may be arc-shaped, so that diffraction can be reduced. In some other examples, the traces within the first inter-island connection region A15a and the second inter-island connection region A15b may be serpentine traces. Remaining description of the display substrate in this example may be referred to the description in the aforementioned embodiments, which is not repeated here.

FIG. 25 is another partial schematic diagram of a display region according to at least one embodiment of the present disclosure. In some examples, as shown in FIG. 25, a first display region A1 may include a plurality of island regions A13 that are disposed independently of each other, a plurality of transmissive regions A14, and a plurality of inter-island connection regions (for example, including a plurality of first inter-island connection regions A15a and a plurality of second inter-island connection regions A15b) .

In some examples, the island region A13 may be provided with a plurality of first pixel circuits and a plurality of first light emitting elements. The inter-island connection region is provided with a plurality of second light emitting elements 12. For example, the plurality of second light emitting elements 12 may be disposed in each of the first inter-island connection region A15a and the second inter-island connection region A15b. The plurality of second light emitting elements 12 may be connected with a plurality of second pixel circuits 22 in a second display region A2 through a plurality of first conductive connection lines 31 extending along a second direction Y. The transmissive region A14 is not provided with light emitting element or pixel circuit. In some other examples, the plurality of second light emitting elements may be disposed in the first inter-island connection region A15a or in the second inter-island connection region A15b.

In this example, the second light emitting element with a built-out pixel circuit is provided in the inter-island connection region to avoid shielding of the transmissive region, and this is beneficial to improve the light transmittance of the first display region. Remaining description of the display substrate in this example may be referred to the description in the aforementioned embodiments, which is not repeated here.

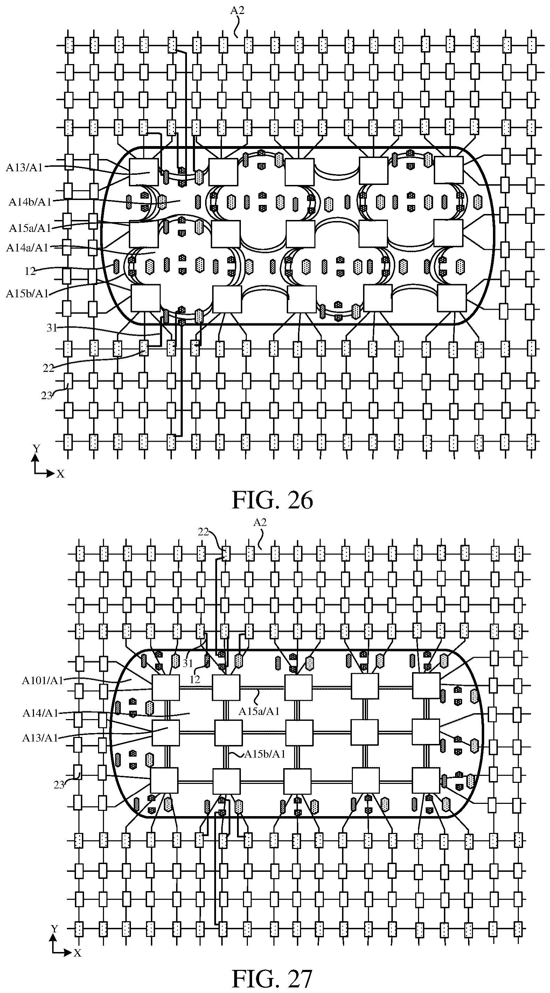

FIG. 26 is another partial schematic diagram of a display region according to at least one embodiment of the present disclosure. In some examples, as shown in FIG. 26, a first display region A1 may include a plurality of island regions A13 that are disposed independently of each other, a plurality of transmissive regions (e.g., including a plurality of first transmissive regions A14a and a plurality of second transmissive regions A14b), and a plurality of inter-island connection regions (e.g., including a plurality of first inter-island connection regions A15a and a plurality of second inter-island connection regions A15b).

In some examples, the island region A13 may be provided with a plurality of first pixel circuits and a plurality of first light emitting elements. The first transmissive region A14a and the inter-island connection region may be provided with a plurality of second light emitting elements 12. The second transmissive region A14b may not be provided with light emitting element and pixel circuit. The plurality of second light emitting elements 12 may be connected with a plurality of second pixel circuits 22 in a second display region A2 through a plurality of first conductive connection lines 31 extending along a second direction Y, and may also be connected with the plurality of second pixel circuits 22 through a plurality of second conductive connection lines (not shown) extending along a first direction X. In the second display region A2, one row of reserved pixel circuits may be arranged every m rows of in-situ pixel circuits 23 along the second direction Y, at least one row of reserved pixel circuits may include a plurality of second pixel circuits 22, and one column of reserved pixel circuits may be arranged every n columns of in-situ pixel circuits along the first direction X, for example, n and m are both 2. In some other examples, all of the transmissive regions within the first display region A1 may be provided with the second light emitting element.

In this example, the plurality of second light emitting elements with built-out pixel circuit are provided in both the inter-island connection region and the first transmissive region to achieve high PPI. Remaining description of the display substrate in this example may be referred to the description in the aforementioned embodiments, which is not repeated here.

FIG. 27 is another partial schematic diagram of a display region according to at least one embodiment of the present disclosure. In some examples, as shown in FIG. 27, a first display region A1 may be in a shape of a track hole extending along a first direction X. The first display region A1 may include a display edge region A101 and a display middle region, wherein the display edge region A101 surrounds the display middle region and is located between the display middle region and a second display region A2. The display middle region may include a plurality of island regions A13 disposed independently of each other, a transmissive region A14 between adjacent island regions, and an inter-island connection region connecting the adjacent island regions (including, for example, a first inter-island connection region A15a extending along the first direction X and a second inter-island connection region A15b extending along a second direction Y).

In some examples, the plurality of island regions A13 are arranged in an array along the first direction X and the second direction Y. The transmissive region A14 is not provided with light emitting element or pixel circuit. The first inter-island connection region A15a may be in a shape of a straight strip extending along the first direction X, and the second inter-island connection region A15b may be in a shape of a straight strip extending along the second direction Y.

In some examples, a plurality of second light emitting elements 12 may be located in the display edge region A101. A second light emitting element 12 in a region of the display edge region A101 extending along the first direction X may be connected with a second pixel circuit 22 in the second display region A2 through a first conductive connection line 31, and a second light emitting element 12 in a region of the display edge region A101 extending along the second direction Y may be connected with a second pixel circuit 22 in the second display region A2 through a second conductive connection line. In the second display region A2, one row of reserved pixel circuits may be arranged every m rows of in-situ pixel circuits 23 along the second direction Y, at least one row of reserved pixel circuits may include a plurality of second pixel circuits 22, and one column of reserved pixel circuits may be arranged every n columns of in-situ pixel circuits along the first direction X, for example, n and m are both 2.

In this example, the second light emitting element with a built-out pixel circuit is disposed in the display edge region, and an electrical connection between the second light emitting element and the second pixel circuit is realized by a combination of the second conductive connection line extending along the first direction with the first conductive connection line extending along the second direction, which may be beneficial to reduce the length of the conductive connection line. Remaining description of the display substrate in this example may be referred to the description in the aforementioned embodiments, which is not repeated here.

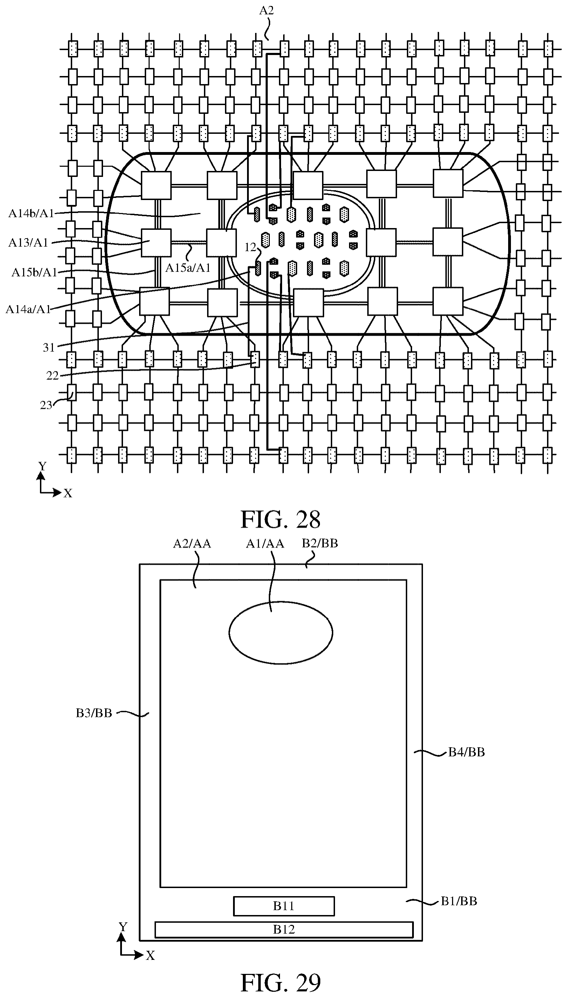

FIG. 28 is another partial schematic diagram of a display region according to at least one embodiment of the present disclosure. In some examples, as shown in FIG. 28, a first display region A1 is in a shape of a track hole extending along a first direction X. The first display region A1 may include a plurality of island regions A13 disposed independently of each other, a transmissive region between adjacent island regions (for example, including one first transmissive region A14a and a plurality of second transmissive regions A14b), and an inter-island connection region connecting adjacent island regions (for example, including a first inter-island connection region A15a extending along the first direction X and a second inter-island connection region A15b extending along a second direction Y).

In some examples, the first transmissive region A14a may be located at a central position of the first display region A1. The first transmissive region A14a is provided with a plurality of second light emitting elements 12. The second transmissive region A14b is not provided with pixel circuit or light emitting element. The size of the first transmissive region A14a may be larger than the size of the second transmissive region A14b. For example, a maximum length of the first transmissive region A14a along the first direction X may be greater than a maximum length of the second transmissive region A14b along the first direction X, and a maximum length of the first transmissive region A14a along the second direction Y may be greater than a maximum length of the second transmissive region A14b along the second direction Y.

In this example, the second light emitting element with a built-out pixel circuit is disposed in the first transmissive region at the center position of the first display region, which can be beneficial to optimize the wiring space. Remaining description of the display substrate in this example may be referred to the description in the aforementioned embodiments, which is not repeated here.

FIG. 29 is another schematic diagram of a display substrate according to at least one embodiment of the present disclosure. In some examples, as shown in FIG. 29, a display region AA may include a first display region A1 and a second display region A2 disposed surrounding the first display region A1. The first display region A1 may have an elliptical shape. A maximum length of the first display region A1 along a first direction X may be greater than a maximum length of the first display region A1 along a second direction Y. As for an arrangement of a plurality of first pixel circuits, a plurality of first light emitting elements, and a plurality of second light emitting elements in the first display region A1, the description of the above-described embodiments can be referred to, and therefore, the description thereof is omitted here.

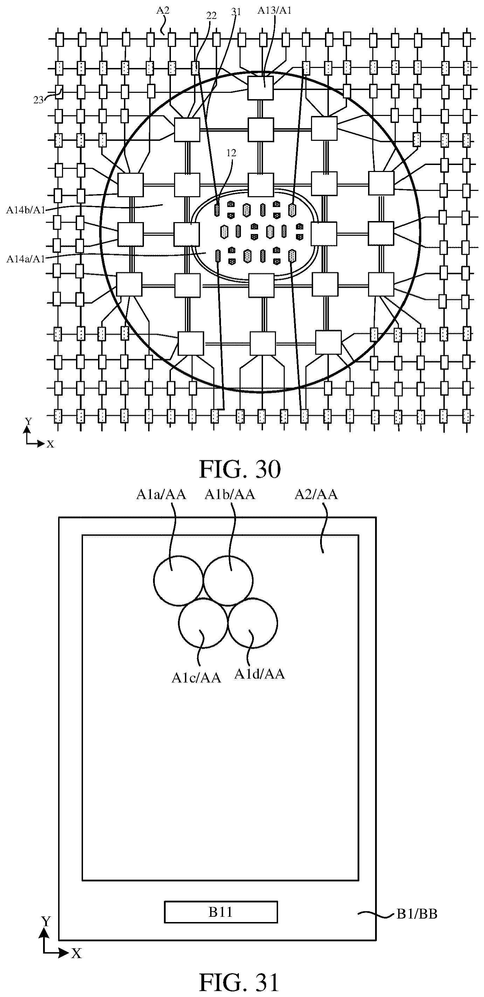

FIG. 30 is another partial schematic diagram of a display region according to at least one embodiment of the present disclosure. In some examples, as shown in FIG. 30, a first display region A1 has a shape of a circular hole, and for example, a maximum length of the first display region A1 along a first direction X and a maximum length of the first display region A1 along a second direction Y may be the same. The first display region A1 may include a plurality of island regions A13 disposed independently of each other, a transmissive region between adjacent island regions (for example, including one first transmissive region A14a and a plurality of second transmissive regions A14b), and an inter-island connection region connecting adjacent island regions (for example, including a first inter-island connection region extending along the first direction X and a second inter-island connection region extending along the second direction Y).

In some examples, the first transmissive region A14a may be located at a central position of the first display region A1. For example, a maximum length of the first transmissive region A14a along the first direction X may be greater than a maximum length of the first transmissive region A14a along the second direction Y. The first transmissive region A14a is provided with a plurality of second light emitting elements 12. The second transmissive region A14b is not provided with pixel circuit or light emitting element. The size of the first transmissive region A14a may be larger than the size of the second transmissive region A14b. For example, a maximum length of the first transmissive region A14a along a first direction X may be greater than a maximum length of the second transmissive region A14b along the first direction X, and a maximum length of the first transmissive region A14a along the second direction Y may be greater than a maximum length of the second transmissive region A14b along the second direction Y.

In some examples, in the second display region A2, one row of reserved pixel circuits may be arranged every m rows of in-situ pixel circuits 23 along the second direction Y, at least one row of reserved pixel circuits may include a plurality of second pixel circuits 22, and one column of reserved pixel circuits may be arranged every n columns of in-situ pixel circuits along the first direction X, for example, n and m may be the same. The plurality of second light emitting elements 12 may be connected with a plurality of second pixel circuits 22 through a plurality of first conductive connection lines 31 extending along the second direction Y and through a plurality of second conductive connection lines (not shown) extending along the first direction X.

In this example, the second light emitting element with a built-out pixel circuit is disposed in the first transmissive region at a center position of the first display region having a shape of a circular hole, which may be beneficial to optimize the wiring space. Remaining description of the display substrate in this example may be referred to the description in the aforementioned embodiments, which is not repeated here.

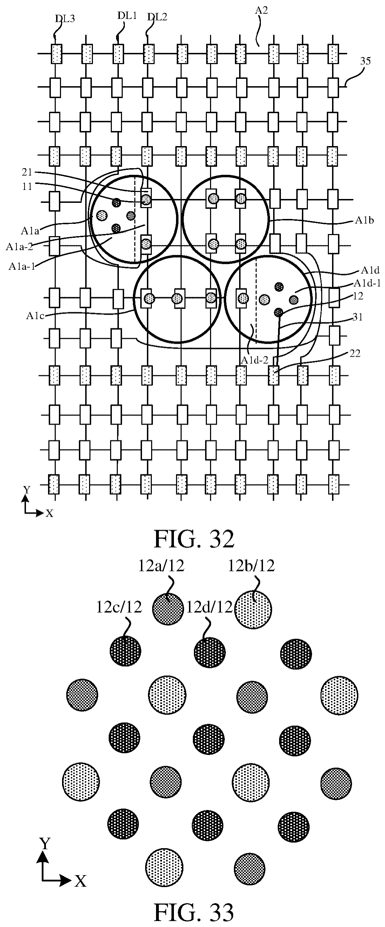

FIG. 31 is another schematic diagram of a display substrate according to at least one embodiment of the present disclosure. FIG. 32 is another partial schematic diagram of a display region according to at least one embodiment of the present disclosure.

In some examples, as illustrated in FIGS. 31 and 32, a display region AA may include four first display regions A1a, A1b, A1c, and A1d, and a second display region A2 disposed surrounding the plurality of first display regions. The first display region A1a, A1b, A1c, and A1d may have the same shape, for example, they may be circular. The four first display regions A1a, A1b, A1c, and A1d may be located in a middle region at top of the display region AA. The four first display regions A1a, A1b, A1c, and A1d may be connected with each other and arranged in two rows, with the two rows of first display regions being arranged along a first direction X in a staggered manner. For example, the first display regions A1a and A1b are arranged to be adjacent and aligned along the first direction X, the first display regions A1c and A1d are arranged to be adjacent and aligned along the first direction X, the first display regions A1a and A1c are arranged along a second direction Y in a staggered manner, and the first display regions A1b and A1d are arranged along the second direction Y in a staggered manner. Center points of the first display regions A1a, A1b, and A1c may be connected to form an equilateral triangle, and center points of the first display regions A1c, A1b, and A1d may be connected to form an equilateral triangle.

In some examples, at least one first display region may be provided with a plurality of first light emitting elements 11, a plurality of first pixel circuits 21, and a plurality of second light emitting elements 12. For example, the first display region A1a may include a first region A1a-1 and a second region A1a-2 arranged along the first direction X, the first region A1a-1 being adjacent to the second display region A2 in the first direction X, and the second region A1a-2 being adjacent to another first display region A1b in the first direction X. The second light emitting element 12 in the first display region A1a may be located at at least one side of the first light emitting element 11 close to the second display region A2. For example, in first display region A1a, the second region A1a-2 may be provided with a plurality of first pixel circuits 21 and a plurality of first light emitting elements 11, and the first region A1a-1 may be provided with a plurality of second light emitting elements 12. And in the first display region A1d, the second region A1d-2 may be provided with a plurality of first pixel circuits 21 and a plurality of first light emitting elements 11, and the first region A1d-1a may be provided with a plurality of second light emitting elements 12. The plurality of second light emitting elements 12 may be connected with a plurality of second pixel circuits 22 in the second display region A2 through a plurality of first conductive connection lines 31 extending along the second direction Y. The first display regions A1b and A1c may be provided with a plurality of first light emitting elements 11 and a plurality of first pixel circuits 21.

In some examples, a second signal line extending along the second direction Y may include a plurality of data lines, and the plurality of data lines may include a plurality of first data lines DL1, a plurality of second data lines DL2, and a plurality of third data lines DL3. The plurality of third data lines DL3 are located in the second display region A2. The plurality of first data lines DL1 are partitioned by one first display region (for example, by the first display region A1a or A1d). The plurality of second data lines DL2 pass through two first display regions, for example, through respective parts of the first display regions A1a and A1c that are aligned along the second direction Y, or through respective parts of the first display regions A1b and A1c that are aligned along the second direction Y, or through respective parts of the first display regions A1b and A1d that are aligned along the second direction Y. The plurality of first data lines DL1 may be arranged by being wound along an edge of the first display region, for example, may be wound along a side of the first display region A1a away from the first display region A1b, or may be wound along a side of the first display region A1d away from the first display region A1c. The plurality of second data lines DL2 may be connected with a plurality of first pixel circuits 21 which are provided in the aligned parts of two first display regions and which are arranged along the second direction Y.

In this example, the plurality of first data lines DL1 bypass the first display region by being wound, therefore trace lengths of the first data lines DL1 increase, and the resistance increases. The plurality of second data lines DL2 pass through the first display region by connecting the first pixel circuits in series, and the resistance is also increased due to the connections between the second data lines DL2 and the plurality of first pixel circuits. This may be beneficial to reduce load differences between the plurality of first data lines and the plurality of second data lines, so that the resistances of different data lines tend to be consistent. Remaining description of the display substrate in this example may be referred to the description in the aforementioned embodiments, which is not repeated here.

FIG. 33 is a schematic diagram of another arrangement of a plurality of second light emitting elements in a second sub-region of a first display region according to at least one embodiment of the present disclosure. In some examples, as shown in FIG. 33, the plurality of second light emitting elements 12 in the first display region may include: a plurality of second light emitting elements 12a emitting light of the first color, a plurality of second light emitting element 12b emitting light of the second color, and a plurality of second light emitting elements 12c and 12d emitting light of the third color. One pixel unit in the second sub-region may include one second light emitting element 12a emitting light of the first color, one second light emitting element 12b emitting light of the second color, and two second light emitting elements 12c and 12d emitting light of the third color. For example, the light of the first color may be red light, the light of the second color may be blue light, and the light of the third color light may be green light.

In some examples, the plurality of second light-emitting elements 12a emitting light of the first color and the plurality of second light emitting elements 12b emitting light of the second color may be arranged at intervals along a first direction X and be arranged at intervals along a second direction Y. The plurality of second light emitting elements 12c and 12d emitting light of the third color may be arranged at intervals along the first direction X and be arranged at intervals along the second direction Y. The second light emitting elements 12a and 12b may be staggered with the second light emitting elements 12c and 12d in the first direction X, and the second light-emitting elements 12a and 12b may be staggered with the second light-emitting elements 12c and 12d in the second direction Y.

In some examples, orthographic projections of light emitting regions of the second light emitting elements 12a, 12b, 12c and 12d on the base substrate may be substantially circular. An area of the light emitting region of a single second light emitting element 12a may be smaller than an area of the light emitting region of a single second light emitting element 12b, and an area of the light emitting region of a single second light emitting element 12c or 12d may be smaller than an area of the light emitting region of a single second light emitting element 12a. An area of the light emitting region of a single second light emitting element 12c and an area of the light emitting region of a single second light-emitting element 12d may be the same.

In this example, as for the arrangement of the plurality of first light emitting elements in the first sub-region and the arrangement of the plurality of third light emitting elements in the second display region, the arrangement of the plurality of second light emitting elements in the second sub-region can be referred to, and thus the detailed description thereof is omitted.

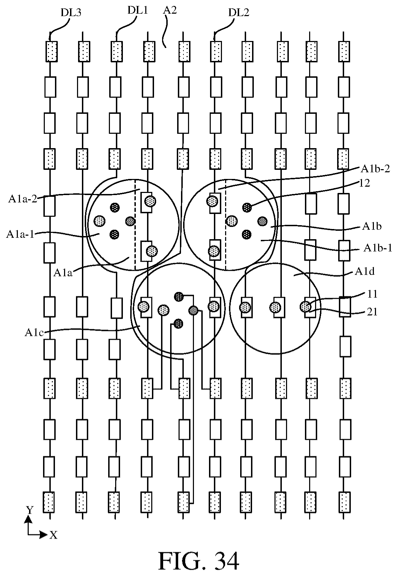

FIG. 34 is another partial schematic diagram of a display region according to at least one embodiment of the present disclosure. In some examples, as illustrated in FIG. 34, the display region AA may include four first display regions A1a, A1b, A1c, and A1d. At least one first display region may be provided with a plurality of first light emitting elements 11, a plurality of first pixel circuits 21, and a plurality of second light emitting elements 12. For example, the first display region A1a may include a first region A1a-1 and a second region A1a-2 arranged along a first direction X, the first region A1a-1 being adjacent to a second display region A2 in the first direction X, and the second region A1a-2 being adjacent to another first display region A1b in the first direction X. For the first display region A1a, the second region A1a-2 may be provided with a plurality of first pixel circuits 21 and a plurality of first light emitting elements 11, and the first region A1a-1 may be provided with a plurality of second light emitting elements 12. For the first display region A1b, the second region A1b-2 may be provided with a plurality of first pixel circuits 21 and a plurality of first light emitting elements 11, and the first region Alb-1 may be provided with a plurality of second light emitting elements 12. For the first display region A1c, a middle region along the first direction X may be provided with a plurality of second light emitting elements 12, and two side regions along the first direction X may be provided with a plurality of first light emitting elements 11 and a plurality of first pixel circuits 21. The first display region A1d may be provided with a plurality of first pixel circuits 21 and a plurality of first light emitting elements 11.

In some examples, the plurality of second light emitting elements 12 may be connected with a plurality of second pixel circuits 22 in the second display region A2 through a plurality of first conductive connection lines 31 extending along a second direction Y.

In some examples, a second signal line extending along the second direction Y may include a plurality of data lines, and the plurality of data lines may include a plurality of first data lines DL1, a plurality of second data lines DL2, and a plurality of third data lines DL3. The plurality of third data lines DL3 are located in the second display region A2. The plurality of first data lines DL1 are partitioned by one first display region (for example, by the first display region A1a, A1b, or A1c). The plurality of second data lines DL2 pass through at least one first display region, for example, through respective parts of the first display regions A1a and A1c that are aligned along the second direction Y, or through respective parts of the first display regions A1b and A1c that are aligned along the second direction Y, or through the first display region A1d. The plurality of first data lines DL1 may be arranged by being wound along an edge of one first display region, for example, may be wound along a side of the first display region A1a away from the first display region A1b, or may be wound along a side of the first display region A1b away from the first display region A1a, or may be wound along a side of the first display region A1c away from the first display region A1d. Here, the first data line DL1 wound along the side of the first display region A1b away from the first display region A1a may be connected with a plurality of first pixel circuits 21 arranged along the second direction Y in the first display region A1d. The plurality of second data lines DL2 may be connected with a plurality of first pixel circuits 21 arranged along the second direction Y in the at least one first display region. For example, the plurality of second data lines DL2 may be connected with a plurality of first pixel circuits 21 in the respective parts of the first display regions A1a and A1c that are aligned along the second direction Y, or may be connected with a plurality of first pixel circuits 21 in the respective parts of the first display regions A1b and A1c that are aligned along the second direction Y, or may be connected with a plurality of first pixel circuits 21 arranged along the second direction Y in the first display region A1d.

In the present example, the plurality of first data lines DL1 bypass the first display region by being wound, or pass through the first display region by a combination of being wound and being connected with the first pixel circuit, and resistance of the first data line DL1 increases. The plurality of second data lines DL2 pass through the first display region by connecting the first pixel circuits in series, and the resistance increases due to the connection of the second data lines DL2 with the plurality of first pixel circuits. This may be beneficial to reduce load differences between the plurality of first data lines and the plurality of second data lines, so that the resistances of different data lines tend to be consistent. Remaining description of the display substrate in this example may be referred to the description in the aforementioned embodiments, which is not repeated here.

In some other examples, each of first display region may be provided with a plurality of first light emitting elements, a plurality of first pixel circuits, and a plurality of second light emitting elements. The arranged positions of the first light emitting element and the second light emitting element in the first display region may be determined according to the shortest winding of the data lines. The present embodiment is not limited thereto.

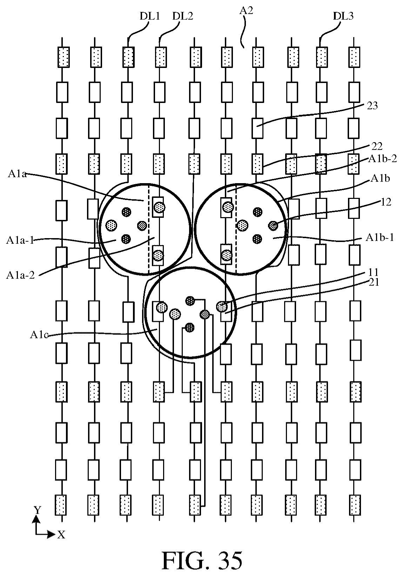

FIG. 35 is another partial schematic diagram of a display region according to at least one embodiment of the present disclosure. In some examples, as illustrated in FIG. 35, the display region may include three first display regions A1a, A1b, and A1c. The first display regions A1a, A1b, and A1c may have the same shape, for example, they may be circular. The three first display regions A1a, A1b, and A1c may be located in a middle region at top of the display region AA. The three first display regions A1a, A1b, and A1c may be connected with each other. For example, the first display regions A1a and A1b are arranged to be adjacent and aligned along a first direction X, and the first display region A1c is located at lower side the first display regions A1a and A1b along a second direction Y, and is staggered with the first display regions A1a and A1b in the second direction Y. Center points of the first display regions A1a, A1b, and A1c may be connected to form an equilateral triangle.

In some examples, each of the three first display regions is provided with a plurality of first light emitting elements 11, a plurality of first pixel circuits 21, and a plurality of second light emitting elements 12. For example, the first display region A1a may include a first region A1a-1 and a second region A1a-2 arranged along the first direction X, the first region A1a-1 being adjacent to the second display region A2 in the first direction X, and the second region A1a-2 being adjacent to another first display region A1b in the first direction X. For the first display region A1a, the second region A1a-2 may be provided with a plurality of first pixel circuits 21 and a plurality of first light emitting elements 11, and the first region A1a-1 may be provided with a plurality of second light emitting elements 12. For the first display region A1b, the second region A1b-2 may be provided with a plurality of first pixel circuits 21 and a plurality of first light emitting elements 11, and the first region A1b-1 may be provided with a plurality of second light emitting elements 12. For the first display region A1c, a middle region along the first direction X may be provided with a plurality of second light emitting elements 12, and two side regions along the first direction X may be provided with a plurality of first light emitting elements and a plurality of first pixel circuits 21.

In some examples, the plurality of second light emitting elements 12 may be connected with a plurality of second pixel circuits 22 in the second display region A2 through a plurality of first conductive connection lines 31 extending along the second direction Y.

In some examples, a second signal line extending along the second direction Y may include a plurality of data lines, and the plurality of data lines may include a plurality of first data lines DL1, a plurality of second data lines DL2, and a plurality of third data lines DL3. The plurality of third data lines DL3 are located in the second display region A2. The plurality of first data lines DL1 are partitioned by one first display region (for example, by the first display region A1a, A1b, or A1c). The plurality of second data lines DL2 pass through two first display regions, for example, through respective parts of the first display regions A1a and A1c that are aligned along the second direction Y, or through respective parts of the first display regions A1b and A1c that are aligned along the second direction Y. The plurality of first data lines DL1 may be arranged by being wound along an edge of one first display region, for example, may be wound along a side of the first display region A1a away from the first display region A1b, or may be wound along a side of the first display region A1b away from the first display region A1a, or may be wound along a side of the first display region A1c. The plurality of second data lines DL2 may be connected with a plurality of first pixel circuits 21 arranged along the second direction Y in two first display regions. For example, the plurality of second data lines DL2 may be connected with a plurality of first pixel circuits 21 in respective parts of the first display regions A1a and A1c that are aligned along the second direction Y, or may be connected with a plurality of first pixel circuits 21 in respective parts of the first display regions A1b and A1c that are aligned along the second direction Y.

In this example, the plurality of first data lines DL1 bypass the first display region by being wound, and the resistance of the first data lines DL1 increase. The plurality of second data lines DL2 pass through the first display region by connecting the first pixel circuits in series, and the resistance is increased due to the connections between the second data lines DL2 and the plurality of first pixel circuits. This may be beneficial to reduce load differences between the plurality of first data lines and the plurality of second data lines, so that the resistances of different data lines tend to be consistent. Remaining description of the display substrate in this example may be referred to the description in the aforementioned embodiments, which is not repeated here.

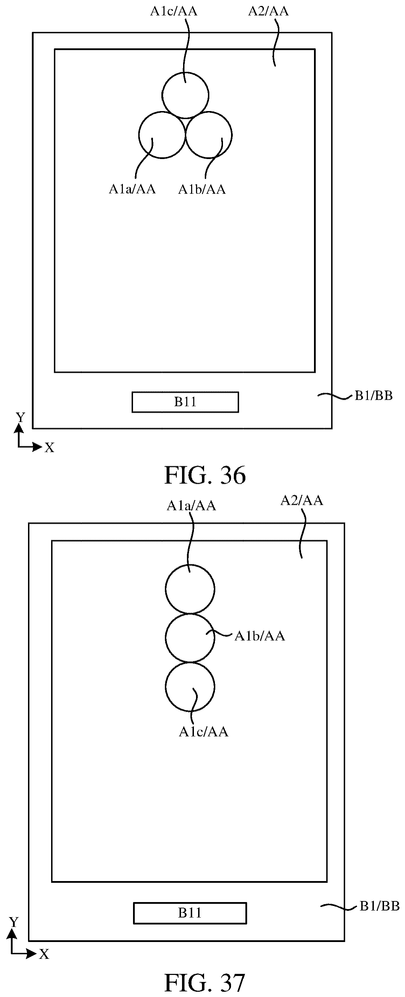

FIG. 36 is another schematic diagram of a display substrate according to at least one embodiment of the present disclosure. In some examples, as illustrated in FIG. 36, a display region may include three first display regions A1a, A1b, and A1c. The first display regions A1a, A1b, and A1c may have the same shape, for example, they may be circular. The three first display regions A1a, A1b, and A1c may be located in a middle region at top of the display region AA. The three first display regions A1a, A1b, and A1c may be connected with each other. For example, the first display regions A1a and A1b are arranged to be adjacent and aligned along a first direction X, and the first display region A1c is located at upper side the first display regions A1a and A1b along the second direction Y, and is staggered with the first display regions A1a and A1b in the second direction Y. Center points of the first display regions A1a, A1b, and A1c may be connected to form an equilateral triangle.

Each of the three first display regions of the present example may be provided therein with a plurality of first light emitting elements, a plurality of first pixel circuits, and a plurality of second light emitting elements. The arrangement of pixel circuits and light emitting elements in the three first display regions can refer to the description of the above-described embodiments, and thus the description thereof will not be repeated here.

FIG. 37 is another schematic diagram of a display substrate according to at least one embodiment of the present disclosure. In some examples, as shown in FIG. 37, a display region AA may include a plurality of first display regions (for example, three first display regions A1a, A1b, and A1c) arranged along a second direction Y. The three first display regions A1a, A1b, and A1c may be aligned along the second direction Y. The three first display regions A1a, A1b, and A1c may have the same shape, for example, all are circular. Each of the first display regions may be provided with a plurality of first light emitting elements, a plurality of first pixel circuits, and a plurality of second light emitting elements. In each first display region, the plurality of second light emitting elements may be located at both sides of the plurality of first light emitting elements in a first direction X to reduce a length of a conductive connection line between a second light emitting element and a second pixel circuit in a second display region, and to reduce a second signal line (including, for example, data lines) extending along the second direction Y which may pass through the first display region by bypassing the first display region or being connected with the first pixel circuit of the first display region in series, so that the increased resistances of the data lines tend to be consistent, thereby reducing the load differences between different data lines. Remaining description of the display substrate in this example may be referred to the description in the aforementioned embodiments, which is not repeated here.

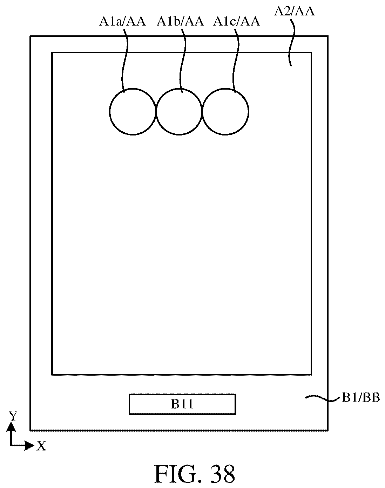

FIG. 38 is another schematic diagram of a display substrate according to at least one embodiment of the present disclosure. In some examples, as shown in FIG. 38, a display region AA may include a plurality of first display regions (e.g., three first display regions A1a, A1b, and A1c) arranged a the first direction X. The three first display regions A1a, A1b, and A1c may be aligned along the first direction X. The three first display regions A1a, A1b, and A1c may have the same shape, for example, all are circular. For example, the first display region A1b may be provided with a plurality of second light emitting elements, and the first display regions A1a and A1c may be provided with a plurality of first light emitting elements and a plurality of first pixel circuits. The plurality of second light emitting elements may be connected with a plurality of second pixel circuits in a second display region through first conductive connection lines extending along a second direction. The arrangement of the present example may reduce a second signal line (including, for example, data lines) extending along the second direction Y which may pass through the first display region by bypassing the first display region or being connected with the first pixel circuit in the first display region in series, so that the increased resistances of the data lines tend to be consistent, thereby reducing the load differences between different data lines. Remaining description of the display substrate in this example may be referred to the description in the aforementioned embodiments, which is not repeated here.

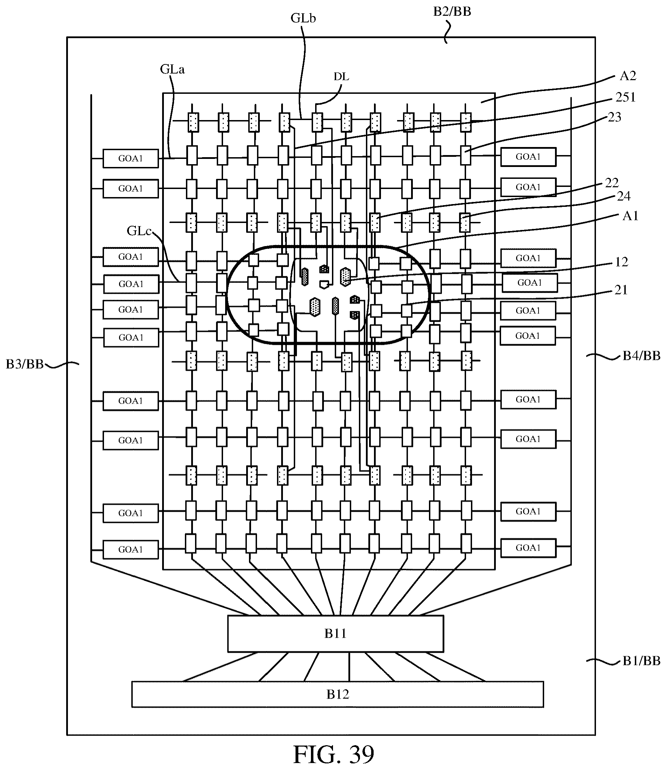

FIG. 39 is a schematic diagram of a display substrate according to at least one embodiment of the present disclosure. In some examples, as illustrated in FIG. 39, a second peripheral region is provided with a gate driving circuit, and for example, the gate driving circuit may include a plurality of first driving units GOA1 located in, for example, a left bezel region B3 and a right bezel region B4. For example, the gate driving circuit may be configured to provide a first scan signal or a second scan signal. One first driving unit GOA1 in the left bezel region B3 and one first driving unit GOA1 in the right bezel region B4 may provide gate signals to a same row of pixel circuits, thereby realizing bilateral driving of the pixel circuits.

In some examples, both ends of a gate line GLa connected with one row of in-situ pixel circuits 23 in the display region are connected with the first driving unit GOA1 in the left bezel region B3 and the first driving circuit GOA1 in the right bezel region B4, respectively. A gate line GLb with which a plurality of second pixel circuits 22 in a row of reserved pixel circuits in the display region are connected is connected with a gate signal transfer line 251. The gate signal transfer line 251 extends along a second direction Y and is connected with a gate line GLc, the gate line Glc being connected with a first pixel circuit 21 connected with a first light emitting element which is located in the same row as the second light emitting element 12 connected with the second pixel circuit 22, so that the first pixel circuit 21 connected with the first light-emitting element and the second pixel circuit connected with the second light emitting element 12 (which is located in the same row as the first light emitting element) receive the same gate signal. A plurality of invalid pixel circuits 24 in a row of reserved pixel circuits may be connected with an invalid gate line, and the invalid gate line may not be connected with the gate line GLb connected with the plurality of second pixel circuits 22 in the row of reserved pixel circuits.

In this example, the gate line connected with the second pixel circuit and the gate line connected with the corresponding first pixel circuit are connected through a gate signal transfer line, and the number of required driving units can be reduced. Remaining description of the display substrate in this example may be referred to the description in the aforementioned embodiments, which is not repeated here.

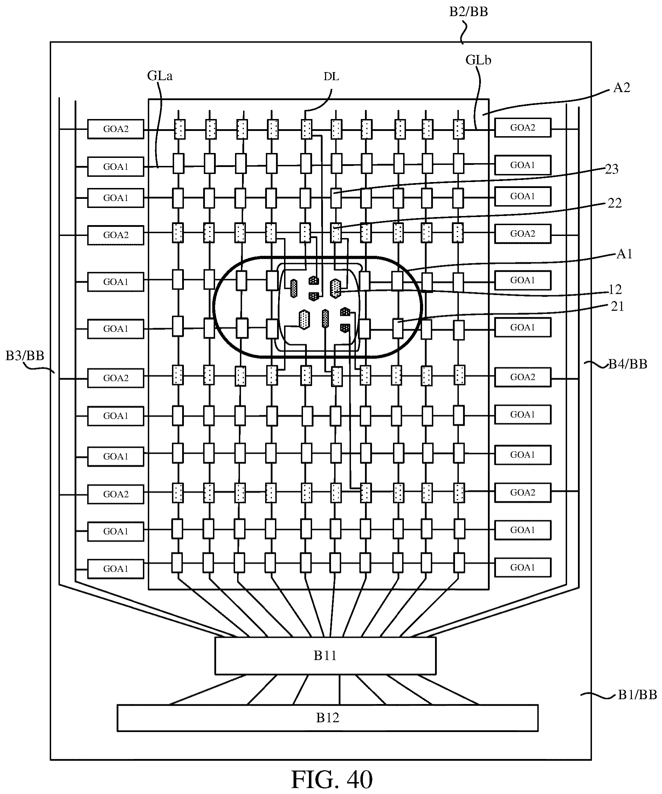

FIG. 40 is a schematic diagram of a display substrate according to at least one embodiment of the present disclosure. In some examples, as illustrated in FIG. 40, a second peripheral region is provided with a gate driving circuit, for example, the gate driving circuit is located in a left bezel region B3 and a right bezel region B4. The gate driving circuit may be configured to provide a first scan signal or a second scan signal.

In some examples, the gate driving circuit may include a plurality of first driving units GOA1 and a plurality of second driving units GOA2. The first driving unit GOA1 may provide gate signals to a first pixel circuit 21 and an in-situ pixel circuit 23 in a display region, and the second driving unit GOA2 may provide gate signals to a plurality of second pixel circuits 22 in the display region. For example, one row of in-situ pixel circuits or an in-situ pixel circuit 23 and a first pixel circuit 21 located in the same row are driven by the first driving unit GOA1, and one row of reserved pixel circuits are driven by the second driving unit GOA2.

In this example, two groups of driving units (a group of first driving units and a group of second driving units) are provided to realize driving of pixel circuits in the display region, and the number of transfer lines in the display region can be reduced. Remaining description of the display substrate in this example may be referred to the description in the aforementioned embodiments, which is not repeated here.

The present embodiment provides a display substrate including a plurality of first display regions and a second display region located at at least one side of the plurality of first display regions. The plurality of first display regions are arranged along a first direction or a second direction in a staggered manner. The display substrate includes a base substrate, and a plurality of pixel circuits and a plurality of light emitting elements provided on the base substrate. The plurality of pixel circuits include a plurality of first pixel circuits located in at least one first display region of the plurality first display regions, and a plurality of reserved pixel circuits and a plurality of in-situ pixel circuits located in the second display region, the plurality of reserved pixel circuits including a plurality of second pixel circuits. In the second display region, a plurality of reserved pixel circuits arranged along the first direction are one row of reserved pixel circuits, a plurality of in-situ pixel circuits arranged along the first direction are one row of in-situ pixel circuits, and one row of reserved pixel circuits is arranged every m rows of in-situ pixel circuits along the second direction, with m being an integer greater than 1. The plurality of light emitting elements include a plurality of first light emitting elements and a plurality of second light emitting elements located in the at least one first display region, and a plurality of third light emitting elements located in the second display region. The at least one first display region includes a first region and a second region arranged along the first direction, the first region being adjacent to the second display region in the first direction, the second region being adjacent to another first display region in the first direction, the plurality of second light emitting elements being located in the first region, and the plurality of first pixel circuits and the plurality of first light emitting elements being located in the second region. At least one first pixel circuit of the plurality of first pixel circuits is connected with at least one first light emitting element of the plurality of first light emitting elements, and an orthographic projection of the at least one first pixel circuit on the base substrate is at least partially overlapped with an orthographic projection of the connected at least one first light emitting element on the base substrate. At least one second pixel circuit of the plurality of second pixel circuits is connected

EP 4 665 125 A1

with at least one second light emitting element of the plurality of second light emitting elements through at least one first conductive connection line extending along the second direction, and an orthographic projection of the at least one second pixel circuit on the base substrate is not overlapped with an orthographic projection of the connected at least one second light emitting element on the base substrate. At least one in-situ pixel circuit of the plurality of in-situ pixel circuits is connected with at least one third light emitting element of the plurality of third light emitting elements, and an orthographic projection of the at least one in-situ pixel circuit on the base substrate is at least partially overlapped with an orthographic projection of the connected at least one third light emitting element on the base substrate.

In the display substrate of the present embodiment, the first display region adopts a combination of a pixel circuit built-out mode and a pixel circuit built-in mode, so that a light transmittance of the first display region can be guaranteed, and size of the first display region can be increased. For example, the present example may be applicable to the design requirements of multiple FDC regions.

In some exemplary implementations, the display substrate includes three first display regions, with two first display regions being arranged aligned along the first direction, and a third first display region being located at the same side of the two first display regions in the second direction, and each first display region being provided with a plurality of first light emitting elements, a plurality of second light emitting elements, and a plurality of first pixel circuits. In the two first display regions located in the same row, the plurality of second light emitting elements are located in a first region of the first display region in the first direction, and the plurality of first pixel circuits and the plurality of first light emitting elements are located in a second region of the first display region in the first direction. In the third first display region, the plurality of second light emitting elements are located in the middle of the plurality of first light emitting elements in the first direction.

In some exemplary implementations, the display substrate includes four first display regions arranged in two rows, with the two rows of first display regions being arranged along the first direction in a staggered manner. Two first display regions in at least one row are provided with a plurality of first light emitting elements, a plurality of second light emitting elements and a plurality of first pixel circuits. Alternatively, one first display region in a row is provided with a plurality of first light emitting elements, a plurality of second light emitting elements, and a plurality of first pixel circuits.

Rest of a structure of the display substrate according to this example may be referred to the description of the aforementioned embodiments, which will not be described here in detail.

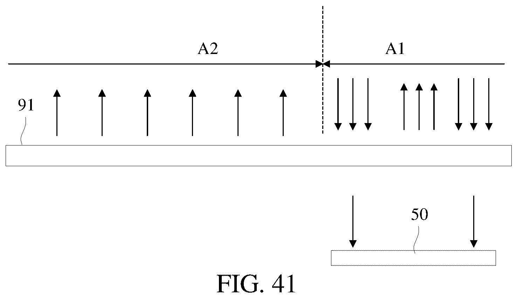

FIG. 41 is a schematic diagram of a display apparatus according to at least one embodiment of the present disclosure. As shown in FIG. 41, a display apparatus is provided in an embodiment, which includes a display substrate 91 and a sensor 50 located on a light exit side of a light emitting structure layer away from the display substrate 91. The sensor 50 may be located on a side of a non-display surface of the display substrate 91. An orthographic projection of the sensor 50 on the display substrate 91 may be at least partially overlapped with an orthographic projection of a first display region A1 on the display substrate 91. For example, the orthographic projection of the sensor 50 on the display substrate 91 is located within the orthographic projection of the first display region A1 on the display substrate 91.

In some examples, the display substrate 91 may be a flexible OLED display substrate, a QLED display substrate, a Micro-LED display substrate, or a Mini-LED display substrate. The display apparatus may be a product having an image (including a still image or a moving image, where the moving image may be a video) display function. For example, the display apparatus may be any one of a display, a television, a billboard, a digital photo frame, a laser printer with display function, a telephone, a mobile phone, a picture screen, a personal digital assistant (PDA), a digital camera, a portable camcorder, a viewfinder, a navigator, a vehicle, a large-area wall, an information inquiry equipment (such as business inquiry equipment in e-government, banks, hospitals, power departments), a monitor, or the like. As another example, the display apparatus may be any one of a micro-display, a VR device or an AR device including a micro-display.

The drawings of the present disclosure only involve structures involved in the present disclosure, and other structures may refer to conventional designs. The embodiments of the present disclosure, i.e., features in the embodiments, may be combined with each other to obtain new embodiments if there is no conflict. It should be noted that the above examples or embodiments are exemplary only but not restrictive. Therefore, the present disclosure is not limited to what is specifically shown and described herein. Various modifications, substitutions, or omissions may be made in forms and details of implementations without departing from the scope of the present disclosure.

## Claims

1. A display substrate comprising: at least one first display region and a second display region located at at least one side of the first display region, wherein a maximum length of the first display region along a first direction is different from a maximum length of the first display region along a second direction, the first direction intersecting the second direction; the display substrate comprises:

   a base substrate;
   a plurality of pixel circuits disposed on the base substrate and comprising: a plurality of first pixel circuits located in the first display region, and a plurality of reserved pixel circuits and a plurality of in-situ pixel circuits located in the second display region, wherein, the plurality of reserved pixel circuits comprise a plurality of second pixel circuits, and in the second display region, a plurality of reserved pixel circuits arranged along the first direction are one row of reserved pixel circuits, a plurality of in-situ pixel circuits arranged along the first direction are one row of in-situ pixel circuits, and one row of reserved pixel circuits is arranged every m rows of in-situ pixel circuits along the second direction, with m being an integer greater than 1; and

a plurality of light emitting elements disposed on the base substrate and comprising: a plurality of first light emitting elements and a plurality of second light emitting elements located in the first display region, and a plurality of third light emitting elements located in the second display region; wherein

at least one first pixel circuit of the plurality of first pixel circuits is connected with at least one first light emitting element of the plurality of first light emitting elements, and an orthographic projection of the at least one first pixel circuit on the base substrate is at least partially overlapped with an orthographic projection of the connected at least one first light emitting element on the base substrate;

at least one second pixel circuit of the plurality of second pixel circuits is connected with at least one second light emitting element of the plurality of second light emitting elements through at least one first conductive connection line extending along the second direction, and an orthographic projection of the at least one second pixel circuit on the base substrate is not overlapped with an orthographic projection of the connected at least one second light emitting element on the base substrate; and

at least one in-situ pixel circuit of the plurality of in-situ pixel circuits is connected with at least one third light emitting element of the plurality of third light emitting elements, and an orthographic projection of the at least one in-situ pixel circuit on the base substrate is at least partially overlapped with an orthographic projection of the connected at least one third light emitting element on the base substrate.

2. The display substrate according to claim 1, wherein the maximum length of the first display region along the first direction is greater than the maximum length of the first display region along the second direction;

the first display region comprises a+1 first sub-regions and a second sub-regions, wherein the a+1 first sub-regions and the a second sub-regions are arranged at intervals along the first direction, with a being an integer greater than 0, and at least one of the first sub-region is provided between the second sub-region and the second display region in the first direction;

the first sub-region is provided with the plurality of first pixel circuits and the plurality of first light emitting elements, and the second sub-region is provided with the plurality of second light emitting elements.

3. The display substrate according to claim 2, further comprising a plurality of data lines connected with the plurality of pixel circuits and configured to provide data signals to the plurality of pixel circuits, the plurality of data lines being arranged along the first direction and extending along the second direction, wherein

the plurality of data lines comprises a plurality of first data lines, a plurality of second data lines, and a plurality of third data lines, the plurality of first data lines are partitioned by the first display region and bypass the second sub-region along both sides of the second sub-region in the first direction, the plurality of second data lines are connected with the plurality of first pixel circuits in the first sub-region, and the plurality of third data lines are located in the second display region.

4. The display substrate according to claim 2, wherein a is 1 or 3.

5. The display substrate according to claim 1, wherein the maximum length of the first display region along the second direction is greater than the maximum length of the first display region along the first direction;

the first display region comprises b first sub-regions and b+1 second sub-regions, wherein the b first sub-regions and the b+1 second sub-regions are arranged at intervals along the second direction, with b being an integer greater than 0, and at least one of the second sub-regions is provided between the first sub-region and the second display region in the second direction; and

the first sub-region is provided with the plurality of first pixel circuits and the plurality of first light emitting elements, and the second sub-region is provided with the plurality of second light emitting elements.

6. The display substrate according to claim 5, wherein in the second display region, a plurality of reserved pixel circuits sequentially arranged along the second direction are one column of reserved pixel circuits, a plurality of in-situ pixel circuits sequentially arranged along the second direction are one column of in-situ pixel circuits, and one column of reserved pixel circuits is arranged every n columns of in-situ pixel circuits along the first direction, with n being an integer greater than 1;

the plurality of second light emitting elements disposed in the second sub-region located between the second display region and the first sub-region in the second direction are connected with a plurality of second pixel circuits in the second display region through a plurality of first conductive connection lines; and
the plurality of second light emitting elements disposed in the second sub-region located between two adjacent first sub-regions in the second direction are connected with a plurality of second pixel circuits in the second display region through a plurality of second conductive connection lines extending along the first direction.

7. The display substrate according to claim 1, wherein the first display region comprises a plurality of island regions, a transmissive region located between adjacent island regions, and an inter-island connection region connecting adjacent island regions, a light transmittance of the transmissive region being greater than a light transmittance of the island region;

the island region is provided with the plurality of first pixel circuits and the plurality of first light emitting elements; and
the first display region satisfies at least one of the following: the transmissive region is provided with the plurality of second light emitting elements; the inter-island connection region is provided with the plurality of second light emitting elements.

8. The display substrate according to claim 7, wherein the first display region comprises a plurality of transmissive regions, and the plurality of transmissive regions comprise at least one first transmissive region and a plurality of second transmissive regions, the first transmissive region being provided with the plurality of second light emitting elements, a light transmittance of the second transmissive region being greater than a light transmittance of the first transmissive region, and the second transmissive region and the first transmissive region are arranged at intervals along the first direction or the second direction; and
the first display region satisfies at least one of the following:

a maximum length of the first transmissive region along the first direction is greater than a maximum length of the second transmissive region along the first direction;
the maximum length of the first transmissive region along the first direction is equal to the maximum length of the second transmissive region along the first direction;
a maximum length of the first transmissive region along the second direction is greater than a maximum length of the second transmissive region along the second direction;
the maximum length of the first transmissive region along the second direction is equal to the maximum length of the second transmissive region along the second direction.

9. The display substrate according to claim 8, further comprising a shielding layer in the first display region, the shielding layer being located at a side of the plurality of first pixel circuits close to the base substrate, wherein an orthographic projection of the shielding layer on the base substrate covers orthographic projections of the plurality of island regions, the plurality of inter-island connection regions, and the plurality of second light emitting elements in the first transmissive region on the base substrate.

10. The display substrate according to claim 9, wherein the at least one first conductive connection line is disposed in the same layer as the shielding layer.

11. The display substrate according to claim 8, wherein the first transmissive region is located at a central region of the first display region, and the maximum length of the first transmissive region along the first direction is greater than the maximum length of the first transmissive region along the second direction.

12. The display substrate according to claim 8, wherein the first display region comprises a plurality of inter-island connection regions, and the plurality of inter-island connection regions comprise a plurality of first inter-island connection regions, a plurality of second inter-island connection regions, and a plurality of third inter-island connection regions, the plurality of first inter-island connection regions and the plurality of third inter-island connection regions extending along the first direction, the plurality of second inter-island connection regions extending along the second direction, the first inter-island connection region being adjacent to the second transmissive region along the second direction, and the third inter-island connection region being adjacent to the first transmissive region along the second direction; and

a maximum length of the third inter-island connection region along the first direction is greater than a maximum length of the first inter-island connection region along the first direction.

13. The display substrate according to claim 12, wherein a maximum length of the third inter-island connection region along the second direction is greater than or equal to a maximum length of the first inter-island connection region along the second direction.

14. The display substrate according to claim 7, wherein a minimum distance between the second light emitting element located in the transmissive region and the base substrate is less than or equal to a minimum distance between the first light emitting element located in the island region and the base substrate.

15. The display substrate according to claim 7, wherein the inter-island connection region is provided with a plurality of traces, which are straight line segments extending along the first direction or the second direction, or which are arc line segments extending along the first direction or the second direction.

16. The display substrate according to claim 1, wherein the first display region comprises a display middle region and a display edge region surrounding the display middle region, and the display middle region comprises a plurality of island regions, a transmissive region located between adjacent island regions, and an inter-island connection region connecting adjacent island regions; and
the plurality of second light emitting elements are located in the display edge region.

17. The display substrate according to claim 1, comprising: a plurality of first display regions, at least one of the plurality of first display region being provided with the plurality of first pixel circuits, the plurality of first light emitting elements, and the plurality of second light emitting elements;
wherein the plurality of first display regions are arranged along the first direction or the second direction in a staggered manner.

18. The display substrate according to claim 1, further comprising a peripheral region located at at least one side of the second display region, the peripheral region comprising a first peripheral region located at one side of the second display region in the second direction and a second peripheral region located at the remaining sides of the second display region; wherein
the display substrate further comprises a gate driving circuit located in the second peripheral region, the gate driving circuit comprising a plurality of first driving units which are configured to provide gate signals to a plurality of rows of in-situ pixel circuits and a plurality of rows of reserved pixel circuits.

19. The display substrate according to claim 1, further comprising a peripheral region located at at least one side of the second display region, the peripheral region comprising a first peripheral region located at one side of the second display region in the second direction and a second peripheral region located at the remaining sides of the second display region; wherein
the display substrate further comprises a gate driving circuit located in the second peripheral region, the gate driving circuit comprising a plurality of first driving units configured to provide gate signals to a plurality of rows of in-situ pixel circuits and a plurality of second driving units configured to provide gate signals to a plurality of rows of reserved pixel circuits.

20. The display substrate according to any one of claims 1 to 19, wherein the first display region is in a shape of a track hole.

21. The display substrate according to any one of claims 1 to 19, wherein the plurality of second light emitting elements in the first display region are connected with the plurality of second pixel circuits in the second display region through a plurality of first conductive connection lines, the plurality of first conductive connection lines being located on the same conductive layer.

22. A display apparatus, comprising the display substrate according to any one of claims 1 to 21, and a sensor located on a non-display side of the display substrate, wherein an orthographic projection of the sensor on the base substrate of the display substrate is at least partially overlapped with an orthographic projection of the first display region of the display substrate on the base substrate.

23. A display substrate comprising: a plurality of first display regions and a second display region located at at least one side of the plurality of first display regions, the plurality of first display regions being arranged along a first direction or a second direction in a staggered manner, and the first direction intersecting the second direction;
the display substrate comprising:

a base substrate;
a plurality of pixel circuits comprising a plurality of first pixel circuits located in at least one first display region of the plurality first display regions, and a plurality of reserved pixel circuits and a plurality of in-situ pixel circuits located in the second display region, wherein, the plurality of reserved pixel circuits comprise a plurality of second pixel circuits, and in the second display region, a plurality of reserved pixel circuits arranged along the first direction are one row of reserved pixel circuits, a plurality of in-situ pixel circuits arranged along the first direction are one row of in-situ pixel circuits, and one row of reserved pixel circuits is arranged every m rows of in-situ pixel circuits along the second direction, with m being an integer greater than 1; and
a plurality of light emitting elements comprising a plurality of first light emitting elements and a plurality of second light emitting elements located in the at least one first display region, and a plurality of third light emitting elements located in the second display region; wherein
the at least one first display region comprises a first region and a second region arranged along the first direction, the first region being adjacent to the second display region in the first direction, the second region being adjacent to another first display region in the first direction, the plurality of second light emitting elements being located in the first region, and the plurality of first pixel circuits and the plurality of first light emitting elements being located in the second region;
at least one first pixel circuit of the plurality of first pixel circuits is connected with at least one first light emitting element of the plurality of first light emitting elements, and an orthographic projection of the at least one first pixel circuit on the base substrate is at least partially overlapped with an orthographic projection of the connected at least one first light emitting element on the base substrate;
at least one second pixel circuit of the plurality of second pixel circuits is connected with at least one second light emitting element of the plurality of second light emitting elements through at least one first conductive connection line extending along the second direction, and an orthographic projection of the at least one second pixel circuit on the base substrate is not overlapped with an orthographic projection of the connected at least one second light emitting element on the base substrate; and
at least one in-situ pixel circuit of the plurality of in-situ pixel circuits is connected with at least one third light emitting element of the plurality of third light emitting elements, and an orthographic projection of the in-situ pixel circuit on the base substrate is at least partially overlapped with an orthographic projection of the connected at least one third light emitting element on the base substrate.

24. The display substrate according to claim 23, wherein the display substrate comprises three first display regions, with two first display regions being arranged aligned along the first direction, and a third first display region being located at the same side of the two first display regions in the second direction, and each first display region being provided with the plurality of first light emitting elements, the plurality of second light emitting elements, and the plurality of first pixel circuits;

in the two first display regions located in the same row, the plurality of second light emitting elements are located in a first region of the first display region in the first direction, and the plurality of first pixel circuits and the plurality of first light emitting elements are located in a second region of the first display region in the first direction; and
in the third first display region, the plurality of second light emitting elements are located in the middle of the plurality of first light emitting elements in the first direction.

25. The display substrate according to claim 23, wherein the display substrate comprises four first display regions arranged in two rows, and the two rows of first display regions are arranged along the first direction in a staggered manner;
two first display regions in at least one row are provided with the plurality of first light emitting elements, the plurality of second light emitting elements, and the plurality of first pixel circuits, or one first display region in a row is provided with the plurality of first light emitting elements, the plurality of second light emitting elements, and the plurality of first pixel circuits.

FIG. 1

FIG. 2

FIG. 3

FIG. 4

FIG. 5

FIG. 6

FIG. 7

FIG. 8

FIG. 9

FIG. 10

FIG. 11

FIG. 12

FIG. 13

EP 4 665 125 A1

A2

A1

A13

A14a

A13

13

131 132 133

443 442 441

11

111 112 113

333
331

334

12

121 122 123

434

332

418
417
416
415
414
413
411

40

421

21

31

412 21

23

50

FIG. 14

FIG. 15

A2

610
620
640
630
660
650
670

A1

520
510
540
530
550
570
560

Y
X

FIG. 16

FIG. 17A

A2

681
GL2(n)
581
GL1(n)

EML(n)

GL2(n+1)

GL1(n+1)

A1

Y

X

FIG. 17B

A2

A1

INIT1(n)

Y

X

FIG. 18A

A2

A1

INIT1(n)

682

INIT1(n+1)

582

591

Y

X

FIG. 18B

FIG. 19A

FIG. 19B

FIG. 20A

A2

731

A1

605

505

Y

X

FIG. 20B

FIG. 21A

FIG. 21B

FIG. 22

FIG. 23

FIG. 24

FIG. 25

A2

A13/A1

A14b/A1

A15a/A1

A14a/A1

12

A15b/A1

31

22

23

Y
X

## FIG. 26

22

A2

A101/A1

A14/A1

A13/A1

31

12

A15a/A1

A15b/A1

23

Y
X

## FIG. 27

A2

A14b/A1

A13/A1

A15b/A1

A14a/A1

A15a/A1

12

31

22

23

Y
X

FIG. 28

A2/AA    A1/AA    B2/BB

B3/BB

B4/BB

B1/BB

B11

B12

Y
X

FIG. 29

FIG. 30

FIG. 31

FIG. 32

FIG. 33

FIG. 34

FIG. 35

A1c/AA    A2/AA

A1a/AA    A1b/AA

B11

B1/BB

Y
X

FIG. 36

A1a/AA    A2/AA

A1b/AA

A1c/AA

B11

B1/BB

Y
X

FIG. 37

A1a/AA  A1b/AA  A1c/AA  A2/AA

B11

B1/BB

Y

X

FIG. 38

FIG. 39

FIG. 40

A2

A1

91

50

FIG. 41

## INTERNATIONAL SEARCH REPORT

| International application No. |
|---|
| **PCT/CN2024/125556** |

| A. | CLASSIFICATION OF SUBJECT MATTER |
|---|---|

H10K 59/12(2023.01)i;  H10K 59/121(2023.01)i

According to International Patent Classification (IPC) or to both national classification and IPC

| B. | FIELDS SEARCHED |
|---|---|

Minimum documentation searched (classification system followed by classification symbols)

IPC：H10K

Documentation searched other than minimum documentation to the extent that such documents are included in the fields searched

Electronic data base consulted during the international search (name of data base and, where practicable, search terms used)

CNTXT, ENTXT, WPABS, DWPI, CNKI: 显示面板, 显示基板, 像素, 电路, 交叠, 重叠, 投影, 内置, 外置, display panel, pixel?, circuit, overlap+, project???, built in, external

| C. | DOCUMENTS CONSIDERED TO BE RELEVANT |
|---|---|

| Category* | Citation of document, with indication, where appropriate, of the relevant passages | Relevant to claim No. |
|---|---|---|
| A | CN 114373774 A (BOE TECHNOLOGY GROUP CO., LTD. et al.) 19 April 2022 (2022-04-19) <br> description, paragraphs [0037]-[0137], and figures 1-11 | 1-25 |
| A | CN 116546855 A (BOE TECHNOLOGY GROUP CO., LTD. et al.) 04 August 2023 (2023-08-04) <br> entire document | 1-25 |
| A | CN 116685162 A (BOE TECHNOLOGY GROUP CO., LTD.) 01 September 2023 (2023-09-01) <br> entire document | 1-25 |
| A | WO 2023159509 A1 (BOE TECHNOLOGY GROUP CO., LTD. et al.) 31 August 2023 (2023-08-31) <br> entire document | 1-25 |
| A | US 2017371464 A1 (JAPAN DISPLAY INC.) 28 December 2017 (2017-12-28) <br> entire document | 1-25 |

☐ Further documents are listed in the continuation of Box C.    ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **30 December 2024** | **02 January 2025** |

| Name and mailing address of the ISA/CN | Authorized officer |
|---|---|
| **China National Intellectual Property Administration (ISA/CN)** <br> **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT
### Information on patent family members

International application No.

**PCT/CN2024/125556**

| Patent document cited in search report | | | Publication date (day/month/year) | Patent family member(s) | | | Publication date (day/month/year) |
|---|---|---|---|---|---|---|---|
| CN | 114373774 | A | 19 April 2022 | None | | | |
| CN | 116546855 | A | 04 August 2023 | None | | | |
| CN | 116685162 | A | 01 September 2023 | CN | 220326166 | U | 09 January 2024 |
| WO | 2023159509 | A1 | 31 August 2023 | CN | 116965175 | A | 27 October 2023 |
| US | 2017371464 | A1 | 28 December 2017 | JP | 2018004733 | A | 11 January 2018 |
| | | | | JP | 6938119 | B2 | 22 September 2021 |
| | | | | KR | 20180002014 | A | 05 January 2018 |
| | | | | US | 10452177 | B2 | 22 October 2019 |
| | | | | CN | 107546241 | A | 05 January 2018 |
| | | | | JP | 2021005088 | A | 14 January 2021 |
| | | | | CN | 107546241 | B | 15 September 2023 |
| | | | | JP | 7095038 | B2 | 04 July 2022 |

Form PCT/ISA/210 (patent family annex) (July 2022)

**REFERENCES CITED IN THE DESCRIPTION**

**Patent documents cited in the description**

- CN 2023126428 W